# EUROPEAN PATENT APPLICATION

(11) **EP 1 727 197 A2**
(43) Date of publication of application: **29.11.2006**
(21) Application number: 06010034.4
(22) Date of filing: 16.05.2006
(51) Int. Cl.: H01L 21/8238

(54) **Semiconductor device, method for fabricating the semiconductor device and method and computer programme for designing the semiconductor device**

(30) Priority: 26.05.2005 JP 2005153718; 20.03.2006 JP 2006077009
(71) Applicant: Fujitsu Ltd., Kawasaki-shi, Kanagawa 211-8588 (JP)
(72) Inventor: Tanaka, Takuji, Kawasaki-shi Kanagawa, 211-8588 (JP)
(74) Representative: Seeger, Wolfgang

(57) **Abstract**

The semiconductor device comprises a semiconductor substrate 10 of a first conduction type, a first well 32a of the first conduction type formed in the semiconductor substrate 10, a second well 32b of a second conduction type formed in the semiconductor substrate 10, and an impurity layer 14 of the second conduction type buried in the semiconductor substrate 10 below the first well 32a and below the second well 32b and connected to the second well 32b, for applying a bias voltage to the second well 32b, a contact region 34 of the first conduction type are formed selectively in the impurity layer 14 immediately below the first well 32a, and the first well 32a is connected to the semiconductor substrate 10 via the contact region 34.

## Description

### BACKGROUND OF THE INVENTION

The present invention relates to a semiconductor device, a method for fabricating the semiconductor device and a method for designing the semiconductor device, more specifically, a semiconductor device in which a bias voltage is applied to a plurality of wells via an impurity layer buried in a semiconductor substrate, a method for fabricating the semiconductor device and a method for designing the semiconductor device.

Recently, the technique of burying a deep N-type well region in a P-type semiconductor substrate to apply a bias voltage to shallow N-type wells via such deep N-type well region is proposed (refer to Patent references 1 and 2).

In the proposed semiconductor device, a deep N-type well region is formed in a P-type semiconductor substrate. On the deep N-type well region, a plurality of shallow N-type wells and a plurality of shallow P-type wells are formed. The deep N-type well region and the shallow N-type well regions are connected to each other. Accordingly, the plural shallow N-type wells are electrically connected to each other via the deep N-type well. A deep P-type well region is formed immediately below the shallow P-type wells. The shallow P-type wells neighboring to each other are connected to each other via the deep P-type well region. The shallow P-type wells and the deep P-type well region are electrically isolated from the P-type semiconductor substrate by device isolation regions and the deep N-type well region.

In the proposed semiconductor device, a plurality of shallow N-type wells are connected to each other by the deep N-type well, which makes it possible to apply a bias voltage at once to the plural shallow N-type wells via the deep N-type well region. The deep P-type well is formed immediately below the shallow P-type wells so as to connect the plural shallow P-type wells to each other, which makes it possible to apply a bias voltage at once to the plural shallow P-type wells via the deep P-type well.

Following references disclose the background art of the present invention.

### [Patent reference 1]

Specification of Japanese Patent Application Unexamined Publication No. 2002-158293

### [Patent reference 2]

Specification of Japanese Patent Application Unexamined Publication No. 2002-198439

### [Patent reference 3]

Specification of Japanese Patent Application Unexamined Publication No. Hei 10-199993

However, the proposed semiconductor device has a P-type contact layer formed on the surfaces of the shallow P-type wells, and the shallow P-type wells are connected to a bias input terminal via the P-type contact layer. The region for the P-type contact layer to be formed in must be ensured. Besides, as the distance from the P-type contact region to the P-type wells is larger, the electric resistance is larger, and a number of P-type contact regions must be formed on the semiconductor substrate. It is a barrier to facilitating the design and downsizing the semiconductor device that a number of regions for the P-type contact layer to be formed in must be formed.

In the proposed semiconductor device, the deep P-type well region must be formed immediately below the shallow P-type wells. Besides, immediately below such deep P-type well, a deeper N-type well region must be formed. The thus-complicated structure of the proposed semiconductor device is not easy to be designed. The method for fabricating the proposed semiconductor device has very complicated steps, which makes it difficult to reduce the cost.

Patent reference 3 simply discloses the technique that N-type well regions are buried in a P-type semiconductor substrate, and P-type well regions are formed inside the N-type well regions to form a triple well structure, and a bias voltage is applied from the semiconductor substrate side to the P-type well region via the conduction regions formed in the N-type well regions.

### SUMMARY OF THE INVENTION

An object of the present invention is to provide a semiconductor device in which different bias are applied to N-type wells and to P-type wells and which can facilitate design and can realize downsizing, cost reduction, etc., a method for fabricating the semiconductor device and a method for designing the semiconductor device.

According to one aspect of the present invention, there is provided a semiconductor device comprising: a semiconductor substrate of a first conduction type; a first well of the first conduction type formed in the semiconductor substrate; a first transistor of the second conduction type formed over the first well; a second well of the second conduction type formed in the semiconductor substrate; a second transistor of the first conduction type formed over the second well; and an impurity layer of the second conduction type buried in the semiconductor substrate below the first well and below the second well, connected to the second well, for applying a bias voltage to the second well, a contact region of the first conduction type being formed selectively in the impurity layer immediately below the first well, the first well being connected to the semiconductor substrate via the contact region.

According to another aspect of the present invention, there is provided a semiconductor device comprising: a semiconductor substrate of a first conduction type; a first well of the first conduction type formed in the semiconductor substrate; a first transistor of the second conduction type formed over the first well; a second well of the second conduction type formed in the semiconductor substrate; a second transistor of the first conduction type formed on the second well; and an impurity layer of the second conduction type buried in the semiconductor substrate below the first well and below the second well, connected to the second well, for applying a bias voltage to the second well, contact regions of the first conduction type being formed in the impurity layer, the first well being connected to the semiconductor substrate via the contact regions, and a total sum of areas of the contact regions in the region of the impurity layer being smaller than an area of the region of the impurity layer except the contact regions.

According to further another aspect of the present invention, there is provided a method for fabricating a semiconductor device comprising the steps of: forming an impurity layer of a second conduction type, buried in a semiconductor substrate of a first conduction type so that a contact region of the first conduction type are formed selectively in a first region of the region of the impurity layer; a first well of the first conduction type over the first region of the region of the impurity layer, connected to the semiconductor substrate via the contact region; a second well of the second conduction type on a second region of the region of the impurity layer, connected to the impurity layer; a first transistor of the second conduction type over the first well; and forming a second transistor of the first conduction type over the second well.

According to further another aspect of the present invention, there is provided a method for designing a semiconductor device comprising a semiconductor substrate of a first conduction type; a first well of the first conduction type formed in the semiconductor substrate; a first transistor of a second conduction type formed over the first well; a second well of a second conduction type formed in the semiconductor substrate; a second transistor of the first conduction type formed over the second well; an impurity layer of the second conduction type buried in the semiconductor substrate below the first well and below the second well and connected to the second well, for applying a bias voltage to the second well, a contact region of the first conduction type being formed selectively in the impurity layer immediately below the first well, the first well being connected to the semiconductor substrate via the contact region, the method comprising the steps of: computing a prescribed parameter, based on a pattern of the first well, a pattern of the impurity layer or patterns of the contact region; judging whether or not a result of computing the prescribed parameter satisfies a prescribed design basis; and adding, deleting, deforming or shifting the contact region so as to satisfy the prescribed design basis unless the prescribed parameter satisfies the prescribed design basis.

According to further another aspect of the present invention, there is provided a computer program for designing a semiconductor device comprising a semiconductor substrate of a first conduction type; a first well of the first conduction type formed in the semiconductor substrate; a first transistor of the second conduction type formed over the first well; a second well of the second conduction type formed in the semiconductor substrate; and a second transistor of the first conduction type formed over the second well; an impurity layer of the second conduction type buried in the semiconductor substrate below the first well and below the second well and connected to the second well, for applying a bias voltage to the second well, contact region of the first conduction type being formed selectively in the impurity layer immediately below the first well, the first well being connected to the semiconductor substrate via the contact region, the computer program executing the steps of: computing a prescribed parameter, based on a pattern of the first well, a pattern of the impurity layer or patterns of the contact region; judging whether or not a result of computing the prescribed parameter satisfies a prescribed design basis; adding, deleting, deforming or shifting the contact region so that the prescribed parameter satisfies the prescribed design basis, unless the prescribed parameter satisfies the prescribed design basis.

According to the present invention a contact regions of a first conduction type are formed in an impurity layer of a second conduction type buried in a semiconductor substrate of the first conduction type, a first well of the first conduction type and the semiconductor substrate of the first conduction type are connected to each other via the contact regions of the first conduction type, whereby it is not necessary to form in the surface of the first well a contact layer of the first conduction type for connecting the first well to a bias input terminal. According to the present embodiment, it is not necessary to ensure on the semiconductor substrate a region for such contact layer of the first conduction type to be formed in. Thus, the present invention can facilitate designing and downsizing the semiconductor device and reducing the cost of the semiconductor device.

According to the present invention, the contact regions of the first conduction type are formed selectively in a position where the first well of the first conduction type and the semiconductor substrate of the first conduction type must be connected to each other, i.e., in the impurity layer of the second conduction type immediately below the first well of the first conduction type, whereby the increase of the intra-plane electric resistance of the impurity layer of the second conduction type can be suppressed. According to the present invention, the contact regions of the first conduction type are formed selectively in the impurity layer of the second conduction type immediately below the first well of the first conduction type, whereby the first well of the first conduction type to be connected to the semiconductor substrate of the first conduction type can be connected to the semiconductor substrate of the first conduction type. Thus, according to the present invention, respective prescribed bias voltages can be applied to the first well of the first conduction type and the second well of the second conduction type without deteriorating the electric characteristics.

According to the present invention, a prescribed parameter is computed based on a pattern of the first well of the first conduction type, a pattern of the impurity layer of the second conduction type, patterns of the contact regions of the first conduction type, etc., and it is judged whether or not the prescribed parameter satisfies a prescribed design basis, and unless the prescribed parameter satisfies the design basis, addition, deletion, deformation, shift or others of the contact regions of the first conduction type are made speedily by computers or others, whereby the design of the semiconductor device can be simplified, made efficient, automated and optimized.

According to the present invention, the total sum of areas of the contact regions immediately below the first well is set smaller than the area of the region immediately below the first well except the contact regions, whereby the intra-plane electric resistance of the impurity layer of the second conduction type can be relatively depressed low immediately below the first well. Thus, according to the present invention, respective prescribed bias voltages can be applied to the first well of the first conduction type and to the second well of the second conduction type.

According to the present invention, the total sum of areas of the contact region of the first conduction type in the region where the impurity layer of the second conduction type is formed is set smaller than the area of the region of the impurity layer of the second conduction type except the contact regions of the first conduction type, whereby even when the contact regions of the first conduction type are arranged generally in the region where the impurity layer of the second conduction type is formed, the intra-plane electric resistance of the impurity layer of the second conduction type can be depressed relatively low. Thus, according to the present invention, respective prescribe bias voltages can be applied to the first well of the first conduction type and to the second well of the second conduction type.

### BRIEF DESCRIPTION OF THE DRAWINGS

FIGs. 1A and 1B are a plan view and a sectional view of the semiconductor device according to a first embodiment of the present invention.
FIG. 2 is a plan view of the semiconductor device according to the first embodiment of the present invention.
FIGs. 3A and 3B are views illustrating configurations of contact regions.
FIGs. 4A and 4B are sectional views of the semiconductor device according to the first embodiment of the present invention in the steps of the method for fabricating the semiconductor device, which illustrate the method (Part 1).
FIGs. 5A and 5B are sectional views of the semiconductor device according to the first embodiment of the present invention in the steps of the method for fabricating the semiconductor device, which illustrate the method (Part 2).
FIGs. 6A and 6B are a plan view and a sectional view of the semiconductor device according to a second embodiment of the present invention.
FIGs. 7A and 7B are sectional views of the semiconductor device according to the second embodiment of present invention in the steps of the method for fabricating the semiconductor device, which illustrate the method (Part 1).
FIGs. 8A and 8B are sectional views of the semiconductor device according to the second embodiment of present invention in the steps of the method for fabricating the semiconductor device, which illustrate the method (Part 2).
FIGs. 9A and 9B are a plan view and a sectional view of the semiconductor device according to a third embodiment of the present invention.
FIGs. 10A and 10B are sectional views of the semiconductor device according to the third embodiment of present invention in the steps of the method for fabricating the semiconductor device, which illustrate the method (Part 1).
FIGs. 11A and 11B are sectional views of the semiconductor device according to the third embodiment of present invention in the steps of the method for fabricating the semiconductor device, which illustrate the method (Part 2).
FIGs. 12A and 12B are sectional views of the semiconductor device according to the third embodiment of present invention in the steps of the method for fabricating the semiconductor device, which illustrate the method (Part 3).
FIGs. 13A and 13B are sectional views of the semiconductor device according to a modification of the third embodiment in the steps of the method for fabricating the semiconductor device, which illustrate the method (Part 1).
FIGs. 14A and 14B are sectional views of the semiconductor device according to the modification of the third embodiment in the steps of the method for fabricating the semiconductor device, which illustrate the method (Part 2).
FIG. 15 is sectional views of the semiconductor device according to the modification of the third embodiment in the steps of the method for fabricating the semiconductor device, which illustrate the method (Part 3).
FIGs. 16A and 16B are a plan view and a sectional view of the semiconductor device according to a fourth embodiment of the present invention.
FIGs. 17A and 17B are sectional views of the semiconductor device according to a fourth embodiment of the present invention in the steps of the method for fabricating the semiconductor device, which illustrate the method (Part 1).
FIGs. 18A and 18B are sectional views of the semiconductor device according to the fourth embodiment of the present invention in the steps of the method for fabricating the semiconductor device, which illustrate the method (Part 2).
FIG. 19 is sectional views of the semiconductor device according to the fourth embodiment of the present invention in the steps of the method for fabricating the semiconductor device, which illustrate the method (Part 3).
FIGs. 20A and 20B are a plan view and a sectional view of the semiconductor device according to the fifth embodiment of the present invention.
FIGs. 21A and 21B are sectional views of the semiconductor device according to the fifth embodiment of the present invention in the steps of the method for fabricating the semiconductor device, which illustrate the method (Part 1).
FIGs. 22A and 22B are sectional views of the semiconductor device according to the fifth embodiment of the present invention in the steps of the method for fabricating the semiconductor device, which illustrate the method (Part 2).
FIG. 23 is sectional views of the semiconductor device according to the fifth embodiment of the present invention in the steps of the method for fabricating the semiconductor device, which illustrate the method (Part 3).
FIGs. 24A and 24B are a plan view and a sectional view of the semiconductor device according to a sixth embodiment of the present invention.
FIGs. 25A and 25B are sectional views of the semiconductor device according to the sixth embodiment of the present invention in the steps of the method for fabricating the semiconductor device, which illustrate the method (Part 1).
FIGs. 26A and 26B are sectional views of the semiconductor device according to the sixth embodiment of the present invention in the steps of the method for fabricating the semiconductor device, which illustrate the method (Part 2).
FIGs. 27A and 27B are sectional views of the semiconductor device according to the sixth embodiment of the present invention in the steps of the method for fabricating the semiconductor device, which illustrate the method (Part 3).
FIGs. 28A and 28B are a plan view and a sectional view of the semiconductor device according to a seventh embodiment of the present invention.
FIGs. 29A and 29B are sectional views of the semiconductor device according to the seventh embodiment of the present invention in the steps of the method for fabricating the semiconductor device, which illustrate the method (Part 1).
FIGs. 30A and 30B are sectional views of the semiconductor device according to the seventh embodiment of the present invention in the steps of the method for fabricating the semiconductor device, which illustrate the method (Part 2).
FIGs. 31A and 31B are sectional views of the semiconductor device according to the seventh embodiment of the present invention in the steps of the method for fabricating the semiconductor device, which illustrate the method (Part 3).
FIGs. 32A and 32B are a plan view and a sectional view of the semiconductor device according to an eighth embodiment of the present invention.
FIGs. 33A and 33B are a plan view and a sectional view of the semiconductor device according to a ninth embodiment of the present invention.
FIG. 34 is the flow chart of the algorithm of the computer program for executing the method for designing the semiconductor device according to a tenth embodiment of the present invention.
FIGs. 35A to 35C are plan views illustrating the method for designing the semiconductor device according to the tenth embodiment of the present invention (Part 1).
FIGs. 36A and 36B are plan views illustrating the method for designing the semiconductor device according to the tenth embodiment of the present invention (Part 2).
FIGs. 37A and 37B are plan views illustrating the processing for designing the semiconductor device according to the tenth embodiment of the present invention (Part 3).
FIGs. 38A to 38C are plan views illustrating the processing for designing the semiconductor device according to the tenth embodiment of the present invention (Part 4).
FIGs. 39A to 39C are plan views illustrating the processing for designing the semiconductor device according to the tenth embodiment of the present invention (Part 5).
FIGs. 40A and 40B are plan views illustrating the processing for designing the semiconductor device according to the tenth embodiment of the present invention (Part 6).
FIGs. 41A to 41C are plan views illustrating the processing for designing the semiconductor device according to the tenth embodiment of the present invention (Part 7).
FIG. 42 is the flow chart of the method for designing the semiconductor device according to a modification of the tenth embodiment of the present invention.
FIGs. 43A and 43B are plan views of modifications of the configuration of the contact regions.
FIGs. 44A and 44B are a plan view and a sectional view of the semiconductor device according to an eleventh embodiment of the present invention.
FIGs. 45A and 45B are a plan view and a sectional view of the semiconductor device according to Control 1.
FIGs. 46A and 46B are a plan view and a sectional view according to Modification 1 of the eleventh embodiment of the present invention.
FIGs. 47A and 47B are a plan view and a sectional view according to Modification 2 of the eleventh embodiment of the present invention.
FIGs. 48A and 48B are a plan view and a sectional view according to Modification 3 of the eleventh embodiment of the present invention.
FIGs. 49A and 49B are a plan view and a sectional view according to Modification 4 of the eleventh embodiment of the present invention.
FIGs. 50A and 50B are a plan view and a sectional view according to Modification 5 of the eleventh embodiment of the present invention.
FIGs. 51A and 51B are a plan view and a sectional view according to Modification 6 of the eleventh embodiment of the present invention.
FIGs. 52A and 52B are a plan view and a sectional view according to Modification 7 of the eleventh embodiment of the present invention.
FIGs. 53A and 53B are a plan view and a sectional view according to Modification 8 of the eleventh embodiment of the present invention.
FIGs. 54A and 54B are a plan view and a sectional view according to Modification 9 of the eleventh embodiment of the present invention.
FIGs. 55A and 55B are a plan view and a sectional view according to Modification 10 of the eleventh embodiment of the present invention.
FIGs. 56A and 56B are a plan view and a sectional view of the semiconductor device according to a twelfth embodiment of the present invention.
FIGs. 57A and 57B are a plan view and a sectional view of the semiconductor device according to Control 2.
FIGs. 58A and 58B are a plan view and a sectional view of the semiconductor device according to a modification of the twelfth embodiment of the present invention.
FIGs. 59A and 59B are a plan view and a sectional view of the semiconductor device according to Control 3.

### DETAILED DESCRIPTION OF THE INVENTION

### [A First Embodiment]

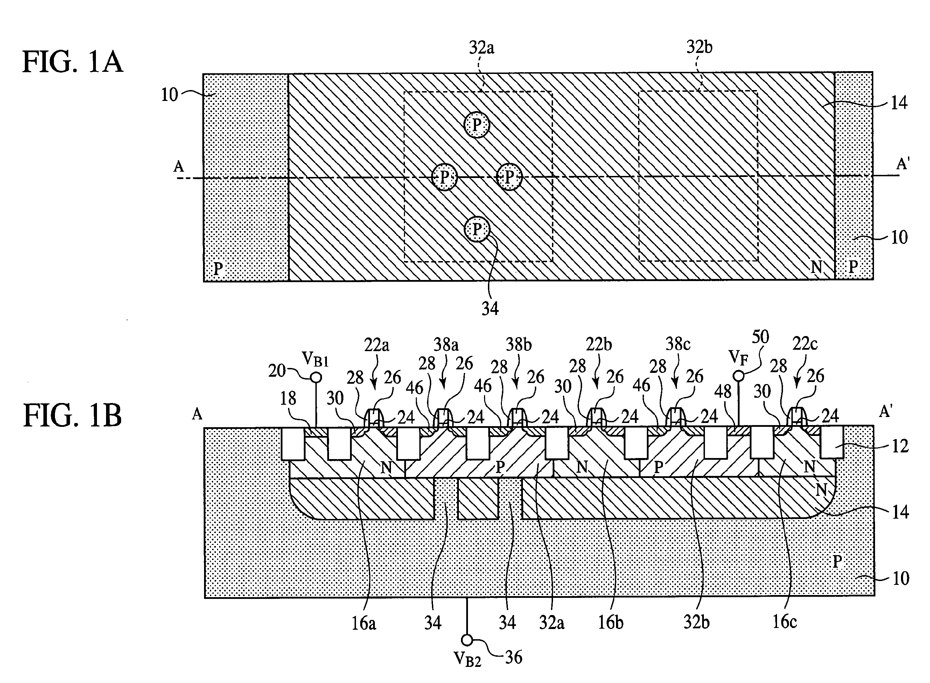

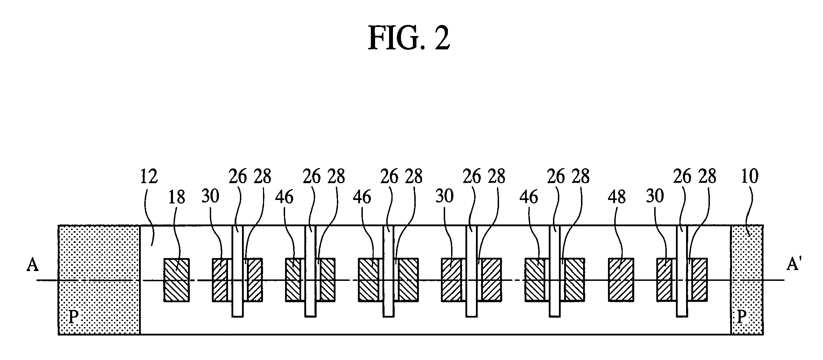

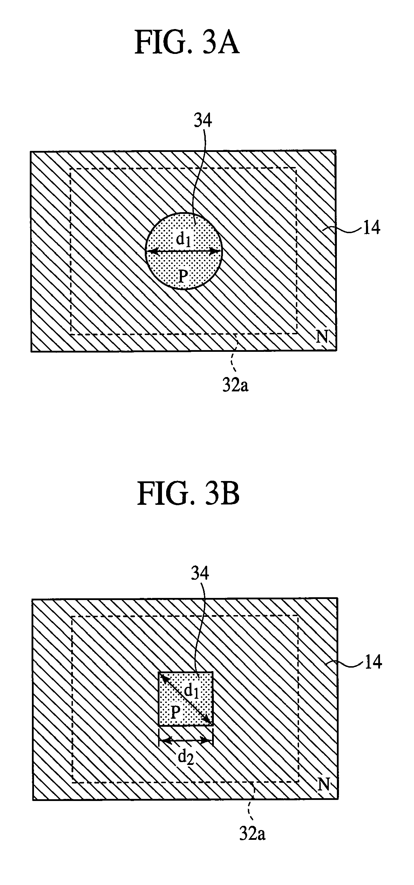

The semiconductor device according to a first embodiment of the present invention and the method for fabricating the semiconductor device will be explained with reference to FIGs. 1A to 5B. FIGs. 1A and 1B are a plan view and a sectional view of the semiconductor device according to the present embodiment. FIG. 2 is a plan view of the semiconductor device. FIG. 1A is the plan view illustrating the layout of an N-type impurity layer and P-type contact regions. In FIG. 1A, the constituent members, such as N-type wells, P-type wells, gate electrodes, etc., are omitted. FIG. 1B is the sectional view along A-A' line in FIG. 2. FIGs. 3A and 3B are plan views illustrating the shapes of the contact regions.

### (The Semiconductor Device)

First, the semiconductor device according to the present embodiment will be explained with reference to FIGs. 1A to 3B.

As illustrated in FIGs. 1A to 2, device isolation regions 12 for defining device regions are formed in a P-type semiconductor substrate 10. The semiconductor substrate 10 is, e.g., a silicon substrate.

In the semiconductor substrate 10 with the device isolation regions 12 formed in, an N-type impurity layer (deep N-type well) 14 is buried in a deep region remote from the surface of the semiconductor substrate 10.

On the N-type impurity layer 14, a plurality of N-type wells 16a - 16c are formed, connected to the N-type impurity layer 14. The N-type impurity layer 14 is for applying a bias voltage V_{B1} at once to the plural N-type wells 16a - 16c.

PMOS transistors 22a - 22c are formed on the respective N-type wells 16a - 16c. Each PMOS transistor 22a - 22c includes a gate electrode 26 formed with a gate insulation film 24 formed therebetween, a sidewall insulation film 28 formed on the side wall of the gate electrode 26 and a source/drain diffused layer 30 of LDD (Lightly Doped Drain) structure formed in the semiconductor substrate 10 on both sides of the gate electrode 26.

On the surface of the N-type well 16a, an N-type contact layer 18 is formed. The N-type contact layer 18 is connected to a bias input terminal 20. The bias voltage V_{B1} to be applied to the bias input terminal 20 is suitably set corresponding to operation states of the PMOS transistors 22a - 22c. That is, a variable bias (variable back bias) V_{B1} is applied to the bias input terminal 20. When the bias voltage V_{B1} is applied to the bias input terminal 20, the bias voltage V_{B1} is applied to the N-type well 16a via the N-type contact layer 18. When the bias voltage V_{B1} is applied to the bias input terminal 20, the bias voltage V_{B1} is applied to the N-type well 16b and the N-type well 16c via the N-type contact layer 18, the N-type well 16a and the N-type impurity layer 14. Thus, in the present embodiment, with the N-type impurity layer 14 buried in the P-type semiconductor substrate 10, the bias voltage V_{B1} can be applied at once to the plural N-type wells 16a - 16c via the N-type impurity layer 14.

The PMOS transistors 22a - 22c formed on the respective N-type wells 16a - 16c function as substrate bias variable transistors (variable back bias transistors). The substrate bias variable transistors are transistors which vary a bias voltage to be applied to the wells for stand-by and operation.

The operational principle of the substrate bias variable transistors comprising the PMOS transistors 22a - 22c is as follows. That is, when the voltage to be applied to the sources of the PMOS transistors 22a - 22c is the source voltage, a bias voltage V_{B1} which is higher than the source voltage is applied to the N-type wells 16a - 16c in stand-by. When the bias voltage V_{B1} which is higher than the source voltage is applied to the N-type wells 16a - 16c, the effective threshold of the PMOS transistors 22a - 22c becomes high, and the leak current of the PMOS transistors 22a - 22c can be decreased. In operation, however, a voltage equal to the source voltage or a voltage lower than the source voltage is applied to the N-type well 16a. When a voltage equal to the source voltage or a voltage lower than the source voltage is applied to the N-type wells 16a - 16c, the effective threshold of the PMOS transistors 22a - 22c becomes low, and the drive current of the PMOS transistors 22a - 22c can be increased.

A plurality of P-type wells 32a, 32b are formed on the N-type impurity layer 14. The P-type wells 32a and the P-type wells 32b are electrically isolated from each other by the N-type wells 16a - 16c and the N-type impurity layer 14. A number of the P-type well 32a and the P-type well 32b are formed in the semiconductor substrate 10 in the region not illustrated, but they are omitted here.

P-type contact regions 34 are formed in the N-type impurity layer 14 immediate below the regions where the P-type wells 32a are formed. The P-type contact regions 34 are for connecting the P-type wells 32a and the P-type semiconductor substrate 10 to each other. The P-type contact regions 34 are formed in, e.g., a cylindrical shape. The P-type contact regions 34 are formed by prohibiting an N-type dopant impurity from being introduced locally into the semiconductor substrate 10 when the N-type dopant impurity is implanted into the semiconductor substrate 10 to form the N-type impurity layer 14. The impurity concentration in the P-type contact regions 34 and the impurity concentration in the semiconductor substrate 10 are equal to each other.

In the present embodiment, the P-type wells 32a and the P-type semiconductor substrate 10 are connected to each other via the P-type contact regions 34 for the follow reason.

That is, a plurality of the P-type wells 32a are formed in the semiconductor substrate 10, but the respective P-type wells 32a are isolated from each other by the N-type impurity layer 14 and the N-type wells 16a - 16c, etc. To apply a bias voltage to the respective P-type wells 32a, it will be an idea to form the P-type contact layer on the surfaces of the respective P-type wells 32a, and the respective P-type wells 32a are connected to the bias input terminal via the P-type contact layer. However, to connect the P-type wells 32a to the bias input terminal via such P-type contact layer, the P-type wells 32a must be larger by the region where such P-type contact layer is formed. Thus, when the P-type contact layer is formed on the surfaces of the respective P-type wells 32a to thereby connect the P-type wells 32a to the bias input terminal via such P-type contact layer, it makes it difficult to provide a semiconductor device having a small chip size.

In contrast to this, in the present embodiment, in which the P-type wells 32a and the P-type semiconductor substrate 10 are connected to each other by the P-type contact regions 34 formed in the N-type impurity layer 14, it is not necessary to form such P-type contact layer on the surfaces of the respective P-type wells 32a. Consequently, the space saving can be realized, which leads to downsizing and cost reduction of the semiconductor device.

In the present embodiment, the P-type contact regions 34 are formed selectively immediately below the regions where the P-type wells 32a are formed for the following reason.

That is, when the P-type contact regions 34 are arranged generally in the region where the N-type impurity layer 14 is formed, even the other P-type wells 32b, which must be electrically isolated from the P-type semiconductor substrate 10, are connected to the P-type semiconductor substrate 10. In this case, a bias voltage which is different from a bias voltage to be applied to the P-type semiconductor substrate 10 cannot be applied to the P-type wells 32b. When the P-type contact region 34 is arranged generally in the region where the N-type impurity layer 14 is formed, the intra-plane electric resistance of the N-type impurity layer 14 becomes higher by the P-type contact regions 34 formed therein. When the intra-plane electric resistance of the N-type impurity layer 14 is higher, there is a risk that a required bias voltage could not be applied to the respective N-type wells.

In contrast to this, in the present embodiment, the P-type contact regions 34 are formed in the N-type impurity layer 14 selectively immediately below the P-type wells 32a, whereby the increase of the intra-plane electric resistance of the N-type impurity layer 14 can be suppressed, and only the P-type wells 32a, which are to be connected to the P-type semiconductor substrate 10, can be connected to the P-type semiconductor substrate 10.

In the present embodiment, the contact regions 34 are formed in a cylindrical shape for the following reason.

That is, a bias voltage V_{B1} which is higher than a bias voltage V_{B2} to be applied to the P-type semiconductor substrate 10 is applied to the N-type impurity layer 14. When a difference between the bias voltage V_{B1} to be applied to the N-type impurity layer 14 and the bias voltage V_{B2} to be applied to the P-type semiconductor substrate 10 is relatively large, there is a risk that the contact regions 34 might be depleted. When the contact regions 34 are depleted, the P-type contact wells 32a and the P-type semiconductor substrate 10 cannot be connected to each other via the contact regions 34.

FIGs. 3A and 3B are plan views of the configurations of the contact regions. FIG. 3A illustrates the contact regions formed in a cylindrical shape, and FIG. 3B illustrates the contact regions formed in a rectangular column shape.

As illustrated in FIG. 3B, when the contact regions 34 are formed in the rectangular column shape, a length of the diagonal of the section of the contact regions 34 is d₁, the shortest distance d₂ between the parts of the N-type impurity layer opposed to each other is smaller than the length d₁ of the diagonal.

On the other hand, when the contact regions 34 are formed in a cylindrical shape, when a diameter of the section of the contact regions 34 is d₁, the shortest distance between the parts of the N-type impurity layer 14 opposed to each other is d₁, which is equal to the diameter d₁.

As the distance between the parts of the N-type impurity layer 14 opposed to each other in the contact regions 34 is smaller, the contact regions 34 more tend to be depleted.

When the contact regions 34 are formed in a rectangular column shape as illustrated in FIG. 3B, the distance of the parts of the N-type impurity layer 14 opposed to each other is relatively small, and the contact regions 34 are relatively easily depleted.

In contrast to this, in the present embodiment, the contact regions 34 are formed in a cylindrical shape as illustrated in FIG. 3A, and the distance between the opposed parts of the N-type impurity layer 14 in the contact regions 34 can be made relatively large. Thus, in the present embodiment, when the contact regions 34 are formed relatively small, the depletion of the contact regions 34 can be suppressed.

When a total sum of areas of the P-type contact regions 34 in the region where the P-type well 32a are formed is A, and an area of the P-type well 32a is B, the P-type contact regions 34 are formed so that the ratio (A/B) of the total sum A of the areas of the P-type contact regions 34 to the area B of the P-type well 32a is within a prescribed range, i.e., satisfies a prescribed design basis. For the following reason, the P-type contact regions 34 are formed so that a total sum A of the areas of the P-type contact regions 34 to an area B of the P-type well 32a satisfies a prescribed design basis.

When a ratio of a total sum A of the areas of the contact regions 34 to an area B of the P-type well 32a is too small, i.e., when the ratio (A/B) is smaller than the lower limit of a prescribed design basis, the electric resistance between the P-type well 32a and the P-type semiconductor substrate 10 becomes too high, and it is difficult to apply a prescribed bias voltage V_{B2} to the P-type well 32a.

On the other hand, when a ratio (A/B) of a total sum A of the areas of the P-type contact regions 34 to an area B of the P-type well 32a is too large, i.e., when the ratio (A/B) is larger than the upper limit of a prescribed design basis, the intra-plane electric resistance of the N-type impurity layer 14 becomes too high, and it is difficult to apply a prescribed bias voltage V_{B1} to the N-type well 16.

Thus, the P-type contact regions 34 are formed so that the ratio (A/B) of a total sum A of the areas of the contact regions 34 to an area B of the P-type well 32a satisfies a prescribed design basis.

The P-type contact regions 34 are formed here so that the ratio (A/B) of a total sum of the areas of the contact regions 34 to an area B of the P-type well 32a satisfies a prescribed design basis. However, it is possible that the P-type contact regions 34 are formed so that the conductance between the P-type well 32a and the P-type semiconductor substrate 10 satisfies a prescribed design basis.

That is, when the conductance between the P-type well 32a and the semiconductor substrate 10 is too small, i.e., when the conductance between the P-type well 32a and the semiconductor substrate 10 is smaller than a lower limit of a prescribed design basis, the electric resistance between the P-type well 32a and the P-type semiconductor substrate 10 becomes too high, and it is difficult to apply a prescribed bias voltage V_{B2} to the P-type well 32a, as is in the case that the ratio (A/B) of a total sum A of the areas of the P-type contact regions 34 to an area B of the P-type well 32a is too small.

On the other hand, when the conductance between the P-type well 32a and the semiconductor substrate 10 is too large, i.e., the conductance between the P-type well 32a and the semiconductor substrate 10 is larger than an upper limit of a prescribed design basis, the intra-plane electric resistance of the N-type impurity layer 14 becomes too high, and it is difficult to apply a prescribed bias voltage V_{B1} to the N-type wells 16, as is in the case that a ratio (A/B) of a total sum A of the areas of the P-type contact regions 34 to an area B of the P-type well 32a is too large.

As described above, it is significant that the conductance between the P-type well 32a and the semiconductor substrate 10 satisfies a prescribed design basis, as it is significant that the ratio (A/B) of a total sum A of the areas of the contact regions 34 to an area B of the P-type well 32a satisfies a prescribed design basis. Thus, the P-type contact regions 34 may be formed so that the conductance between the P-type well 32a and the semiconductor substrate 10 satisfies a prescribed design basis.

NMOS transistors 38a - 38c are formed respectively on the P-type wells 32a, 32b. Each NMOS transistor 38a - 38c includes a gate electrode 26 formed with a gate insulation film 24 formed therebetween, a sidewall insulation film 28 and a source/drain diffused layer 40 of LDD structure formed in the semiconductor substrate 10 on both sides of the gate electrode 26.

The backside of the semiconductor substrate 10 is connected to the bias input terminal 36. The bias voltage V_{B2} to be applied to the bias input terminal 36 is set suitably in accordance with operational states of the NMOS transistors. That is, a variable bias (variable back bias) V_{B2} is applied to the bias input terminal 36. When the bias voltage V_{B2} is applied to the bias input terminal 36, the bias voltage V_{B2} can be applied to the P-type well 32a via the P-type semiconductor substrate 10 and the P-type contact regions 34.

The NMOS transistors 38a, 38b formed on the P-type well 32a function as substrate bias variable transistors. The substrate bias variable transistors are transistors which vary the bias for the stand-by and the operation as described above.

The operational principle of the substrate bias variable transistors comprising the NMOS transistors 38a, 38b is as follows. That is, when a voltage to be applied to the sources of the NMOS transistors 38a, 38b is 0 V, a negative voltage is applied to the P-type well 32a in stand-by. When a negative voltage is applied to the P-type well 32a, the effective threshold of the NMOS transistors 38a, 38b is increased, and the off leak current of the NMOS transistors 38a, 38b can be decreased. On the other hand, in operation, 0 V or a positive voltage is applied to the P-type well 32a. When 0 V or a positive voltage is applied to the P-type well 32a, the effective threshold of the NMOS transistors 38a, 38b is lowered, and the drive current of the NMOS transistors 38a, 38b can be increased.

The P-type well 32b is electrically isolated from the P-type semiconductor substrate 10 by the N-type wells 16a - 16c and the N-type impurity layer 14. A P-type contact layer 48 is formed on the surface of the P-type well 32b. The P-type contact layer 48 is connected to a bias input terminal 50. The bias input terminal 50 is connected to, e.g., a fixed bias V_{F}. When the bias voltage V_{F} is applied to the bias input terminal 50, the bias voltage V_{F} is applied to the P-type well 32b via the P-type impurity layer 48.

With the P-type well 32b connected to the fixed bias V_{F}, the NMOS transistor 38c formed on the P-type well 32b operates as an ordinary transistor.

Thus, the semiconductor device according to the present embodiment is constituted.

One of major characteristics of the semiconductor device according to the present embodiment is that a bias voltage V_{B1} is applied to the N-type wells 16a - 16c via the N-type impurity layer 14 buried in the P-type semiconductor substrate 10, and another bias voltage V_{B2} is applied to the P-type well 32a via the P-type contact regions 34 formed in the N-type impurity layer 14, and the P-type semiconductor substrate 10.

In the semiconductor device proposed in Patent references 1 and 2, the P-type contact layer is formed on the surface of a shallow P-type well, and the shallow P-type well is connected to the bias input terminal via the P-type contact layer. Accordingly, in the proposed semiconductor device, a region where the P-type contact layer is to be formed must be ensured. Besides, as the distance from the P-type contact region to the P-type well is larger, the electric resistance is higher, which requires a plurality of the P-type contact regions must be formed on the semiconductor substrate. It is a barrier to facilitating the design and downsizing the semiconductor device that a plurality of the P-type contact regions must be formed on the semiconductor substrate.

In contrast to this, in the present embodiment, the P-type well 32a and the P-type semiconductor substrate 10 are connected to each other via the P-type contact regions 34 formed in the N-type impurity layer 14, which makes it unnecessary to form the P-type contact layer for connecting the P-type well 32a to the bias input terminal on the surface of the P-type well 32a. According to the present embodiment, it is not necessary to ensure the region for the P-type contact layer to be formed in on the semiconductor substrate, which facilitates the design and downsizing the semiconductor device.

One of major characteristics of the semiconductor device according to the present embodiment is that the P-type contact regions 34 is formed selectively in the N-type impurity layer 14 immediately below the region where the P-type well 32a is formed.

When the P-type contact regions 34 are arranged generally in the region where the N-type impurity layer 14 is formed, even the other P-type well 32b which must be electrically isolated from the P-type semiconductor substrate 10 is connected to the P-type semiconductor substrate 10. In this case, a bias voltage which is different from a bias voltage to be applied to the P-type semiconductor substrate 10 cannot be applied to the P-type well 32b. With the P-type contact region 34 arranged generally in the region where the N-type impurity layer 14 formed in, the intra-plane electric resistance of the N-type impurity layer 14 is increased by the presence of the P-type contact region 34. When the intra-plane electric resistance of the N-type impurity layer 14 is high, there is a risk that a prescribed bias voltage could not be applied to the respective N-type wells.

In contrast to this, in the present embodiment, the P-type contact regions 34 are formed in a part where the P-type well 32a and the P-type semiconductor substrate 10 must be connected to each other, i.e., in the N-type impurity layer 14 immediately below the P-type well 32a, whereby the increase of the intra-plane electric resistance of the N-type impurity layer 14 can be suppressed. The P-type contact regions 34 are formed in the N-type impurity layer 14 immediately below the P-type well 32a, which permits only the P-type well 32a to be connected to the P-type semiconductor substrate 10. Thus, according to the present embodiment, a prescribed bias voltage can be applied to the respectively P-type well 32a and the P-type well 32b without causing the deterioration of the electric characteristics.

### (The Method for Fabricating the Semiconductor Device)

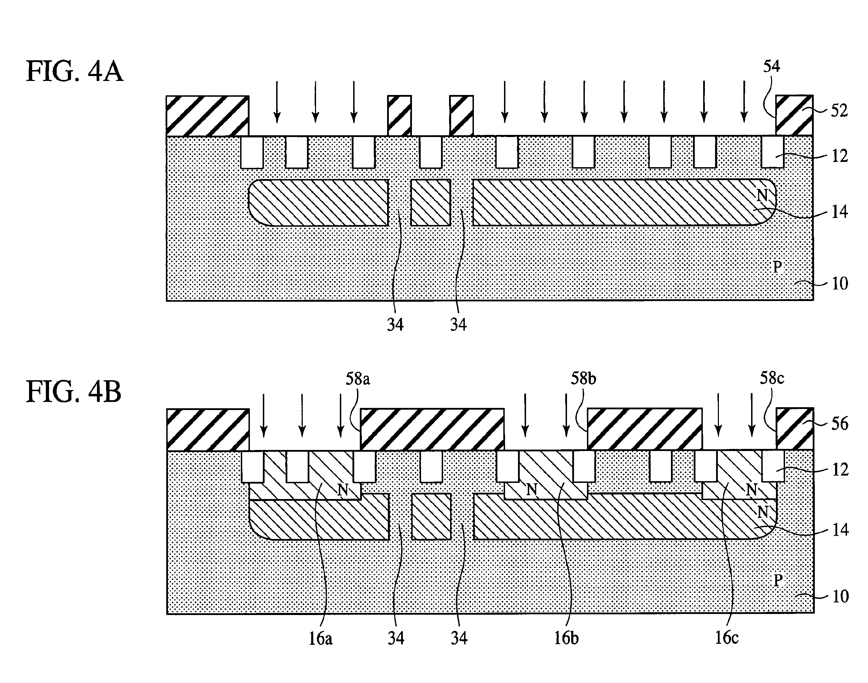

Next, the method for fabricating the semiconductor device according to the present embodiment will be explained with reference to FIGs. 4A to 5B. FIGs. 4A to 5B are sectional views of the semiconductor device according to the present embodiment in the steps of the method for fabricating the semiconductor device, which illustrate the method.

First, as illustrated in FIG. 4A, device isolation regions 12 for defining device regions are formed. The device isolation regions 12 can be formed by, e.g., STI (Shallow Trench Isolation).

Next, a photoresist film 52 is formed by, e.g., spin coating.

Next, the photoresist film 52 is patterned by photolithography. At this time, the photoresist film 52 is patterned to cover the regions for the contact regions 34 to be formed in with the photoresist film 52 and to expose the region for the N-type impurity layer 14 to be formed in from the photoresist film 52. Thus, an opening 54 for the N-type impurity layer 14 to be formed in is formed in the photoresist film 52.

Next, with the photoresist film 52 as the mask, an N-type dopant impurity is implanted into the semiconductor substrate 10 by ion implantation. At this time, the ion implantation conditions are set so that the N-type dopant impurity is implanted in a deep region remote from the surface of the semiconductor substrate 10. The ion implantation conditions are as exemplified below. The dopnat impurity is, e.g., phosphorus. The acceleration voltage is, e.g., 700 keV. The dose is, e.g., 1.5×10¹³ cm⁻². Thus, the N-type impurity layer 14 is formed in the deep region remote from the surface semiconductor substrate 10. In the regions for the P-type contact regions 34 to be formed in, into which the N-type dopant impurity has not been implanted, the P-type contact regions 34 are formed in the regions for the P-type contact region 34 to be formed in. Then, the photoresist film 52 is released.

Next, a photoresist film 56 is formed by, e.g., spin coating.

Next, the photoresist film 56 is patterned by photolithography. At this time, the photoresist film 56 is patterned to expose the regions for the N-type wells 16a - 16c to be formed in. Thus, openings 58a - 58c for forming the N-type wells 16a - 16c are formed in the photoresist film 56.

Next, with the photoresist film 56 as the mask, an N-type dopant impurity is implanted into the semiconductor substrate 10 by ion implantation. The dopant impurity is, e.g., phosphorus. The acceleration voltage is, e.g., 360 keV. The dose is, e. g. , 3.0×10¹³ cm⁻². Thus, a plurality of the N-type wells 16a - 16c connected to the N-type impurity layer 14 are formed (see FIG. 4B). Then, the photoresist film 56 is released.

Next, a photoresist film 60 is formed by, e.g., spin coating.

Then, the photoresist film 60 is patterned by photolithography. At this time, the photoresist film 60 is patterned to expose the regions where the P-type wells 32a, 32b are to be formed. Thus, openings 62a, 62b for forming the P-type wells 32a, 32b are formed in the photoresist film 60.

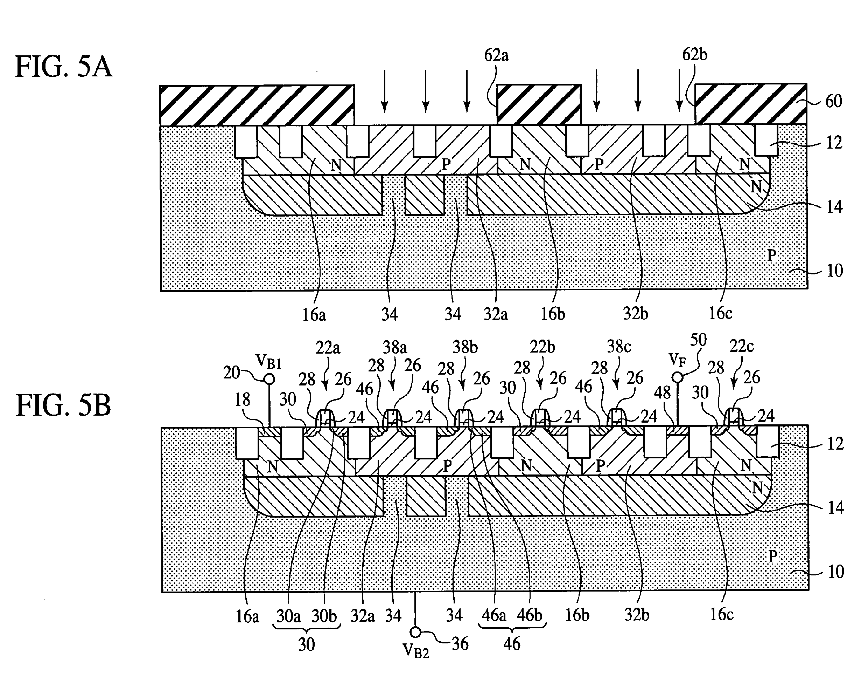

Next, with the photoresist film 60 as the mask, a P-type dopant impurity is implanted in the semiconductor substrate 10 by ion implantation. The ion implantation conditions are as exemplified below. The dopant impurity is, e.g., boron. The acceleration voltage is, e.g., 150 keV. The dose is, e.g., 3.0×10¹³ cm⁻². Thus, a plurality of the P-type wells 32a, 32b are formed in the semiconductor substrate 10 (see FIG. 5A). The P-type contact regions 34 are formed selectively in the N-type impurity layer 14 immediately below the P-type well 32a. Thus, the P-type well 32a is connected to the P-type semiconductor substrate 10 via the P-type contact regions 34. On the other hand, in the N-type impurity layer 14 immediately below the P-type well 32b, the P-type contact regions 34 are not formed. The P-type well 32b is electrically isolated from the P-type semiconductor substrate 10 by the N-type impurity layer 14 and the N-type wells 16a - 16c.

Next, the gate insulation film 24 is formed on the entire surface by, e.g., thermal oxidation.

Then, a polysilicon film 26 is formed on the entire surface by, e.g., CVD.

Next, the polysilicon film 26 is patterned by photolithography. Thus, the gate electrodes 26 of polysilicon are formed.

Next, a photoresist film (not illustrated) is formed on the entire surface by, e.g., spin coating.

Then, openings (not illustrated) for exposing the regions for the PMOS transistors 22a - 22c to be formed in are formed in the photoresist film by photolithography.

Next, with the photoresist film as the mask, a P-type dopant impurity is implanted by ion implantation. Thus, a P-type lightly doped diffused layer 30a is formed. Then, the photoresist film is released.

Then, a photoresist film (not illustrated) is formed on the entire surface by, e.g., spin coating.

Next, openings (not illustrated) for exposing the regions for the NMOS transistors 38a - 38c to be formed in are formed in the photoresist film by photolithography.

Next, with the photoresist film as the mask, an N-type dopant impurity is implanted by ion implantation. Thus, an N-type lightly doped diffused layer 46a is formed. Then, the photoresist film is released.

Next, a silicon oxide film 28 is formed on the entire surface by, e.g., CVD.

Next, the silicon oxide film 28 is anisotropically etched. Thus, the sidewall insulation film 28 of the silicon oxide film is formed on the side walls of the gate electrodes.

Next, a photoresist film (not illustrated) is formed on the entire surface by, e.g., spin coating.

Next, openings (not illustrated) for exposing the regions for the PMOS transistors 22a - 22c to be formed in and the region for the P-type contact layer 48 to be formed in are formed in the photoresist film by photolithography.

Next, with the photoresist film as the mask, a P-type dopant impurity is implanted by ion implantation. Thus, the P-type heavily doped diffused layer 30b and the P-type contact layer 48 are formed. The P-type lightly doped diffused layer 30a and the P-type heavily doped diffused layer 30b form the source/drain diffused layer 30 of LDD structure. Then, the photoresist film is released.

Then, a photoresist film (not illustrated) is formed on the entire surface by, e.g., spin coating.

Next, openings (not illustrated) for exposing the regions for the NMOS transistors 38a - 38c to be formed in and the region for the N-type contact layer 18 to be formed in are formed in the photoresist film by photolithography.

Then, with the photoresist film as the mask, an N-type dopant impurity is implanted by ion implantation. Thus, the N-type heavily diffused layer 46b and the N-type contact layer 18 are formed. The N-type lightly diffused layer 46a and the N-type heavily diffused layer 46b form the source/drain diffused layer 46 of LDD structure. Then, the photoresist film is released.

Thus, the PMOS transistors 22a - 22c including the gate electrodes 26 and the source/drain diffused layer 30 are formed on the N-type wells 16a - 16c. The NMOS transistors 38a - 38c including the gate electrodes 26 and the source/drain diffused layer 46 are formed on the P-type wells 32a, 32b. On the N-type well 16a, the N-type contact layer 18 is formed. On the P-type well 32b, the P-type contact layer 48 is formed.

The N-type contact layer 18 is connected to the bias input terminal 20. The backside of the semiconductor substrate 10 is connected to another bias input terminal 36. The P-type contact layer 48 is connected further to another bias input terminal 50.

Thus, the semiconductor device according to the present embodiment will be fabricated (see FIG. 5B).

### [A Second Embodiment]

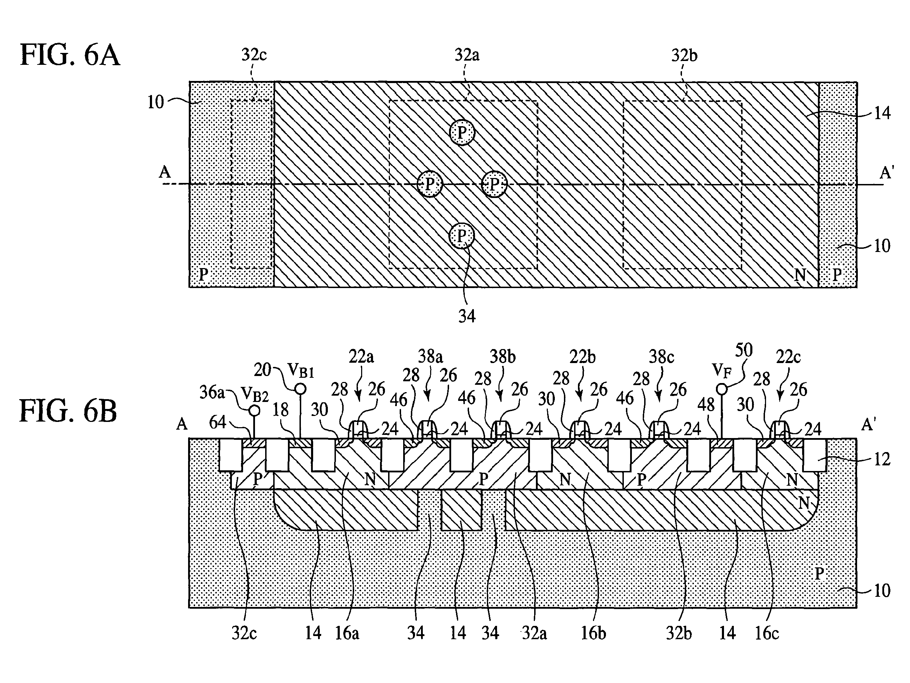

The semiconductor device according to a second embodiment of the present invention and the method for fabricating the semiconductor device will be explained with reference to FIGs. 6A to FIG. 8B. FIGs. 6A and 6B are a plan view and a sectional view of the semiconductor device according to the present embodiment. FIG. 6A is a plan view, and FIG. 6B is the sectional view along the line A-A' in FIG. 6A. The same members of the semiconductor device according to the first embodiment and the method for fabricating the semiconductor device illustrated in FIGs. 1A to 5B are represented by the same reference numbers not to repeat or to simplify the explanation.

### (The Semiconductor Device)

First, the semiconductor device according to the present embodiment will be explained with reference to FIGs. 6A and 6B.

The semiconductor device according to the present embodiment is characterized mainly in that a P-type well 32c is further formed in a P-type semiconductor substrate 10, a P-type contact layer 64 is further formed on the surface of the P-type well 32c, and the P-type semiconductor substrate 10 is connected to a bias input terminal 36a via the P-type well 32c and the P-type contact layer 64.

As illustrated in FIGs. 6A and 6B, the P-type well 32c is formed in the P-type semiconductor substrate 10 on the left side of an N-type well 16a as viewed in the drawing.

The P-type contact layer 64 is formed on the P-type well 32c. The P-type contact layer 64 is connected to the bias input terminal 36a. A bias voltage V_{B2} to be applied to the bias input terminal 36a is set suitably for an operational state of the NMOS transistors. That is, a variable bias (variable back bias) V_{B2} is applied to the bias input terminal 36a. When a bias voltage V_{B2} is applied to the bias input terminal 36a, the bias voltage V_{B2} can be applied to a P-type well 32a via the P-type contact layer 64, the P-type well 32c, the P-type semiconductor substrate 10 and a P-type contact region 34.

As described above, it is possible that the P-type well 32c is further formed in the P-type semiconductor substrate 10, the P-type contact layer 64 is further formed on the surface of the P-type well 32c, and the P-type semiconductor substrate 10 is connected to the bias input terminal 36a via the P-type well 32c and the P-type contact layer 64. In the present embodiment as well, the bias voltage V_{B2} can be applied to the P-type well 32a via the P-type semiconductor substrate 10 and the P-type contact region 34.

### (The Method for Fabricating the Semiconductor Device)

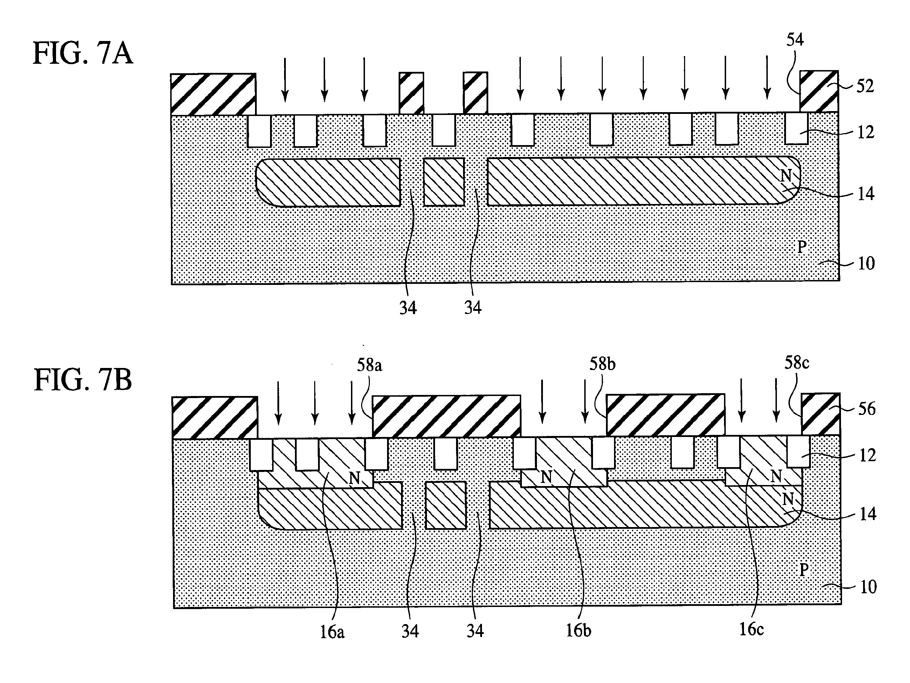

Next, the method for fabricating the semiconductor device according to the present embodiment will be explained with reference to FIGs. 7A to 8B. FIGs. 7A to 8B are sectional views of the method for fabricating the semiconductor device according to the present embodiment, which illustrate the method.

First, in the same way as in the semiconductor device fabricating method illustrated in FIG. 4A, the N-type impurity layer 14 is formed (see FIG. 7A)

Next, in the same way as in the semiconductor device fabricating method illustrated in FIG. 4B, the N-type wells 16a - 16c are formed in the semiconductor substrate 10 (see FIG. 7B).

Then, a photoresist film 60a is formed by, e.g., spin coating.

Then, the photoresist film 60a is patterned by photolithography. At this time, the photoresist film 60a is patterned to expose the regions for the P-type wells 32a - 32c to be formed in. Thus, openings 62a - 62c for forming the P-type wells 32a - 32c are formed in the photoresist film 60a.

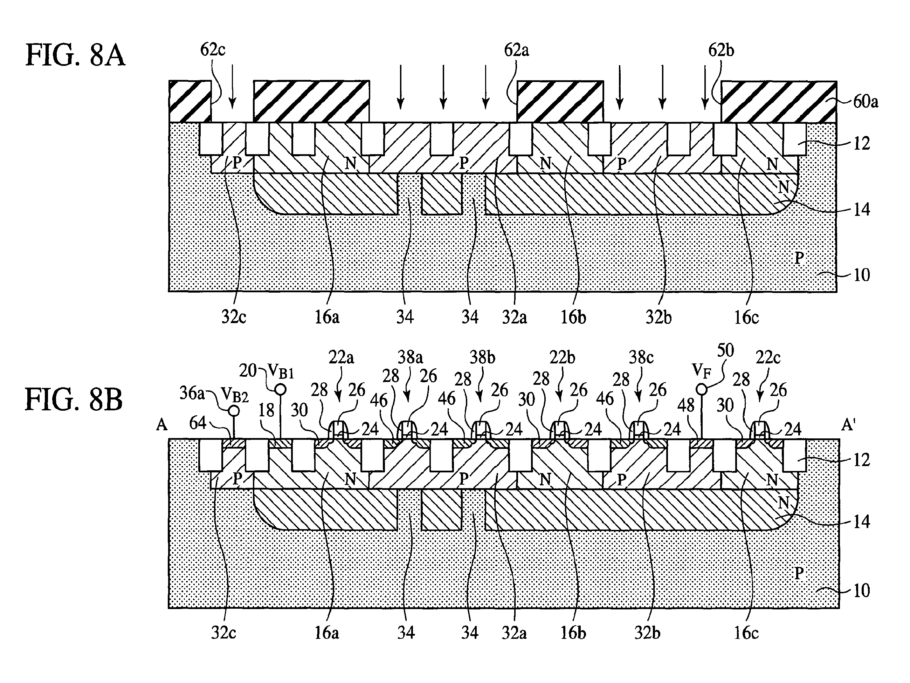

Then, with the photoresist film 60a as the mask, a P-type dopant impurity is implanted into the semiconductor substrate 10 by ion implantation. The ion implantation conditions are as exemplified below. The dopant impurity is, e.g., boron. The acceleration voltage is, e.g., 150 keV. The dose is, e.g., 3.0×10¹³ cm⁻². Thus, a plurality of the P-type wells 32a - 32c are formed in the semiconductor substrate 10 (see FIG. 8A). The P-type contact regions 34 are formed selectively immediately below the P-type well 32a. The P-type well 32a is connected to the P-type semiconductor substrate 10 via the P-type contact regions 34. The P-type contact regions 34 are not formed in the N-type impurity layer 14 immediately below the P-type well 32b. The P-type well 32b is electrically isolated from the P-type semiconductor substrate 10 by the N-type impurity layer 14 and the N-type wells 16a - 16c. The P-type well 32c, which is not enclosed by the N-type wells 16a - 16c and the N-type impurity layer 14, is connected to the P-type semiconductor substrate 10.

Next, the gate insulation film 24 is formed on the entire surface by, e.g., thermal oxidation.

Next, a polysilicon film 26 is formed on the entire surface by, e.g., CVD.

Next, the polysilicon film 26 is patterned by photolithography. Thus, the gate electrodes 26 of polysilicon are formed.

Next, a photoresist film (not illustrated) is formed on the entire surface by, e.g., spin coating.

Next, openings (not illustrated) for exposing the regions for the PMOS transistors 22a - 22c to be formed in are formed in the photoresist film by photolithography.

Next, with the photoresist mask as the mask, a P-type dopant impurity is implanted by ion implantation. Thus, the P-type lightly diffused layer 30a is formed. Then, the photoresist film is released.

Next, a photoresist film (not illustrated) is formed on the entire surface by, e.g., spin coating.

Then, openings (not illustrated) for exposing the regions for the NMOS transistors 38a - 38b to be formed in are formed in the photoresist film by photolithography.

Next, with the photoresist film as the mask, an N-type dopant impurity is implanted by ion implantation. Thus, the N-type lightly diffused layer 46a is formed. Then, the photoresist film is released.

Next, a silicon oxide film 28 is formed on the entire surface by, e.g., CVD.

Then, the silicon oxide film 28 is anisotropically etched. Thus, the sidewall insulation film 28 of silicon oxide film is formed on the side walls of the gate electrodes 26.

Next, a photoresist film (not illustrated) is formed on the entire surface by, e.g., spin coating.

Next, openings for exposing the regions for the PMOS transistors 22a - 22c to be formed in and the P-type contact layers 48, 64 to be formed in are formed in the photoresist film by photolithography.

Then, with the photoresist film as the mask, a P-type dopant impurity is implanted by ion implantation. Thus, the P-type heavily diffused layer 30b and the P-type contact layers 48, 64 are formed by ion implantation. The source/drain diffused layer 30 of LDD structure is formed on the P-type lightly diffused layer 30a and the P-type heavily diffused layer 30b. Then, the photoresist film is released.

Next, a photoresist film (not illustrated) is formed on the entire surface by, e.g., spin coating.

Next, openings (not illustrated) for exposing the region for the NMOS transistors 38a - 38c to be formed in and the regions for the N-type contact layers 48, 64 to be formed in are formed in the photoresist film by photolithography.

Next, with the photoresist film as the mask, an N-type dopant impurity is implanted by ion implantation. Thus, the N-type heavily diffused layer 46b and the N-type contact layer 18 are formed. The source/drain diffused layer 46 of LDD structure is formed of the N-type lightly diffused layer 46a and the N-type heavily diffused layer 46b. Then, the photoresist film is released.

Thus, the PMOS transistors 22a - 22c including the gate electrodes 26 and the source/drain diffused layer 30 are formed on the N-type wells 16a - 16c. The NMOS transistors 38a - 38c including the gate electrodes 26 and the source/drain diffused layer 46 are formed on the P-type wells 32a, 32b. The N-type contact layer 18 is formed on the N-type wells 16a. The P-type contact layer 48 is formed on the P-type well 32b. The P-type contact layer 64 is formed on the P-type well 32c.

The N-type contact layer 18 is connected to the bias input terminal 20. The P-type contact layer 64 is connected to another bias input terminal 36a. The P-type contact layer 48 is connected to further another bias input terminal 50.

Thus, the semiconductor device according to the present embodiment is fabricated (see FIG. 8B).

### [A Third Embodiment]

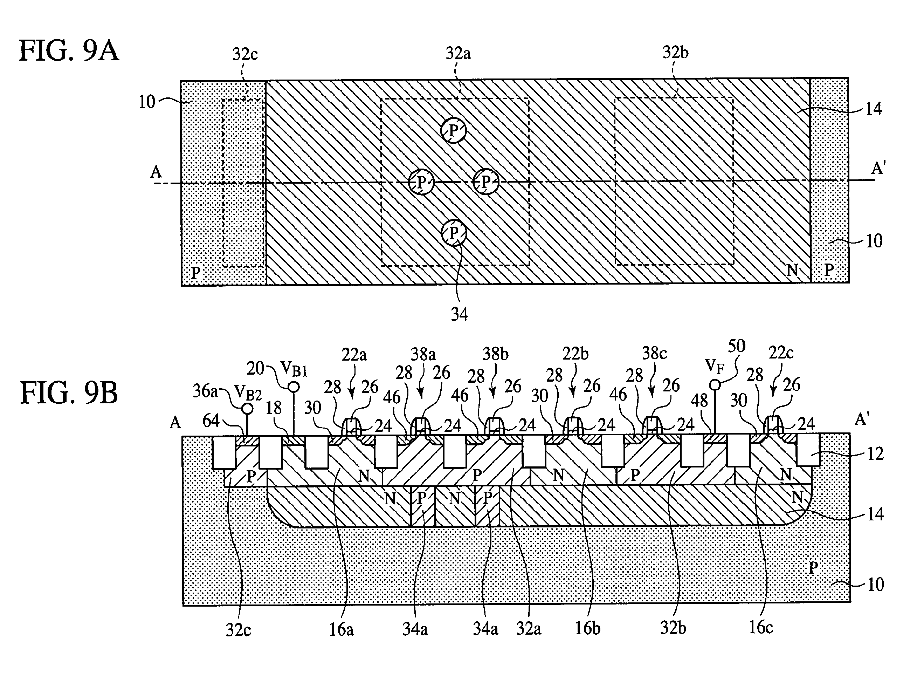

The semiconductor device according to a third embodiment of the present invention and the method for fabricating the semiconductor device will be explained with reference to FIGs. 9A to 12. FIGs. 9A and 9B are a plan view and a sectional view of the semiconductor device according to the present embodiment. FIG. 9A is the plan view, and the FIG. 9B is the sectional view along the line A-A' in FIG. 9A. The same members of the present embodiment as those of the semiconductor device according to the first or the second embodiment and the method for fabricating the semiconductor device illustrated in FIGs. 1 to 8 are represented by the same reference numbers not to repeat or to simplify their explanation.

### (The Semiconductor Device)

First, the semiconductor device according to the present embodiment will be explained with reference to FIGs. 9A and 9B.

The semiconductor device according to the present embodiment is characterized mainly in that a P-type dopant impurity is implanted in a P-type semiconductor substrate 10 to thereby form P-type contact regions 34a.

As illustrated in FIGs. 9A and 9B, the P-type contact regions 34a are formed in an N-type impurity layer 14 immediately below the region where a P-type well 32a is formed. The P-type contact regions 34 are formed by implanting a P-type dopant impurity in the P-type semiconductor substrate 10. Accordingly, the impurity concentration in the P-type contact regions 34a is higher than an impurity concentration of the P-type semiconductor substrate 10.

As described above, the P-type contact regions 34a may be formed by implanting a P-type dopant impurity in the P-type semiconductor substrate 10. According to the present embodiment, the impurity concentration in the P-type contact regions 34a is set higher, which makes it possible to more surely prevent the depletion of the P-type contact regions 34a.

### (The Method for Fabricating the Semiconductor Device)

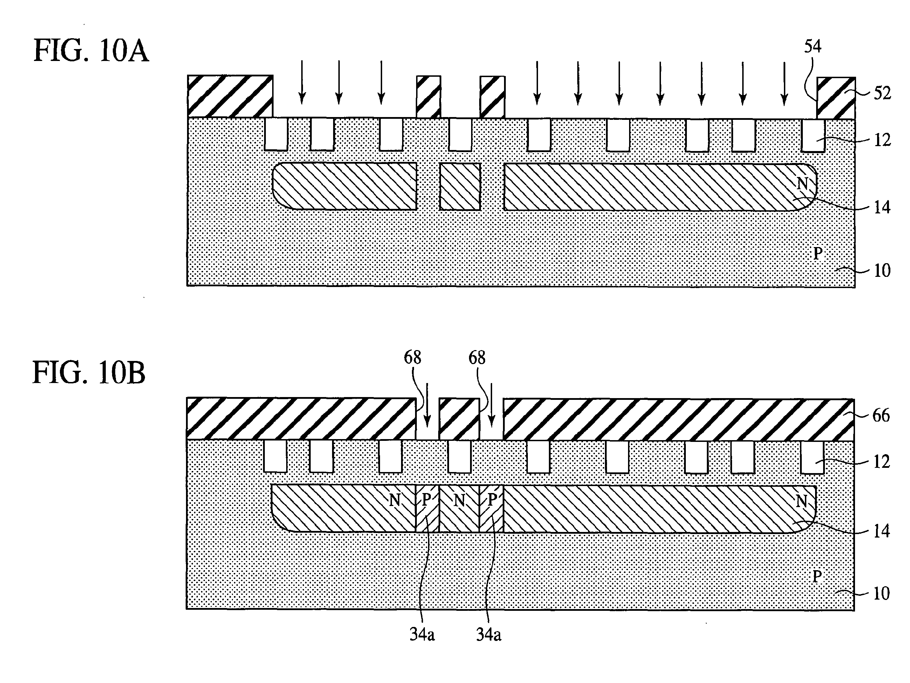

Next, the method for fabricating the semiconductor device according to the present embodiment will be explained with reference to FIGs. 10A to 12. FIGs. 10A to 12B are sectional views of the semiconductor device according to the present embodiment in the steps of the method for fabricating the semiconductor device, which illustrate the method.

First, in the same way as in the semiconductor device fabricating method described above with reference to FIG. 4A, the N-type impurity layer 14 is formed in the semiconductor substrate 10 (see FIG. 10A).

Next, a photoresist film 66 is formed by, e.g., spin coating.

Next, the photoresist film 66 is patterned by photolithography. At this time, the photoresist film 66 is patterned to expose the regions for the P-type contact regions 34a to be formed in. Thus, the opening 68 for forming the P-type well 34a is formed in the photoresist film 66.

Then, with the photoresist film 66 as the mask, a P-type dopant impurity is implanted into the semiconductor substrate 10 by ion implantation. At this time, the ion implantation conditions are set so that the P-type dopant impurity can be implanted into a deeper region remote from the surface of the semiconductor substrate 10. The ion implantation conditions are as exemplified below. The dopant impurity is, e.g., boron. The acceleration voltage is, e.g., 370 keV. The dose is, e.g., 1.5×10¹³ cm⁻². Thus, the P-type contact region 34a is formed in the semiconductor substrate 10 (see FIG. 10B).

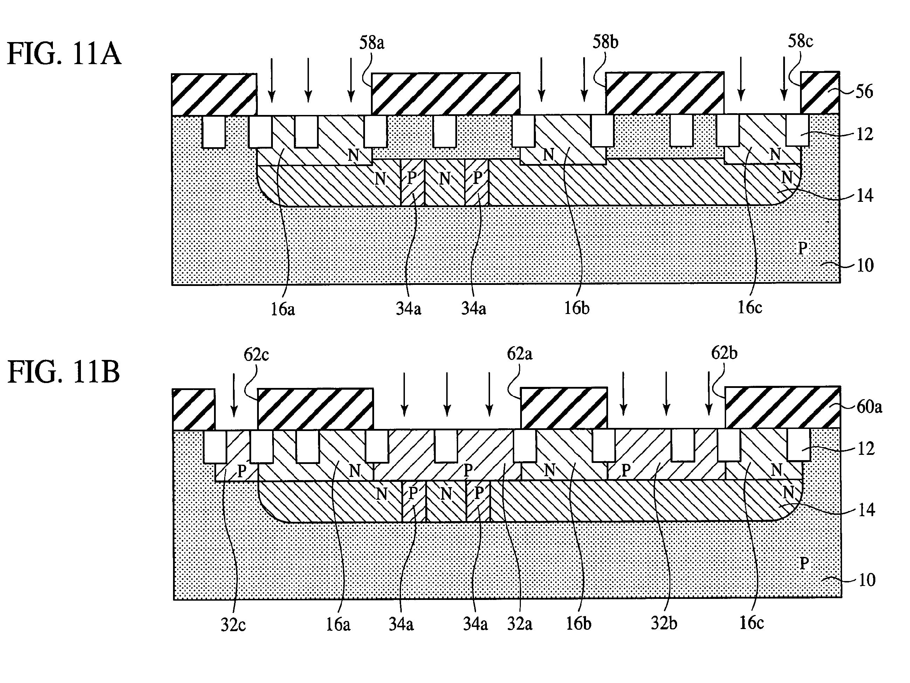

Next, in the same way as in the semiconductor device fabricating method described above with reference to FIG. 4B, N-type wells 16a - 16c are formed in the semiconductor substrate 10 (see FIG. 11A).

Next, in the same way as in the semiconductor device fabricating method described above with reference to FIG. 8A, a plurality of P-type wells 32a - 32c are formed in the semiconductor substrate 10 (see FIG. 11B).

The process of the semiconductor fabricating method following hereafter is the same as that of the semiconductor device fabricating method described above with reference to FIG. 8B, and the explanation will be omitted.

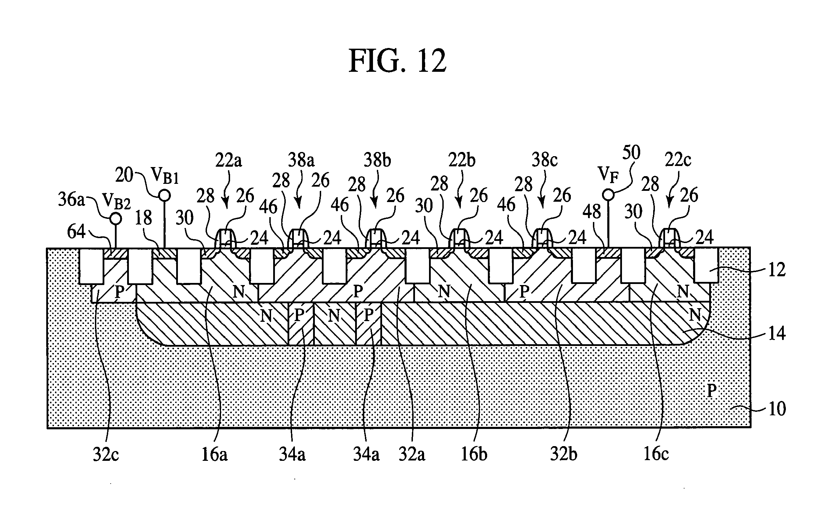

Thus, the semiconductor device according to the present embodiment is fabricated (see FIG. 12).

### (A Modification of the Method for Fabricating the Semiconductor Device)

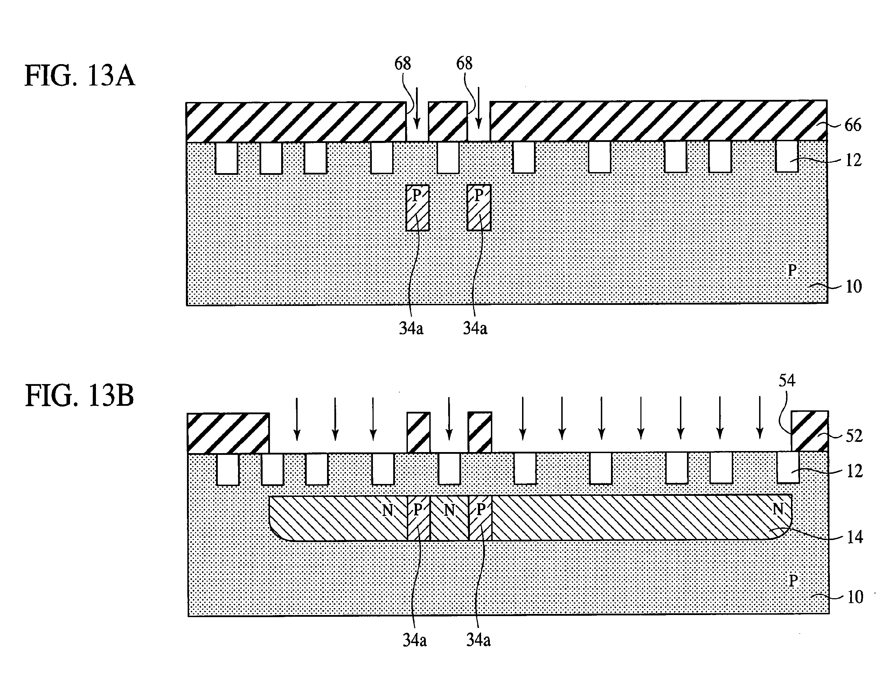

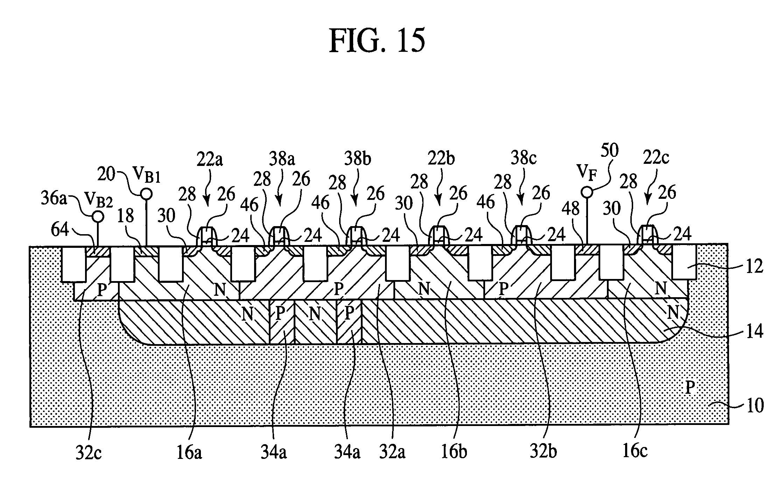

Next, the semiconductor device fabricating method according to a modification of the present embodiment will be explained with reference to FIGs. 13 to 15. FIGs. 13 to 15 are sectional views of the semiconductor device, which illustrate the semiconductor device fabricating method according to the present modification.

The semiconductor device fabricating method according to the present modification is characterized mainly in that a P-type dopant impurity is implanted into the P-type semiconductor substrate 10 to thereby form the P-type contact regions 34a, and then an N-type dopant impurity is implanted into the P-type semiconductor substrate 10 to thereby form the N-type impurity layer 14.

First, as illustrated in FIG. 13A, the device isolation regions 12 for defining the device regions are formed. The device isolation regions 12 can be formed by, e.g., STI.

Next, a photoresist film 66 is formed by, e.g., spin coating.

Next, the photoresist film 66 is patterned by photolithography. At this time, the photoresist film 66 is patterned to expose the regions for the P-type contact regions 34a to be formed in. Thus, an opening 68 for forming the P-type well 34a is formed in the photoresist film 66.

Next, with the photoresist film 66 as the mask, a P-type dopant impurity is implanted into the semiconductor substrate 10 by ion implantation. At this time, the ion implantation conditions are set so that the P-type dopant impurity is implanted into a deep region remote from the surface of the semiconductor substrate 10. The ion implantation conditions are as exemplified below. The dopant impurity is, e.g., boron. The acceleration voltage is, e.g., 370 keV. The dose is, e.g., 1.5×10¹³ cm⁻². Thus, the P-type contact region 34a is formed in the semiconductor substrate 10. Then, the photoresist film 66 is released.

Then, a photoresist film 52 is formed by, e.g., spin coating.

Next, the photoresist film 52 is patterned by photolithography. At this time, the photoresist film 52 is patterned to cover the regions where the contact regions 34a are formed and expose the region for the N-type impurity layer 14 to be formed in. Thus, an opening 54 for forming the N-type impurity layer 14 is formed in the photoresist film 52.

Then, with the photoresist film 52 as the mask, an N-type dopant impurity is implanted into the semiconductor substrate 10 by ion implantation. At this time, the ion implantation conditions are set so that the N-type dopant impurity is implanted into a deep region remote from the surface of the semiconductor substrate 10. The ion implantation conditions are as exemplified below. The dopant impurity is, e.g., phosphorus. The acceleration voltage is, e.g., 360 keV. The dose is, e.g., 3.0×10¹³ cm⁻². Thus, the N-type impurity layer 14 is formed in the deep region remote from the surface of the semiconductor substrate 10. Then, the photoresist film 52 is released.

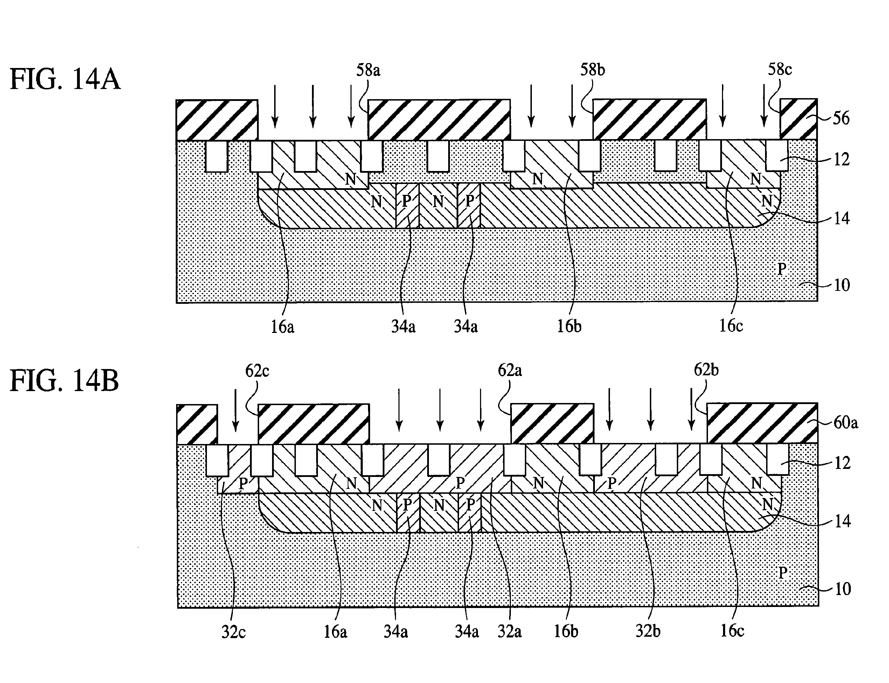

The process of the semiconductor fabricating method following hereafter is the same as that of the semiconductor device fabricating method described above with reference to FIGs. 11A to 12, and the explanation will be omitted (FIGs. 14A to 15).

### [A Fourth Embodiment]

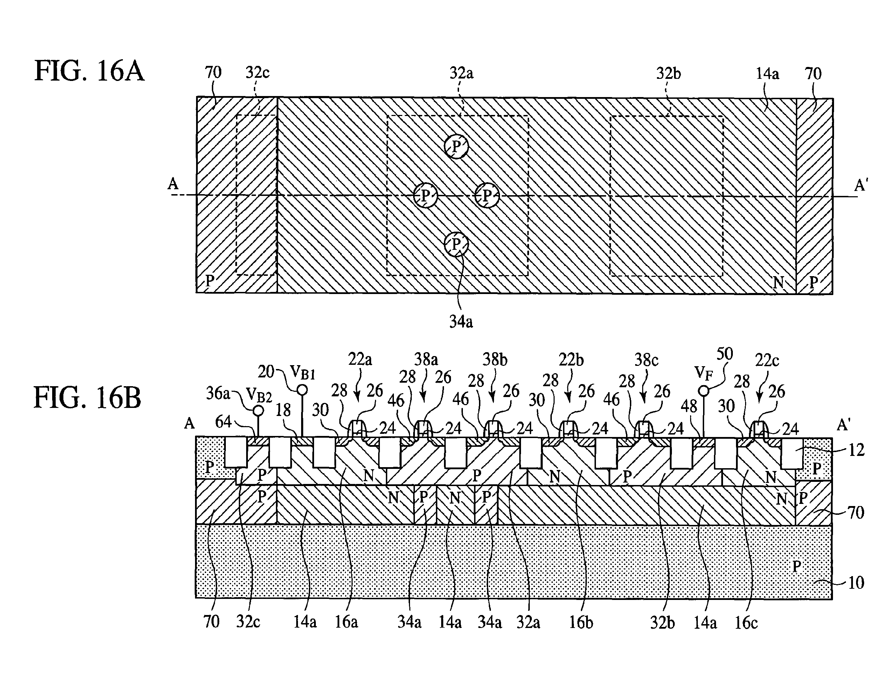

The semiconductor device according to a fourth embodiment of the present invention and the method for fabricating the semiconductor device will be explained with reference to FIGs. 16A to 19. FIGs. 16A and 16B are a plan view and a sectional view of the semiconductor device according to the present embodiment. FIG. 16A is the plan view, and FIG. 16B is the sectional view along the line A-A' in FIG. 16A. The same members of the present embodiment as those of the semiconductor device and the method for fabricating the semiconductor device according to the first to the third embodiment illustrated in FIGs. 1A to 15 are represented by the same reference numbers not to repeat or to simplify their explanation.

### (The Semiconductor Device)

First, the semiconductor device according to the present embodiment will be explained with reference to FIG. 16A and 16B.

The semiconductor device according to the present embodiment is characterized mainly in that a P-type dopant impurity is implanted into the entire surface of a P-type semiconductor substrate 10, and then an N-type dopant impurity is heavily implanted into a region for an N-type impurity layer 14a to be formed in to thereby form P-type contact regions 34a, the P-type impurity layer 70 and the N-type impurity layer 14a.

As illustrated in FIGs. 16A and 16B, the N-type impurity layer 14a is formed below N-type wells 16a - 16c and below P-type wells 32a, 32b.

The P-type contact regions 34a are formed in the N-type impurity layer 14a immediately below the region where the P-type well 32a is formed. The P-type well 32a is connected to the P-type semiconductor substrate 10 via the P-type contact regions 34a.

The P-type impurity layer 70 is formed in the P-type semiconductor substrate 10 outside the region where the N-type impurity layer 14a is formed. A P-type well 32c is connected to the P-type semiconductor substrate 10 via the P-type impurity layer 70.

The P-type contact regions 34a and the P-type impurity layer 70 are formed by implanting a P-type dopant impurity into the entire surface of the P-type semiconductor substrate 10, heavily implanting an N-type dopant impurity in the region except the regions for the P-type contact regions 34a to be formed in and in the region except the region for the P-type impurity layer 70 to be formed in. The impurity concentration in the P-type contact regions 34a and the impurity concentration in the P-type impurity layer 70 are higher than the impurity concentration in the P-type semiconductor substrate 10.

The P-type impurity layer 70 is formed immediately below the P-type well 32c, and the P-type contact regions 34a are formed immediately below the P-type well 32a, whereby a bias voltage V_{B2} can be applied to the P-type well 32a via the P-type contact layer 64, the P-type well 32c, the P-type impurity layer 70, the P-type semiconductor substrate 10 and the P-type contact regions 34a.

As described above, the P-type contact regions 34a, the P-type impurity layer 70 and the N-type impurity layer 14a may be formed by implanting a P-type dopant impurity into the entire surface of the P-type semiconductor substrate 10 and the heavily implanting an N-type dopant impurity into the region for the N-type impurity layer 14a to be formed in.

### (The Method for Fabricating the Semiconductor Device)

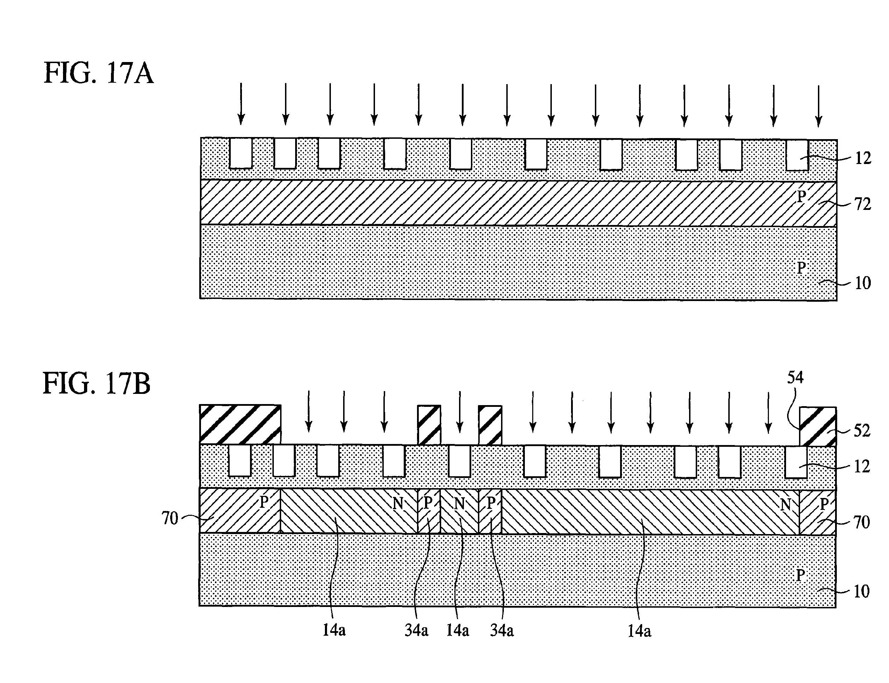

Next, the method for fabricating the semiconductor device according to the present embodiment will be explained with reference to FIGs. 17A to 19. FIGs. 17A to 19 are sectional views of the semiconductor device according to the present embodiment in the steps of the method for fabricating the semiconductor device, which illustrate the method.

First, as illustrated in FIG. 17A, device isolation regions 12 for defining device regions are formed. The device isolation regions 12 can be formed by, e.g., STI.

Next, a P-type dopant impurity is implanted into the entire surface by ion implantation. At this time, the ion implantation conditions are set so that the P-type dopant impurity is implanted into a deep region remote from the surface of the semiconductor substrate 10. The ion implantation conditions are as exemplified below. The dopant impurity is, e.g., boron. The acceleration voltage is, e.g., 370 keV. The dose is, e.g., 1.5×10¹³ cm⁻². Thus, the P-type impurity layer 72 is formed in the deep region remote from the surface of the semiconductor substrate 10.

Then, a photoresist film 52 is formed by, e.g., spin coating.

Next, the photoreisst film 52 is patterned by photolithography. At this time, the photoresist film 52 is patterned to expose the region for the N-type impurity layer 14a to be formed in. Thus, an opening 54 for forming the N-type impurity layer 14a is formed in the photoresist film 52.

Then, with the photoresist film 52 as the mask, an N-type dopant impurity is implanted into the semiconductor substrate 10 by ion implantation. At this time, the ion implantation conditions are set so that the N-type dopant impurity is implanted into a deep region remote from the surface of the semiconductor substrate 10. The ion implantation conditions are as exemplified below. The dopant impurity is, e.g., phosphorus. The acceleration voltage is, e.g., 700 keV. The dose is, e.g., 3.0×10¹³ cm⁻². Thus, the N-type impurity layer 14a is formed in the semiconductor substrate 10. The N-type dopant impurity is not implanted into the region for the P-type contact region 34a to be formed in, and accordingly, in the regions for the P-type contact regions 34a to be formed in, the P-type contact regions 34a are formed of a part of the P-type impurity layer 72. Thus, the P-type contact regions 34a are formed selectively immediately below the region for the P-type well 32a to be formed in. In the P-type semiconductor substrate 10 outside the N-type impurity layer 14a, the P-type impurity layer 70 is formed of a part of the P-type impurity layer 72 (see FIG. 17B).

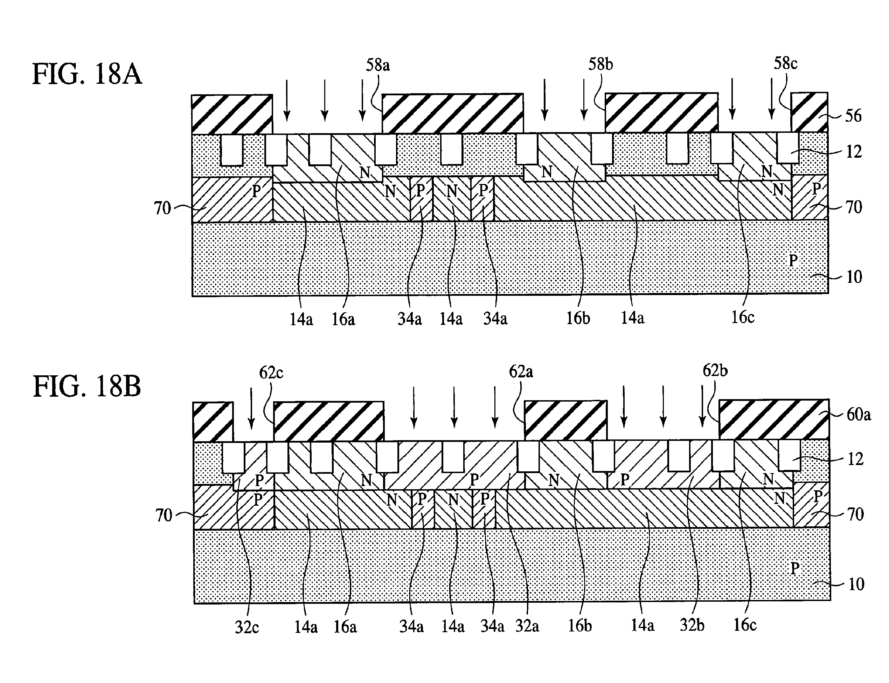

Then, in the same way as in the semiconductor device fabricating method described above with reference to FIG. 4B, the N-type wells 16a - 16c are formed in the semiconductor substrate 10 (see FIG. 18A).

Next, in the same way as in the semiconductor device fabricating method described above with reference to FIG. 8A, the P-type wells 32a - 32c are formed in the semiconductor substrate 10 (see FIG. 18B).

The process of the semiconductor device fabricating method following hereafter is the same as that of the semiconductor device fabricating method described above with reference to FIG. 8B, and the explanation will be omitted.

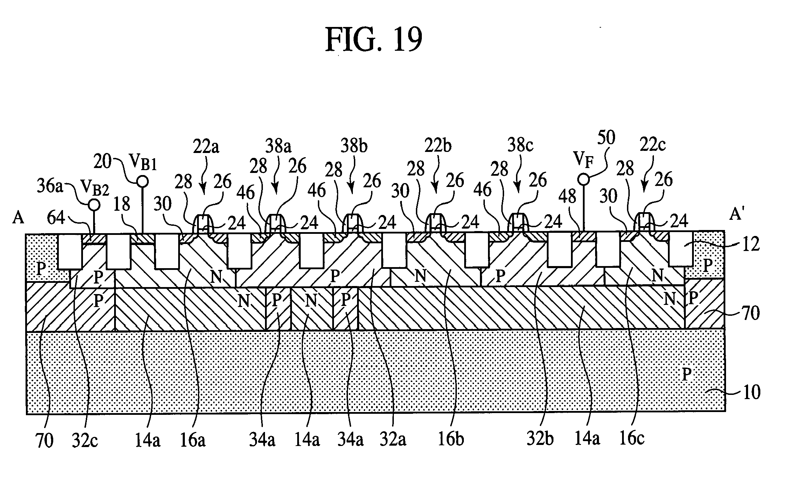

Thus, the semiconductor device according to the present embodiment is fabricated (see FIG. 19).

### [A Fifth Embodiment]

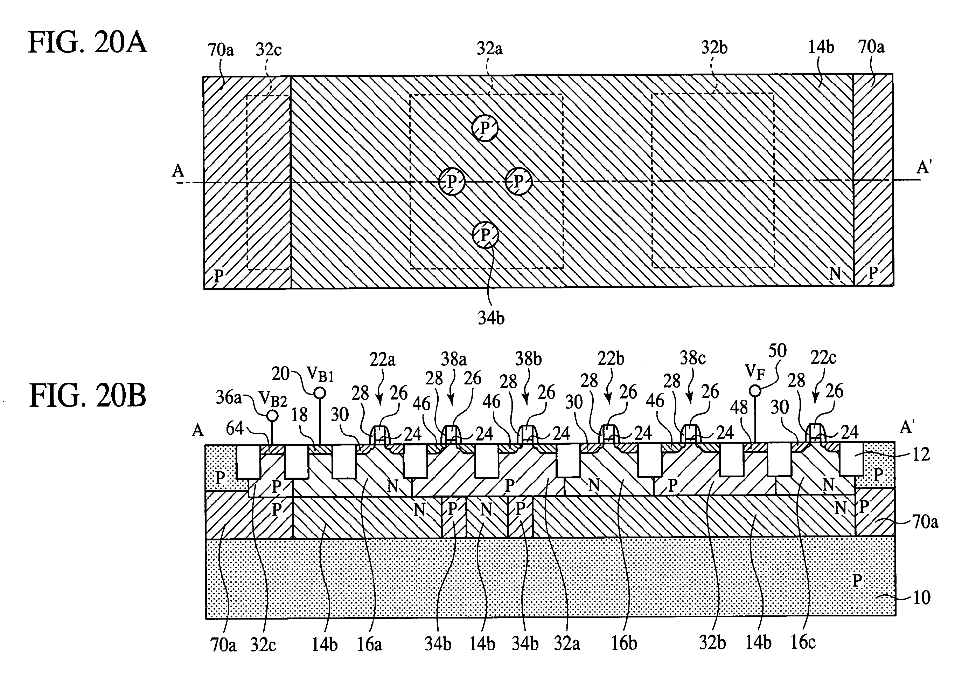

The semiconductor device according to a fifth embodiment of the present invention and the method for fabricating the semiconductor device will be explained with reference to FIGs. 20A to 23. FIG. 20A and 20B are a plan view and a sectional view of the semiconductor device according to the present embodiment. FIG. 20A is the plan view, and the FIG. 20B is the sectional view along the line A-A' in FIG. 20A. The same members of the present embodiment as those of the semiconductor device according to the first to the fourth embodiments and the method for fabricating the semiconductor device illustrated in FIGs. 1A to 19 are represented by the same reference numbers not to repeat or to simplify their explanation.

### (The Semiconductor Device)

First, the semiconductor device according to the present embodiment will be explained with reference to FIGs. 20A and 20B.

The semiconductor device according to the present embodiment is characterized mainly in that a N-type dopant impurity is implanted into the entire surface of a P-type semiconductor substrate 10, and then an P-type dopant impurity is heavily implanted into a region for the P-type impurity layer 34b to be formed in and a region for the P-type impurity layer 70a to be formed in to thereby form P-type contact regions 34b, a P-type impurity layer 70a and an N-type impurity layer 14b.

As illustrated in FIGs. 20A and 20B, the N-type impurity layer 14b is formed below N-type wells 16a - 16c and below P-type wells 32a, 32b.

The P-type contact regions 34a are formed in the N-type impurity layer 14b immediately below the region where the P-type well 32a is formed. The P-type well 32a is connected to the P-type semiconductor substrate 10 via the P-type contact regions 34b.

A P-type impurity layer 70a is formed in the P-type semiconductor substrate 10 outside the region where the N-type impurity layer 14b is formed. A P-type well 32c is connected to the P-type semiconductor substrate 10 via the P-type impurity layer 70a.

The P-type contact regions 34b and the P-type impurity layer 70a are formed by implanting an N-type dopant impurity into the entire surface of the P-type semiconductor substrate 10 and implanting a P-type dopant impurity into the regions for the P-type contact regions 34b to be formed in and the region for the P-type impurity layer 70a to be formed in. The impurity concentration in the P-type contact regions 34b and the impurity concentration in the P-type impurity layer 70a are higher than the impurity concentration in the P-type semiconductor substrate 10.

The P-type impurity layer 70a is formed immediately below the P-type well 32c, and the P-type contact regions 34b are formed immediately below the P-type well 32a, whereby a bias voltage V_{B2} can be applied to the P-type well 32a via the P-type contact layer 64, the P-type well 32c, the P-type impurity layer 70a, the P-type semiconductor substrate 10 and the P-type contact regions 34b.

Thus, it is possible that the P-type contact regions 34b, the P-type impurity layer 70a and the N-type impurity layer 14b are formed by implanting an N-type dopant impurity into the entire surface of the P-type semiconductor substrate 10 and implanting a P-type dopant impurity into the regions for the P-type contact regions 34b to be formed in, the region for the P-type impurity layer 70a to be formed in,

### (The Method for Fabricating the Semiconductor Device)

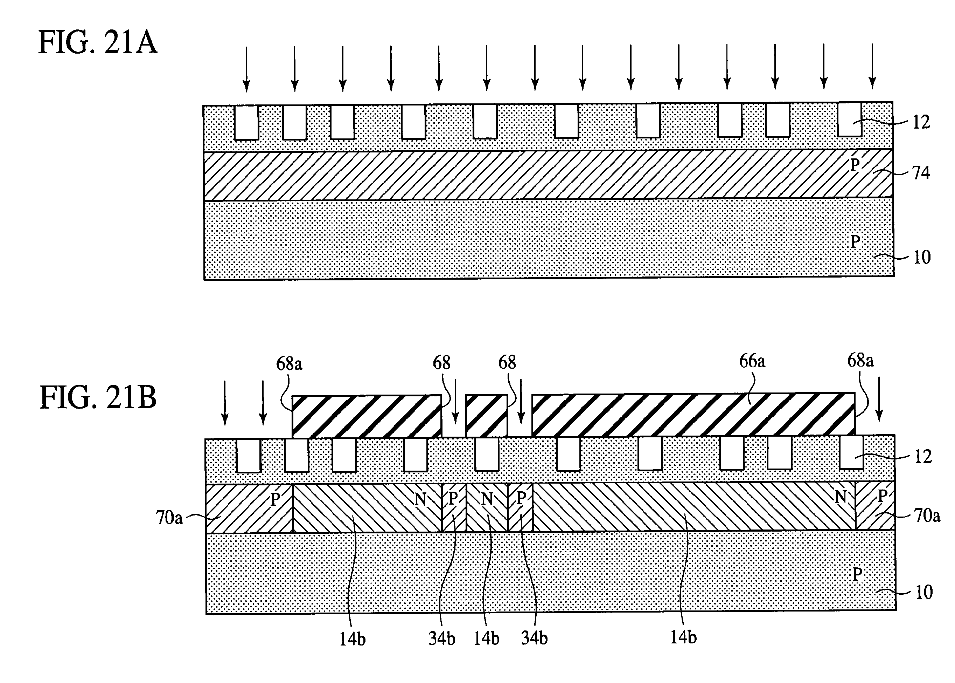

Next, the method for fabricating the semiconductor device according to the present embodiment will be explained with reference to FIGs. 21A to 23. FIGs. 21A to 23 are sectional views of the semiconductor device according to the present embodiment in the steps of the method for fabricating the semiconductor device, which illustrate the method.

First, as illustrated in FIG. 21A, device isolation regions 12 for defining device regions are formed. The device isolation regions 12 can be formed by, e.g., STI.

Next, an N-type dopant impurity is implanted into the entire surface of the semiconductor substrate 10 by ion implantation. At this time, the ion implantation conditions are set so that the N-type dopant impurity is implanted in a deep region remote from the surface of the semiconductor substrate 10. The ion implantation conditions are as exemplified below. The dopant impurity is, e.g., phosphorus. The acceleration voltage is, e.g., 700 keV. The dose is, e.g., 1.5×10¹³ cm⁻². Thus, the N-type impurity layer 74 is formed in the deep region remote from the surface of the semiconductor substrate 10.

Next, a photoresist film 66a is formed by, e.g., spin coating.

Next, the photoresist film 66a is patterned by photolithography. At this time, the photoresist film 66a is patterned to expose the regions for the P-type contact regions 34a to be formed in and the region for the P-type impurity layer 70 to be formed in. Thus, an opening 68 for forming the P-type well 34b and an opening 68a for forming the P-type impurity layer 70a are formed in the photoresist film 66a.

Next, with the photoresist film 66a as the mask, a P-type dopant impurity is implanted heavily into the semiconductor substrate 10. At this time, the ion implantation conditions are set so that the P-type dopant impurity is implanted in a deep region remote from the surface of the semiconductor substrate 10. The ion implantation conditions are as exemplified below. The dopant impurity is, e.g., boron. The acceleration voltage is, e.g., 370 keV. The dose is, e.g., 3.0×10¹³ cm⁻². Thus, the P-type contact regions 34a of the heavily implanted P-type dopant impurity are formed selectively immediately below the region for the P-type well 32a to be formed in. In the P-type semiconductor substrate 10 outside the N-type impurity layer 14b, the P-type impurity layer 70a of the heavily doped P-type dopant impurity is formed (see FIG. 21B).

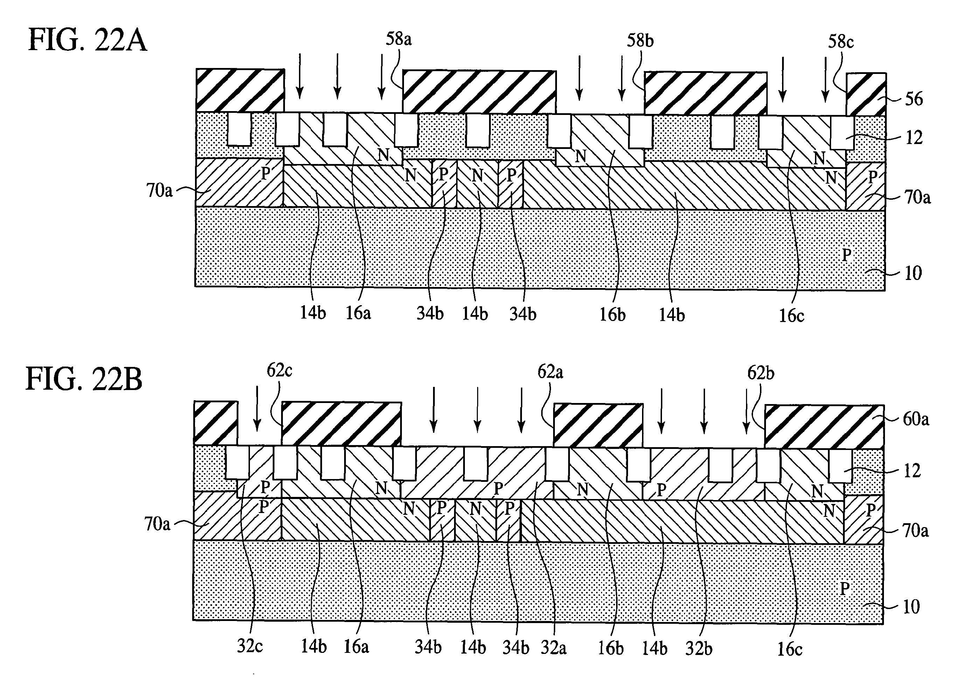

Next, in the same way as in the semiconductor device fabricating method described above with reference to FIG. 4B, the N-type wells 16a - 16c are formed in the semiconductor substrate 10 (see FIG. 22A).

Next, in the same way as in the semiconductor device fabricating method described above with reference to FIG. 8A, the P-type wells 32a - 32c are formed in the semiconductor substrate 10 (see FIG. 22B).

The process of the semiconductor device fabricating method following hereafter is the same as that of the semiconductor device fabricating method described above with reference to FIG. 8B, and the explanation will be omitted.

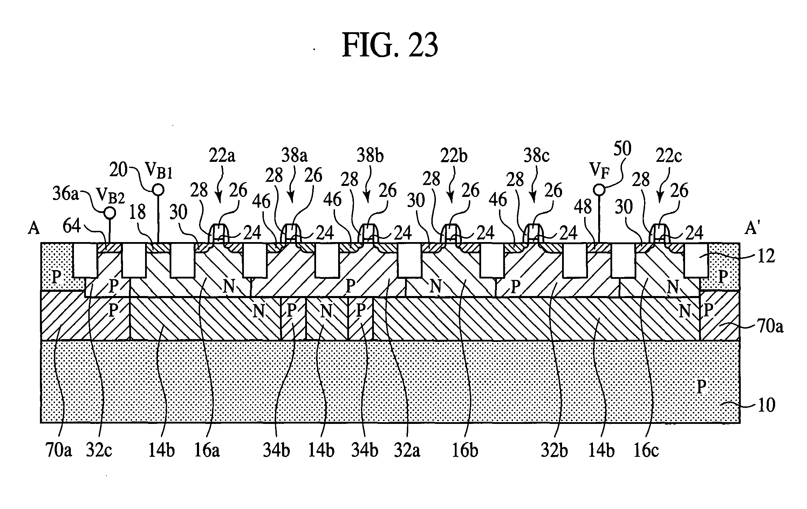

Thus, the semiconductor device according to the present embodiment is fabricated (see FIG. 23).

### [A Sixth Embodiment]

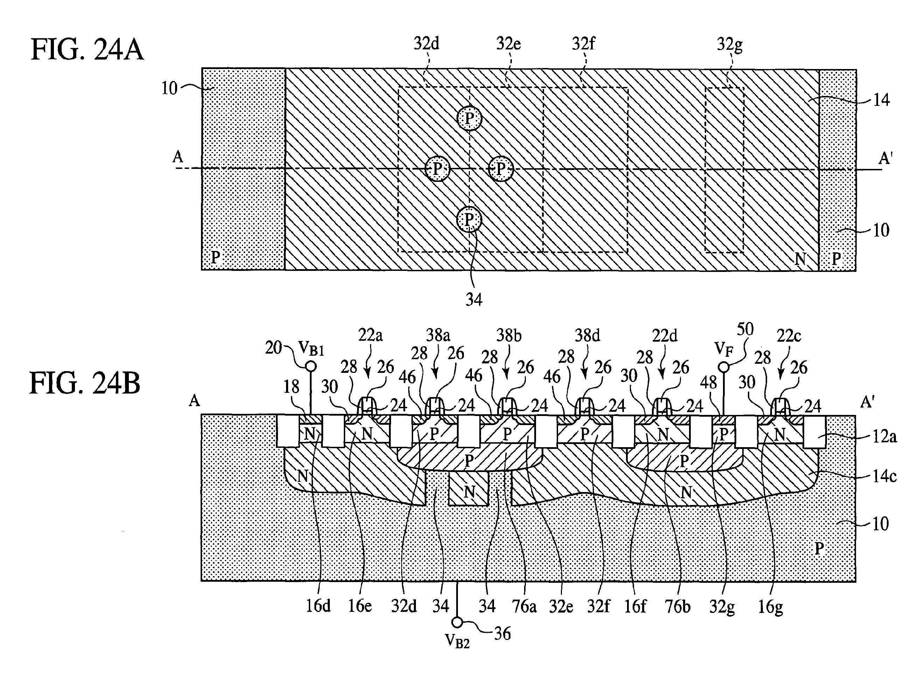

The semiconductor device according to a sixth embodiment of the present invention and the method for fabricating the semiconductor device will be explained with reference to FIGs. 24A to 27B. FIGs. 24A and 24B are a plan view and a sectional view of the semiconductor device according to the present embodiment. FIG. 24A is the plan view, and FIG. 24B is the sectional view along the line A-A' in FIG. 24A. The same members of the present embodiment as those of the semiconductor device according to the first to the fifth embodiments and the method for fabricating the semiconductor device illustrated in FIGs. 1A to 23 are represented by the same reference numbers not to repeat or to simplify their explanation.

### (The Semiconductor Device)

First, the semiconductor device according to the present embodiment will be explained with reference to FIGs. 24A and 24B.

The semiconductor device according to the present embodiment is characterized mainly in that substrate bias variable transistors and DTMOS (Dynamic Threshold MOS) transistors are mixedly mounted.

The DTMOS transistor is a MOS transistor having the substrate and the gate electrodes, more specifically, the wells and the gate electrodes electrically connected. The DTMOS transistor can dynamically varies the threshold voltage and can realize devices having good radio-frequency characteristics.

As illustrated in FIGs. 24A and 24B, device isolation regions 12a for defining device regions are formed in a P-type semiconductor substrate 10.

The device isolation regions 12a are formed deeper than N-type wells 16d - 16g and P-type wells 32a - 32g. The device isolation regions 12 are formed deeper than the upper surface of an N-type impurity layer 14c which will be described later.

In the P-type semiconductor substrate 10 with the device isolation regions 12a formed in, the N-type impurity layer (deep N-type well) 14c is buried in a deep region remote from the surface of the semiconductor substrate 10.

On the N-type impurity layer 14c, a plurality of N-type wells 16d - 16g are formed, connected to the N-type impurity layer 14c. The N-type wells 14c is for applying at once a bias voltage V_{B1} to the plural N-type wells 16d, 16e, 16g.

A PMOS transistor 22a is formed on the N-type well 16e. On the N-type well 16g, a PMOS transistor 22c is formed. The PMOS transistors 22a, 22c formed on the N-type wells 16e, 16g respectively function as substrate bias variable transistors. The substrate bias variable transistor is a transistor which varies the bias to be applied to the wells for stand-by and operation.

The PMOS transistor 22a, 22c include gate electrodes 26 formed with a gate insulation film formed therebetween, a sidewall insulation film 28 formed on the side walls of the gate electrodes 26 and a source/drain diffused layer 30 of LDD structure formed in the semiconductor substrate 10 on both sides of the gate electrodes 26.

An N-type contact layer 18 is formed on the surface of the N-type well 16d. The N-type contact layer 18 is connected to a bias input terminal 20. The bias voltage V_{B1} to be applied to the bias input terminal 20 is suitably set corresponding to operational states of the PMOS transistors 22a, 22c. That is, the variable bias V_{B1} is applied to the bias input terminal 20. When the bias voltage V_{B1} is applied to the bias input terminal 20, the bias voltage V_{B1} is applied to the N-type well 16e and the N-type well 16g via the N-type contact layer 18, the N-type well 16d and the N-type impurity layer 14c. As described above, in the present embodiment, the N-type impurity layer 14c is buried in the P-type semiconductor substrate 10, whereby the bias voltage V_{B1} can be applied at once to the plural N-type wells 16e, 16g via the N-type impurity layer 14c.

P-type impurity layers 76a, 76b are formed in the N-type impurity layer 14c. The P-type impurity layer 76a is formed immediately below the regions for the P-type well 32d and the P-type well 32e to be formed in. The P-type impurity layer 76b is formed immediately below the regions for the N-type wells 16f and the P-type well 32g to be formed in.

On the P-type impurity layer 76a, the P-type well 32d and the P-type well 32e are formed. The P-type well 32d and the P-type well 32e are electrically connected to each other by the P-type impurity layer 76a. A plurality of the P-type wells 32d and a plurality of the P-type wells 32e are formed in the semiconductor substrate 10 in the regions not illustrated but are not illustrated here.

In the N-type impurity layer 14c immediately below the region where the P-type impurity layer 76a is formed, the P-type contact regions 34 are selectively formed. The P-type contact regions 34 are for connecting the P-type impurity layer 76a and the P-type semiconductor substrate 10 to each other. The P-type well 32d and the P-type well 32e are connected to the P-type semiconductor substrate 10 via the P-type impurity layer 76a and the P-type contact region 34. The P-type contact region 34 is formed in, e.g., a cylindrical shape. The P-type contact regions 34 are formed by implanting none of an N-type dopant impurity locally when the N-type dopant impurity is implanted into the semiconductor substrate 10 to form the N-type impurity layer 14c. Accordingly, the impurity concentration in the P-type contact regions 34 and the impurity concentration in the semiconductor substrate 10 are equal to each other.

The backside of the semiconductor substrate 10 is connected to a bias input terminal 36. A bias voltage V_{B2} to be applied to the bias input terminal 36 is suitably set corresponding to operation states of the NMOS transistors. That is, a variable V_{B2} is applied to the bias input terminal 36. When a bias voltage V_{B2} is applied to the bias input terminal 36, a bias voltage V_{B2} can be applied to the P-type well 32d and the P-type well 32e via the P-type semiconductor substrate 10, the P-type contact regions 34 and the P-type impurity layer 76a.

The NMOS transistors 38a, 38b formed on the P-type wells 32d, 32e function respectively as substrate bias variable transistors.

A P-type well 32f is formed on the N-type impurity layer 14c. The P-type well 32f is electrically isolated from the P-type well 32e, the P-type impurity layer 76a, 76b and the P-type semiconductor substrate 10 by the device isolation regions 12a and the N-type impurity layer 14c.

An NMOS transistor 38d is formed on the P-type well 32f. The NMOS transistor 38d includes a gate electrode 26 formed with the gate insulation film 24 formed therebetween, the sidewall insulation film 28 formed on the side wall of the gate electrode 26, and a source/drain diffused layer 46 of LDD structure formed in the semiconductor substrate 10 on both sides of the gate electrode 26. The gate electrode 26 and the P-type well 32f are electrically connected to each other (not illustrated). The NMOS transistor 38d functions as a DTMOS transistor. As described above, the DTMOS transistor is a MOS transistor having the substrate and the gate electrode, more specifically, the well and the gate electrode electrically connected to each other. The DTMOS transistor can dynamically vary the threshold voltage and can realize a device of good radio-frequency characteristics. The P-type well 32f is isolated from the P-type well 32e and the P-type semiconductor substrate 10 by the device isolation region 12a and the N-type impurity layer 14c, whereby even when the gate electrode 26 of the NMOS transistor 38d, and the P-type well 32f are electrically connected to each other, no special problem is caused.

The N-type well 16f and the P-type well 32g are formed on the P-type impurity layer 76b.

On the N-type well 16f, the PMOPS transistor 22d is formed. The PMOS transistor 22d includes a gate electrode 26 formed with the gate insulation film 24 formed therebetween, the sidewall insulation film 28 formed on the side wall of the gate electrode 26 and the source/drain diffused layer 30 of LDD structure formed in the semiconductor substrate on both sides of the gate electrode 26. The gate electrode 26 and the N-type well 16f are electrically connected to each other (not illustrated). The PMOS transistor 22d functions as a DTMOS transistor. The N-type well 16f is isolated from the N-type impurity layer 14c by the device isolation region 12a and the P-type impurity layer 76b, whereby even when the gate electrode 26 of the PMOS transistor 22d and the N-type well 16f are electrically connected, no special problem is caused.

A P-type contact layer 48 is formed on the surface of the P-type well 32g. The P-type contact layer 48 is connected to a bias input terminal 50. A fixed bias V_{F} is applied to the bias input terminal 50. When a bias voltage V_{F} is applied to the bias input terminal 50, the bias voltage V_{F} is applied to the P-type impurity layer 16c via the P-type contact layer 48 and the P-type well 32g. The bias voltage V_{F} is applied to the P-type impurity layer 16c so as to prevent phenomenon of the leak current between electrically isolated regions, and breakdown due to the unstable of the potential.

As described above, the substrate bias variable transistors 22a, 22c, 38a, 38b and the DTMOS transistors 22d, 38d may be mixedly mounted. In the present embodiment as well, the P-type contact regions 34 are formed in the N-type impurity layer 14c immediately below the P-type well 32d, 32e, whereby a bias voltage V_{B2} can be applied to the P-type wells 32d, 32e via the P-type semiconductor substrate 10, the P-type contact regions 34 and the P-type impurity layer 76a.

### (The Method for Fabricating the Semiconductor Device)

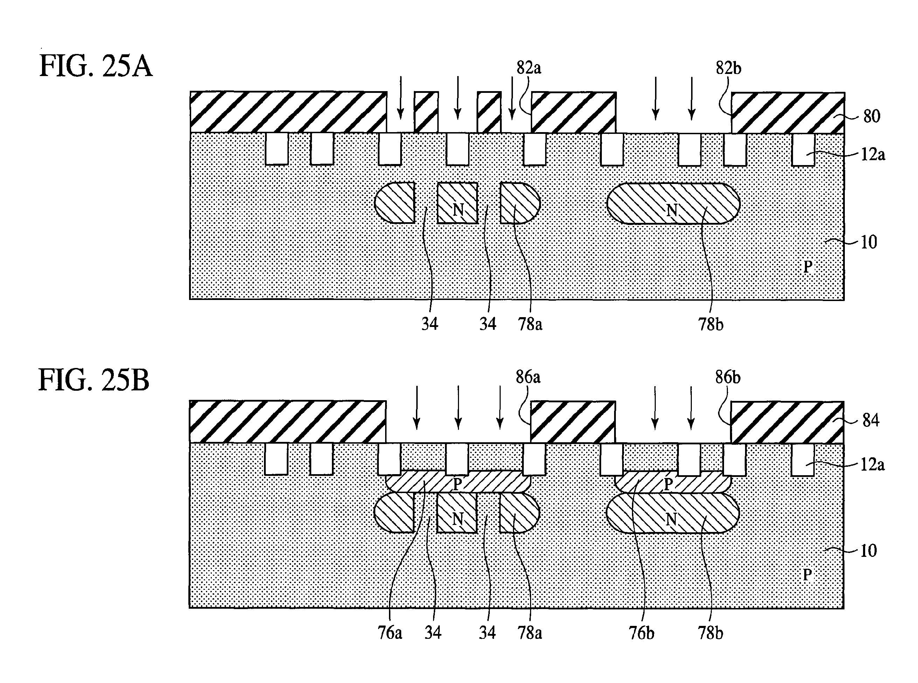

Next, the method for fabricating the semiconductor device according to the present embodiment will be explained with reference to FIGs. 25A to 27B. FIGs. 25A to 27B are sectional view of the semiconductor device according to the present embodiment in the steps of the method for fabricating the semiconductor device, which illustrate the method.

First, as illustrated in FIG. 25A, the device isolation regions 12a for defining the device regions are formed. The device isolation regions 12a can be formed by, e.g., STI. In forming the device isolation regions 12a, the device isolation regions 12a formed deeper than the upper surface of the N-type impurity layer 14c which will be formed in a later step.

Next, a photoresist film 80 is formed by, e.g., spin coating.

Next, the photoresist film 80 is patterned by photolithography. Thus, openings 82b for forming the N-type impurity layers 78a, 78b are formed in the photoresist film 80.

Then, with the photoresist film 80 as the mask, an N-type dopant impurity is implanted into the semiconductor substrate 10 by ion implantation. At this time, the ion implantation conditions are set so that the N-type dopant impurity is implanted in a deep region remote from the surface of the semiconductor substrate 10. The ion implantation conditions are as exemplified below. The dopant impurity is, e.g., phosphorus. The acceleration voltage is, e.g., 800 keV. The dose is, e.g., 1.5×10¹³ cm⁻². Thus, the N-type impurity layer 78a, 78b are formed in the deep region remote from the surface of the semiconductor substrate 10. None of the N-type dopant impurity is implanted into the regions for the P-type contact regions 34 to be formed in, whereby the P-type contact regions 34 are formed in the regions for the P-type contact regions 34 to be formed in. Then, the photoresist film 80 is released.

Next, a photoresist film 84 is formed by, e.g., spin coating.

Next, the photoresist film 84 is patterned by photolithography. Thus, an opening 86a for forming the P-type impurity layer 76a and an opening 86b for forming the P-type impurity layer 76b are formed in the photoresist film 84.

Next, with the photoresist film 84 as the mask, a P-type dopant impurity is implanted into the semiconductor substrate 10 by ion implantation. At this time, the ion implantation conditions are set so that the P-type dopant impurity is implanted into a deep region which is remote from the surface of the semiconductor substrate 10 and is shallower than the N-type impurity layers 78a, 78b. The ion implantation conditions are as exemplified below. The dopant impurity is, e.g., boron. The acceleration voltage is, e.g., 250 keV. The dose is, e.g., 2.0×10¹³ cm⁻². Thus, the P-type impurity layer 76a is formed immediately below the regions for the P-type wells 32d, 32e to be formed in. The P-type impurity layer 76b is formed immediately below the region for the N-type well 16f to be formed in and immediately below the region for the P-type well 32g to be formed in (see FIG. 25B).

Next, a photoresist film 88 is formed by, e.g., spin coating.

Next, the photoresist film 88 is patterned by photolithography. At this time, the photoresist film 88 is patterned to expose the regions for the N-type wells 16d, 16e to be formed in, the region for the P-type well 32f to be formed in and the region for the N-type well 16g to be formed in. Thus, openings 90a, 90b, 90c for implanting the N-type dopant impurity to be implanted in are formed in the photoresist film 88.

Next, with the photoresist film 88 as the mask, an N-type dopant impurity is heavily implanted into the semiconductor substrate 10 by ion implantation. At this time, the ion implantation conditions are set so that the N-type dopant impurity is implanted into a deep region remote from the surface of the semiconductor substrate 10. The ion implantation conditions are as exemplified below. The dopant impurity is, e.g., phosphorus. The acceleration voltage is, e.g., 600 keV. The dose is, e.g., 1.5×10¹³ cm⁻². Thus, the N-type impurity layer 14c is formed in the deep region remote from the surface of the semiconductor substrate 10. The P-type impurity layer 76a is connected to the P-type semiconductor substrate 10 via the P-type contact regions 34 (see FIG. 25B).

Next, a photoresist film 92 is formed by, e.g., spin coating.

Then, the photoresist film 92 is patterned by photolithography. At this time, the photoresist film 92 is patterned to expose the regions for the N-type wells 16d, 16e to be formed in, the region for the N-type well 16f to be formed in and the region for the N-type well 16g to be formed in. Thus, openings 94a - 94c for forming the N-type wells 16d - 16g to be formed in are formed in the photoresist film 92.

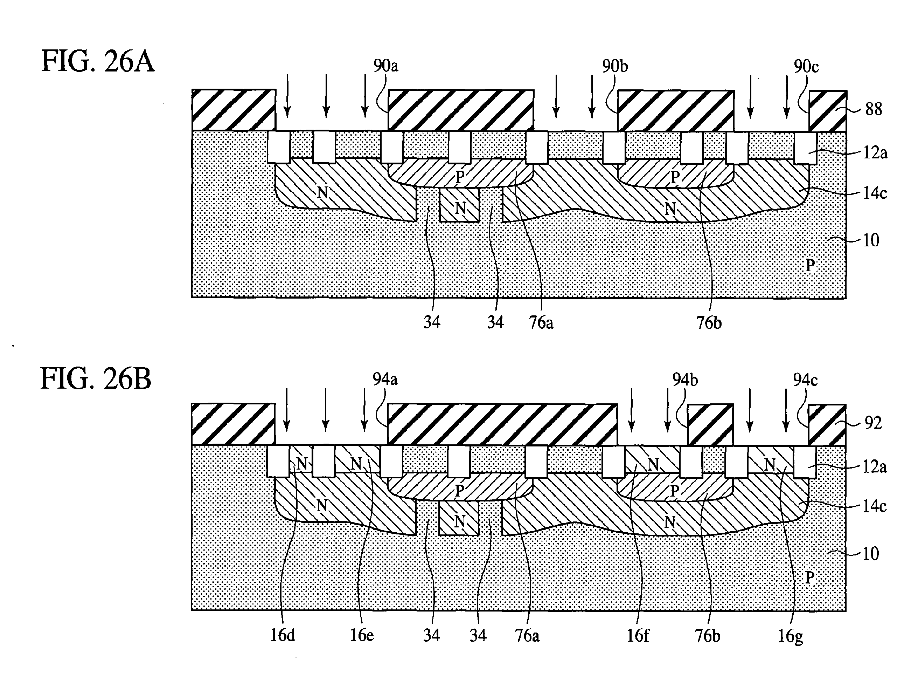

Next, with the photoresist film 92 as the mask, an N-type dopant impurity is implanted into the semiconductor substrate 10 by ion implantation. At this time, the ion implantation conditions are set so that the N-type wells 16d - 16g which are shallower than the device isolation regions 12a. The ion implantation conditions are as exemplified below. The dopant impurity is, e.g., phosphorus. The acceleration voltage is, e.g., 200 keV. The dose is, e.g., 3.0×10¹³ cm⁻². Thus, the N-type wells 16d, 16e, 16g are formed on the N-type impurity layer 14c, and the N-type well 16f is formed on the P-type impurity layer 76b (see FIG. 26B). Then, the photoresist film 92 is released.

Next, a photoresist film 96 is formed by, e.g., spin coating.

Next, a photoresist film 96 is patterned by photolithography. At this time, the photoresist film 96 is patterned to expose the regions for the P-type wells 32d - 32f to be formed in and the region for the P-type well 32g to be formed in. Thus, openings 98a, 98b for forming the P-type wells 32d - 32g are formed in the photoresist film 96.

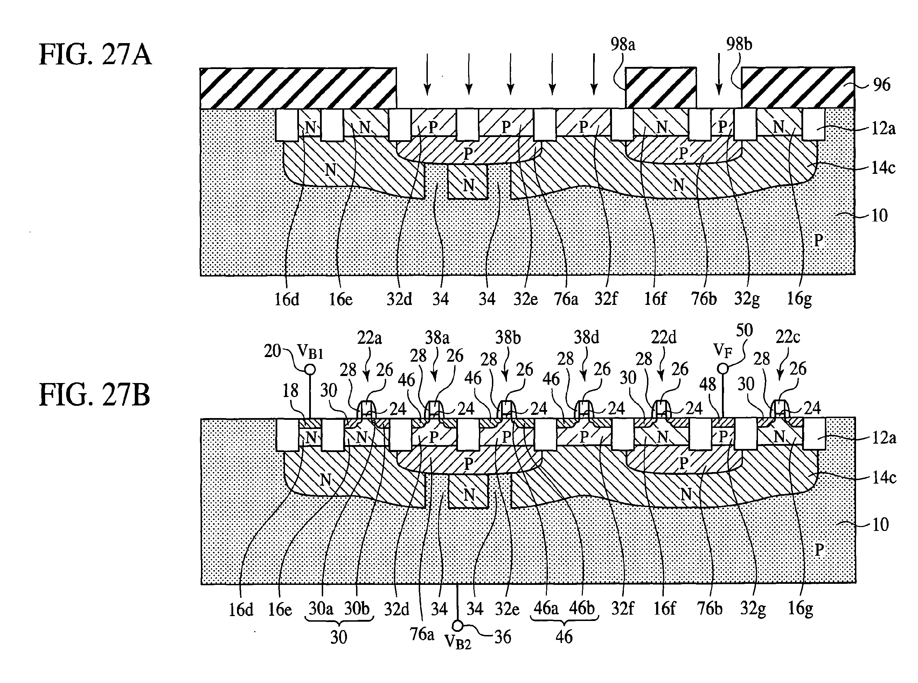

Then, with the photoresist film 96 as the mask, a P-type dopant impurity is implanted into the semiconductor substrate 10 by ion implantation. At this time, the ion implantation conditions are set so that the P-type wells 32d - 32g which are shallower than the device isolation regions 12a. The ion implantation conditions are as exemplified below. The dopant impurity is, e.g., boron. The acceleration voltage is, e.g., 80 keV. The dose is, e.g., 3.0×10¹³ cm⁻². Thus, the P-type wells 32d, 32e are formed on the P-type impurity layer 76a, and the P-type well 32f is formed on the N-type impurity layer 14c, and the P-type well 32g is formed on the P-type impurity layer 76b (see FIG. 27A). Then, the photoresist film 96 is released.

Next, the gate insulation film 24 is formed on the entire surface by, e.g., thermal oxidation.

Next, a polysilicon film 26 is formed on the entire surface by, e.g., CVD.

Next, the polysilicon film 26 is patterned by photolithography. Thus, the gate electrodes 26 of polysilicon are formed.

Next, a photoresist film (not illustrated) is formed on the entire surface by, e.g, spin coating.

Then, openings (not illustrated) for exposing the regions for the PMOS transistors 22a, 22c, 22d to be formed in are formed in the photoresist film by photolithography.

Next, with the photoresist film as the mask, a P-type dopant impurity is implanted by ion implantation. Thus, a P-type lightly diffused layer 30a is formed. Then, the photoresist film is released.

Next, a photoresist film (not illustrated) is formed on the entire surface by, e.g., spin coating.

Next, openings (not illustrated) for exposing the regions for the NMOS transistors 38a, 38b, 38d to be formed in are formed in the photoresist film by photolithography.

Next, with the photoresist film as the mask, an N-type dopant impurity is implanted by ion implantation. Thus, an N-type lightly diffused layer 46a is formed. Then, the photoresist film is released.

Next, a silicon oxide film 28 is formed on the entire surface by, e.g., CVD.

Next, the silicon oxide film 28 is anisotropically etched. Thus, the sidewall insulation film 28 of silicon oxide film is formed on tthe side walls of the gate electrodes 26.

Next, a photoresist film (not illustrated) is formed on the entire surface by, e.g., spin coating.

Next, openings (not illustrated) for exposing the regions for the PMOS transistors 22a, 22c, 22d to be formed in and the region for the P-type contact layer 48 to be formed in are formed in the photoresist film by photolithography.

Next, with the photoresist film as the mask, a P-type dopant impurity is implanted by ion implantation. Thus, the P-type heavily diffused layer 30b and the P-type contact layer 48 are formed. The P-type lightly diffused layer 30a and the P-type heavily diffused layer 30b form the source/drain diffused layer 30 of LDD structure. Then, the photoresist film is released.

Next, a photoresist film (not illustrated) is formed on the entire surface by, e.g., spin coating.

Next, openings (not illustrated) for exposing the regions for the NMOS transistors 38a, 38b, 38d to be formed in and the region for the N-type contact layer 18 to be formed in are formed in the photoresist film by photolithography.

Then, with the photoresist film as the mask, an N-type dopant impurity is implanted by ion implantation. Thus, an N-type heavily diffused layer 46b and the N-type contact layer 18 are formed. The N-type lightly diffused layer 46a and the N-type heavily diffused layer 46b form the source/drain diffused layer 46 of LDD structure. Then, the photoresist film is released.

Thus, the PMOS transistors 22a, 22d, 22c including the gate electrodes 26, the source/drain diffused layer 30 are formed respectively on the N-type wells 16e, 16f, 16g. The NMOS transistors 38a, 38b, 38d including the gate electrodes 26 and the source/drain diffused layer 46 are formed respectively on the P-type wells 32d, 32e, 32f. On the N-type well 16d, the N-type contact layer 18 is formed. On the P-type well 32g, a P-type contact layer 48 is formed.

The N-type contact layer 18 is connected to the bias input terminal 20. The backside of the semiconductor substrate 10 is connected to another bias input terminal 36. The P-type contact layer 48 is connected to further another bias input terminal 50.

Thus, the semiconductor device according to the present embodiment is fabricated (see FIG. 27B).

### [A Seventh Embodiment]

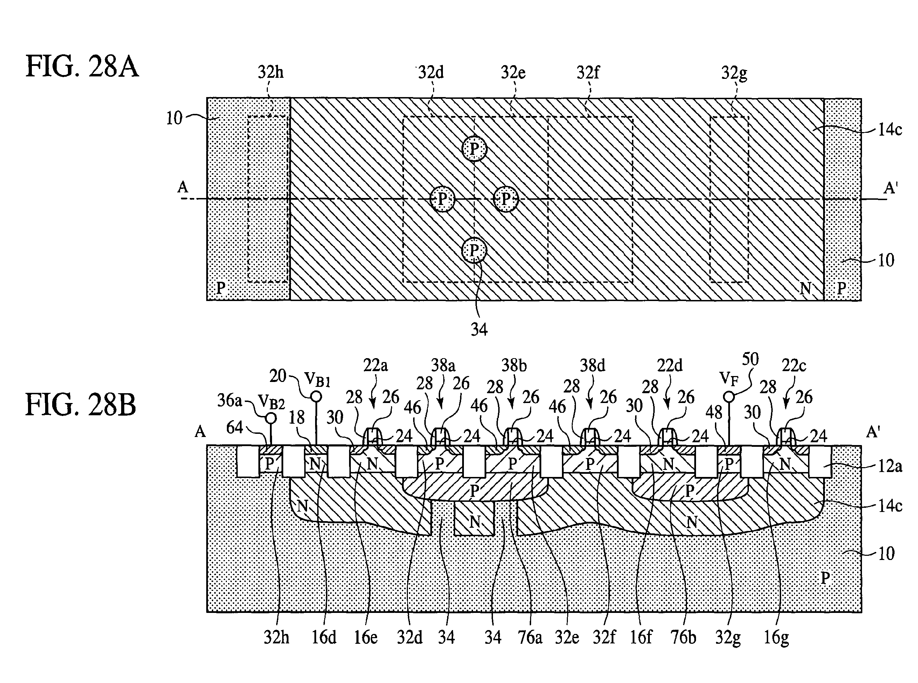

The semiconductor device according to a seventh embodiment of the present invention and the method for fabricating the semiconductor device will be explained with reference to FIGs. 28A to 31B. FIGs. 28A and 28B are a plan view and a sectional view of the semiconductor device according to the present embodiment. FIG. 28A is the plan view, and FIG. 28B is the sectional view along the line A-A' in FIG. 28A. The same members of the present embodiment as those of the semiconductor device according to the first to the sixth embodiments and the method for fabricating the semiconductor device illustrated in FIGs. 1A to 27B are represented by the same reference numbers not to repeat or to simplify their explanation.

### (The Semiconductor Device)

First, the semiconductor device according to the present embodiment will be explained with reference to FIGs. 28A and 28B. FIGs. 28A and 28B are a plan view and a sectional view of the semiconductor device according to the present embodiment. FIG. 28A is the plan view and the FIG. 28B is the sectional view along the line A-A' in FIG. 28A.

The semiconductor device according to the present embodiment is characterized mainly in that a P-type well 32h is further formed in a P-type semiconductor substrate 10, and a P-type contact layer 64 is further formed on the surface of the P-type well 32h, and the P-type semiconductor substrate 10 is connected to a bias input terminal 36a via a P-type well 32h and a P-type contact layer 64.

As illustrated in FIGs. 28A and 28B, the P-type well 32h is formed in the P-type semiconductor substrate 10 on the left side of an N-type well 16d as viewed in the drawing.

The P-type contact layer 64 is formed on the surface of the P-type well 32h. The P-type contact layer 64 is connected to a bias input terminal 36a. A bias voltage V_{B2} to be applied to the bias input terminal 36a is set suitably corresponding to operational states of the NMOS transistors. That is, a variable bias V_{B2} is applied to the bias input terminal 36a. When a bias voltage V_{B2} is applied to the bias input terminal 36a, the bias voltage V_{B2} can be applied to the P-type wells 32d, 32e via the P-type contact layer 64, the P-type well 32h, the P-type semiconductor substrate 10 and the P-type contact regions 34.

As described above, it is possible that the P-type well 32h is further formed in the P-type semiconductor substrate 10, and the P-type contact layer 64 is further formed in the surface of the P-type well 32h, whereby the P-type semiconductor substrate 10 is connected to the bias input terminal 36a via the P-type well 32h and the P-type contact layer 64. In the present embodiment as well, a bias voltage V_{B2} can be applied to the P-type wells 32d, 32e via the P-type semiconductor substrate 10 and the P-type contact regions 34.

### (The Method for Fabricating the Semiconductor Device)

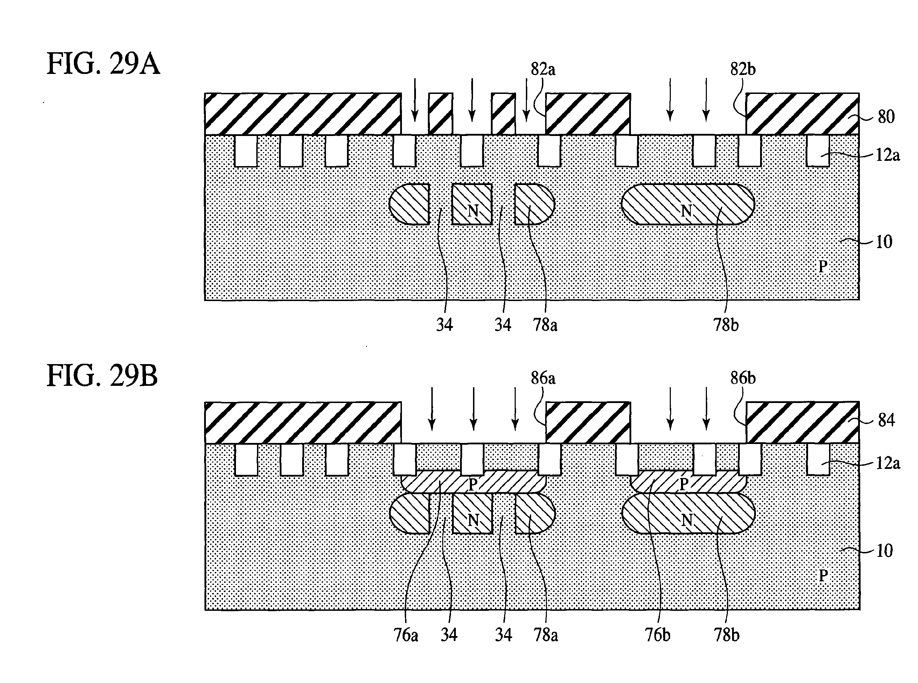

Next, the semiconductor device according to the present embodiment and the method for fabricating the semiconductor device will be explained with reference to FIGs. 29A to 31B. FIGs. 29A to 31B are sectional views of the semiconductor device according to the present embodiment in the steps of the method for fabricating the semiconductor device, which illustrate the method.

First, as illustrated in FIG. 29A, the device isolation regions 12a for defining the device regions are formed. The device isolation regions 12a can be formed by, e.g., STI.

Next, in the same way as in the semiconductor fabricating method described above with reference to FIG. 25A, the N-type impurity layers 78a, 78b are formed (see FIG. 29A).

Next, in the same way as in the semiconductor device fabricating method described above with reference to FIG. 25B, the P-type impurity layers 76a, 76b are formed (see FIG. 29B).

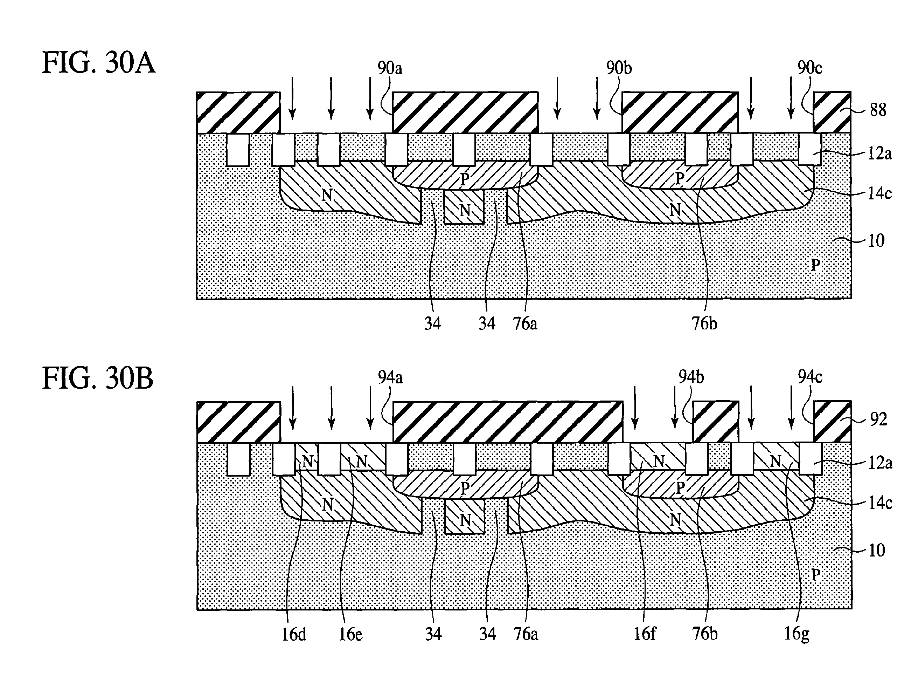

Next, in the same way as in the semiconductor fabricating method described above with reference to FIG. 26A, an N-type dopant impurity is implanted into the semiconductor substrate 10. Thus, the N-type impurity layer 14c is formed in a deep region remote from the surface of the semiconductor substrate 10 (see FIG. 30A).

Next, in the same way as in the semiconductor device fabricating method described above with reference to FIG. 26B, the N-type wells 16d - 16g are formed (see FIG. 30B).

Then, a photoresist film 96a is formed by, e.g., spin coating.

Next, the photoresist film 96a is patterned by photolithography. At this time, the photoresist film 96a is patterned to expose the regions for the P-type wells 32d - 32f to be formed in, the region for the P-type well 32g to be formed in and the region for the P-type well 32h to be formed in. Thus, openings 98a for forming the P-type wells 32d - 32f, openings 98b for forming the P-type well 32g and the opening 98c for forming the P-type well 32h are formed in the photoresist film 96a.

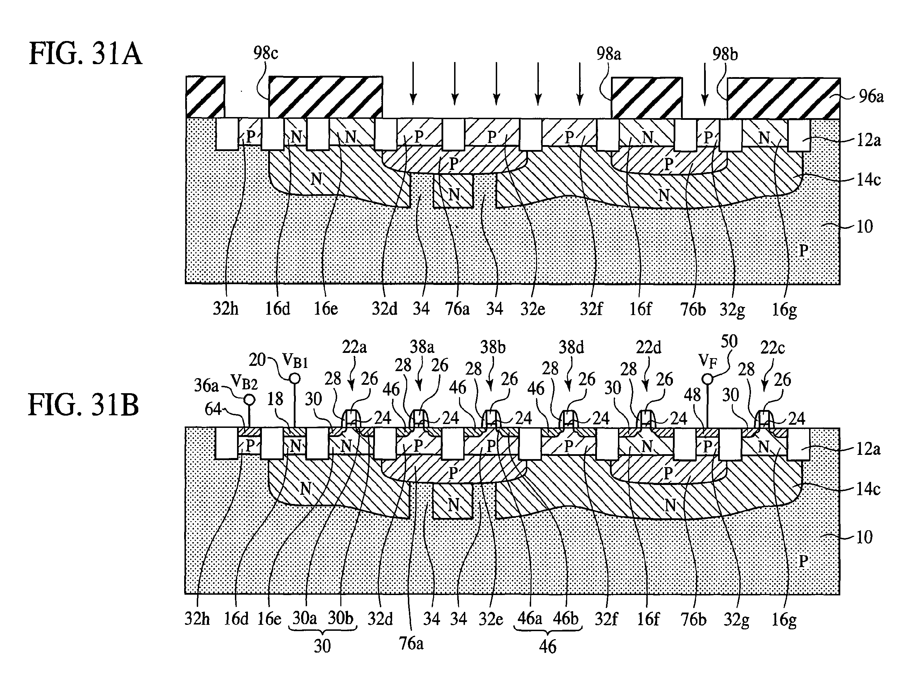

Then, with the photoresist film 96a as the mask, a P-type dopant impurity is implanted into the semiconductor substrate 10 by ion implantation. At this time, ion implantation conditions are set so that the P-type wells 32d - 32h are formed in regions which are shallower than the device isolation regions 12a. The ion implantation conditions are as exemplified below. The dopant impurity is, e.g. boron. The acceleration voltage is, e.g, 80 keV. The dose is, e.g., 3.0×10¹³ cm⁻². Thus, the P-type wells 32d, 32e are formed on the P-type impurity layer 76a, the P-type well 32f is formed on the N-type impurity layer 14c, the P-type well 32g is formed on the P-type impurity layer 76b, and the P-type well 32h is formed in the P-type semiconductor substrate 10 (see FIG. 31A). Then, the photoresist film 96a is released.

Then, the gate insulation film 24 is formed on the entire surface by, e.g., thermal oxidation.

Next, a polysilicon film 26 is formed on the entire surface by, e.g., CVD.

Next, the polysilicon film 26 is patterned by photolithography. Thus, the gate electrodes 26 of polysilicon are formed.

Next, a photoresist film (not illustrated) is formed on the entire surface by, e.g., spin coating.

Then, openings (not illustrated) for exposing the regions for the PMOS transistors 22a, 22c, 22d to be formed in are formed in the photoresist film by photolithography.

Next, with the photoresist film as the mask, a P-type dopant impurity is implanted by ion implantation. Thus, a P-type lightly diffused layer 30a is formed. Then, the photoresist film is released.

Next, a photoresist film (not illustrated) is formed on the entire surface by, e.g., spin coating.

Then, openings (not illustrated) for exposing the regions for the NMOS transistors 38a, 38b, 38d to be formed in are formed in the photoresist film by photolithography.

Next, with the photoresist film as the mask, an N-type dopant impurity is implanted by ion implantation. Thus, an N-type lightly diffused layer 46a is formed. Then, the photoresist film is released.

Next, a silicon oxide film 28 is formed on the entire surface by, e.g., CVD.

Then, the silicon oxide film 28 is anisotropically etched. Thus, the sidewall insulation film 28 of silicon oxide film is formed on the side walls of the gate electrodes 26.

Then, a photoresist film (not illustrated) is formed on the entire surface by, e.g., spin coating.

Next, openings (not illustrated) for exposing the regions for the PMOS transistors 22a, 22c, 22d to be formed in, the region for the P-type contact layer 48 to be formed in and the region for the P-type contact layer 64 to be formed are formed in the photoresist film by photolithography.

Next, with the photoresist film as the mask, a P-type dopant impurity is implanted by ion implantation. Thus, a P-type heavily diffused layer 30b, the P-type contact layer 48 and the P-type contact layer 64 are formed. The P-type lightly diffused layer 30a and the P-type heavily diffused layer 30b form a source/drain layer 30 of LDD structure. Then, the photoresist film is released.

Next, a photoresist film (not illustrated) is formed on the entire surface by, e.g., spin coating.

Then, openings (not illustrated) for exposing the regions for the NMOS transistors 38a, 38b, 38d to be formed in and the region for the N-type contact layer 18 to be formed in are formed in the photoresist film by photolithography.

Next, with the photoresist film as the mask, an N-type dopant impurity is implanted by implantation. Thus, an N-type heavily diffused layer 46b and the N-type contact layer 18 are formed. The N-type lightly diffused layer 46a and the N-type heavily diffused layer 46b form the source/drain diffused layer 46 of LDD structure. Then, the photoresist film is released.

Thus, the PMOS transistors 22a, 22d, 22c including the gate electrodes 26 and the source/drain diffused layer 30 are formed respectively on the N-type wells 16e, 16f, 16g. On the P-type wells 32d, 32e, 32f, the NMOS transistors 38a, 38b, 38d including the gate electrodes 26 and the source/drain diffused layer 46 are respectively formed. The N-type contact layer 18 is formed on the N-type well 16d. The P-type contact layer 48 is formed on the P-type well 32g. The P-type contact layer 64 is formed on the P-type well 32h.

The N-type contact layer 18 is connected to the bias input terminal 20. The P-type contact layer 64 is connected to another bias input terminal 36a. The P-type contact layer 48 is connected to further another bias input terminal 50.

Thus, the semiconductor device according to the present embodiment is fabricated (see FIG. 31B).

### [An Eighth Embodiment]

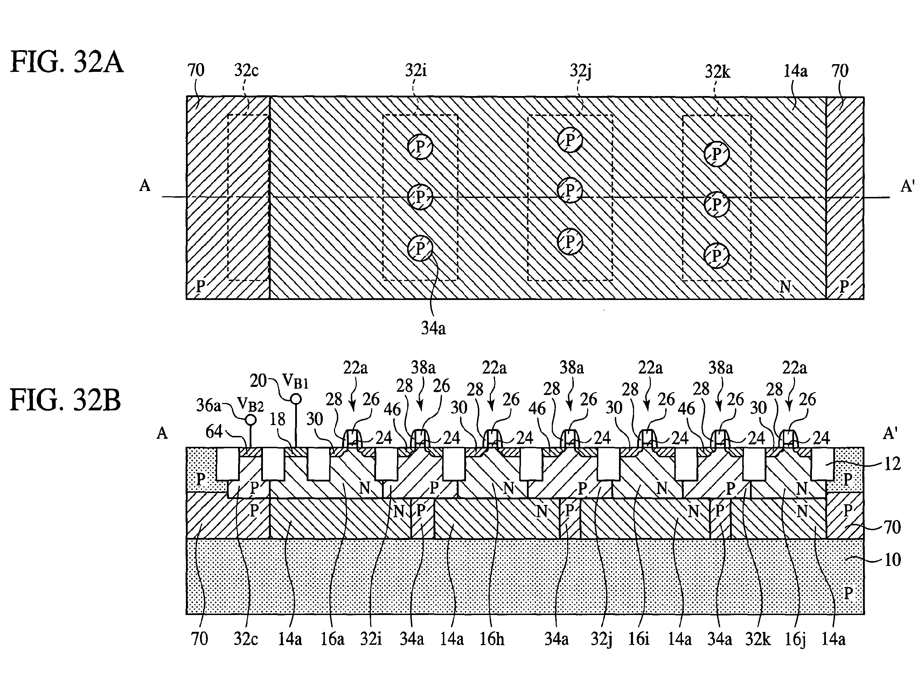

The semiconductor device according to an eighth embodiment of the present invention will be explained with reference to FIGs. 32A and 32B. FIGs. 32A and 32B are a plan view and a sectional view of the semiconductor device according to the present embodiment. FIG. 32A is the plan view, and FIG. 32B is the sectional view along the line A-A' in FIG. 32A. The same members of the present embodiment as those of the semiconductor device according to the first to the seventh embodiments and the method for fabricating the semiconductor device illustrated in FIGs. 1A to 31B are represented by the same reference numbers not to repeat or to simplify their explanation.

The semiconductor device according to the present embodiment is characterized mainly in that P-type wells 32i - 32k are patterned in strips.

As illustrated in FIGs. 32A and 32B, the P-type well 32i - 32k are formed in strips in a semiconductor substrate 10. In the P-type wells 32i - 32k, NMOS transistors 38a are respectively formed.

In the semiconductor substrate 10, N-type wells 16a, 16h - 16j are formed. In the N-type wells 16a, 16h - 16j, PMOS transistors 22a are respectively formed. On the surface of the N-type well 16a, an N-type contact layer 18 is formed. The N-type contact layer 18 is connected to a bias input terminal 20.

A P-type well 32c is formed in the semiconductor substrate 10. A P-type contact layer 64 is formed on the surface of the P-type well 32c. The P-type contact layer 64 is connected to the bias input terminal 36a.

An N-type impurity layer 14a is formed below the N-type wells 16a, 16h - 16j and below the P-type wells 32i - 32k.

P-type contact regions 34a are formed in the N-type impurity layer 14a immediately below the regions where the P-type wells 32i - 32k are formed. The P-type well 32i - 32k are connected to the P-type semiconductor substrate 10 via the P-type contact regions 34a.

In the P-type semiconductor substrate 10 outside the region where the N-type impurity layer 14a is formed, a P-type impurity layer 70 is formed. The P-type well 32c is connected to the P-type semiconductor substrate 10 via the P-type impurity layer 70.

The P-type contact regions 34a and the P-type impurity layer 70 are formed by implanting a P-type dopant impurity in the entire surface of the P-type semiconductor substrate 10 and implanting an N-type dopant impurity in the region except the regions for the P-type contact regions 34a to be formed in and the region for the P-type impurity layer 70 to be formed in. The impurity concentration in the P-type contact regions 34a and the impurity concentration in the P-type impurity layer 70 are higher than the impurity concentration in the P-type semiconductor substrate 10.

The P-type impurity layer 70 is formed immediately below the P-type well 32c, and the P-type contact regions 34a are formed respectively immediately below the P-type wells 32i - 32k, whereby a bias voltage V_{B2} can be applied to the P-type wells 32i - 32k via the P-type contact layer 64, the P-type well 32c, the P-type impurity layer 70, the P-type semiconductor substrate 10 and the P-type contact regions 34a.

The N-type wells 16a, 16h - 16j are connected to each other by the N-type impurity layer 14a, and the N-type impurity layer 14a is connected to the bias input terminal 20 via the N-type well 16a and the N-type contact layer 18, whereby a bias voltage V_{B1} can be applied at once to the N-type wells 16a, 16h - 16j.

As in the present embodiment, the P-type wells 32i - 32k may be patterned in strips.

### [A Ninth Embodiment]

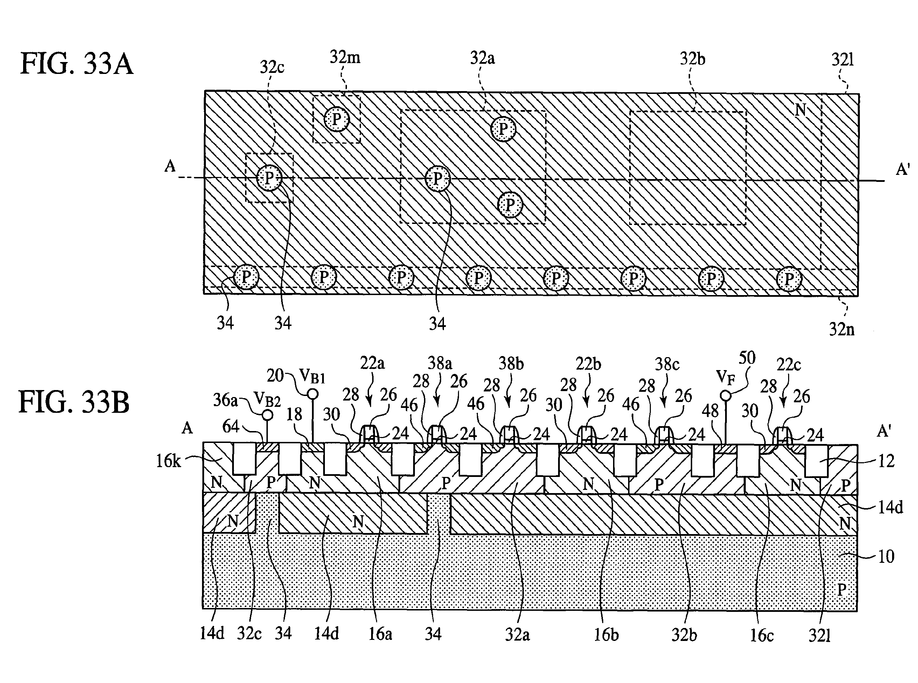

The semiconductor device according to a ninth embodiment of the present invention will be explained with reference to FIGs. 33A and 33B. FIGs. 33A and 33B are a plan view and a sectional view of the semiconductor device according to the present embodiment. FIG. 33A is the plan view, and the FIG. 33B is the sectional view along the line A-A' in FIG. 33A. The same members of the present embodiment as those of the semiconductor device according to the first to the eighth embodiment illustrated in FIGs. 1A to 32B are represented by the same reference numbers not to repeat or to simplify their explanation.

The semiconductor device according to the present embodiment is characterized mainly in that the patterns of the P-type wells 32a - 32c, 321 - 32n are suitably set in the configuration, size, etc.

As illustrated in FIGs. 33A and 33B, P-type wells 32a, 32b, 321 - 32n are formed in the semiconductor substrate 10. The P-type well 321 is formed in a strip. The area of the P-type well 32m is set small. The P-type well 32n is formed linear. In the respective P-type wells 32a, 32b, 32m, 32n, NMOS transistors 38a - 38c are formed.

N-type wells 16a - 16c, 16k are formed in the semiconductor substrate 10. In the respective N-type wells 16a - 16c, 16k, PMOS transistors 22a - 22c are formed. An N-type contact layer 18 is formed on the surface of the N-type well 16a. The N-type contact layer 18 is connected to a bias input terminal 20.

A P-type well 32c is formed in the semiconductor substrate 10. A P-type contact layer 64 is formed on the surface of P-type well 32c. The P-type contact layer 64 is connected to a bias input terminal 36a.

An N-type impurity layer 14d is formed below the N-type wells 16a - 16c and below the P-type wells 32a - 32c, 321.

P-type contact regions 34 are formed in the N-type impurity layer 14d immediately below the regions where the P-type wells 32a, 32c, 32m, 32n are formed. The P-type contact regions 34 are formed by locally implanting none of an N-type dopant impurity when the N-type dopant impurity is implanted into the semiconductor substrate 10 to form the N-type impurity layer 14. Accordingly, the impurity concentration in the P-type contact regions 34 and the impurity concentration in the semiconductor substrate 10 are equal to each other. The P-type wells 32a, 32c, 32m, 32n are connected to the P-type semiconductor substrate 10 via the P-type contact regions 34.

The P-type wells 32a, 32c, 32m, 32n are connected to each other via the P-type contact regions 34 and the P-type semiconductor substrate 10, and the P-type well 32c is connected to the bias input terminal 36a via the P-type contact layer 64, whereby a bias voltage V_{B2} can be applied to the P-type wells 32a, 32m, 32n via the P-type contact layer 64, the P-type well 32c, the P-type contact regions 34, the P-type semiconductor substrate 10 and the P-type contact regions 34.

The N-type wells 16a - 16c, 16k are connected to each other by the N-type impurity layer 14c, and the N-type impurity layer 14c is connected to the bias input terminal 20 via the N-type well 16a and N-type contact layer 18, whereby a bias voltage V_{B1} can be applied at once to the N-type wells 16a - 16c, 16k.

As in the present embodiment, the patterns of the P-type wells 32a - 32c, 321 - 32n may be suitably set in the configuration, size, etc.

### [A Tenth Embodiment]

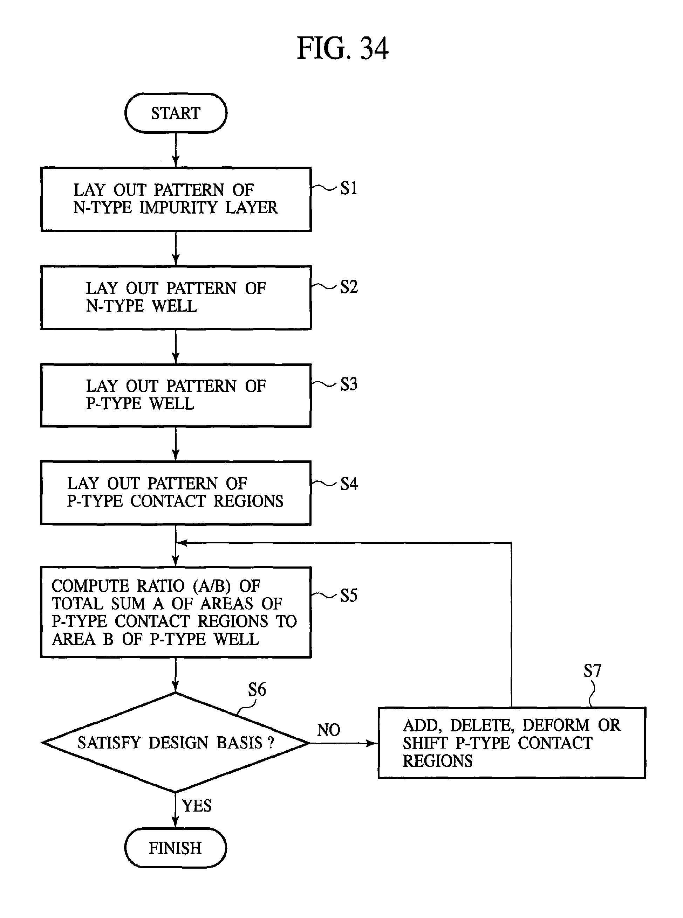

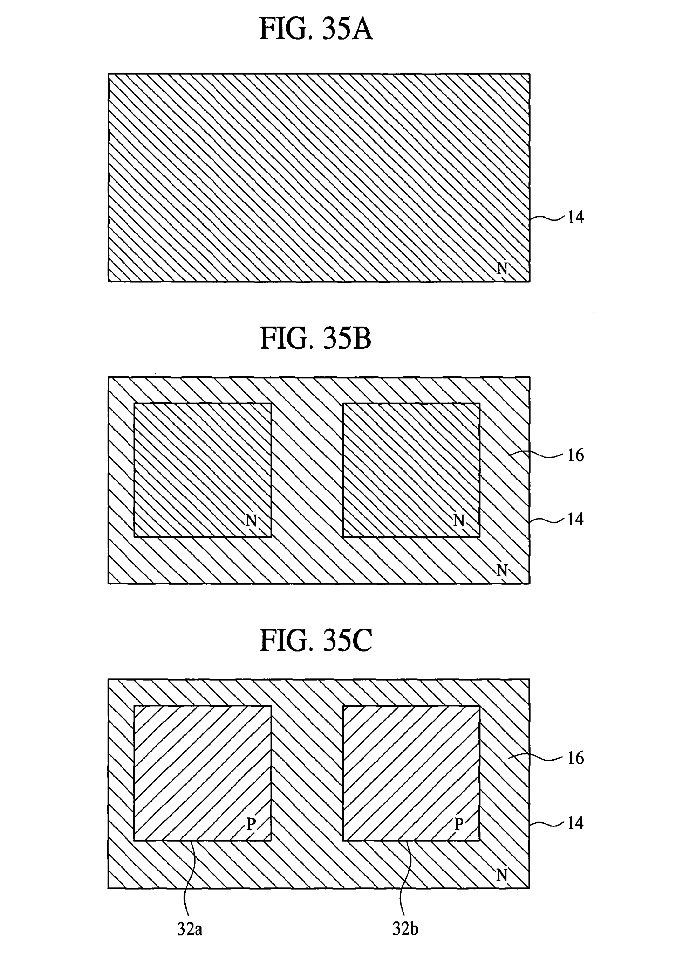

The semiconductor device design method according to a tenth embodiment of the present invention, a computer program for a computer executing the design method will be explained with reference to FIGs. 34 to 41C. FIG. 34 is the flow chart of the semiconductor device design method according to the present embodiment. More specifically, FIG. 34 shows the algorithm of the computer program executed by the semiconductor device design method according to the present embodiment. FIG. 35A to 41C are plane views of the semiconductor device design method according to the present embodiment. The same members of the present embodiment as those of the semiconductor device according to the first to the ninth embodiments and the method for fabricating the semiconductor device illustrated in FIGs. 1A to 9B are represented by the same reference numbers not to repeat or to simplify their explanation.

The semiconductor device design method according to the present embodiment is applicable not only to designing the semiconductor device according to any one of embodiments 1 to 9, but also to design any other semiconductor.

The semiconductor device design method according to the present embodiment can be executed, e.g., by a semiconductor design system (CAD: computer-aided design) with the computer program for executing the semiconductor design method according to the present embodiment installed in. Such computer program may be provided by a recording medium, e.g., CD-ROM, etc. Such computer program may be installed in advance in a semiconductor design system.

First, as illustrated in FIGs. 34 and 35A, a pattern of the N-type impurity layer 14 to be buried in the P-type semiconductor substrate 10 is laid out (Step S1).

Next, as illustrated in FIG. 35B, patterns of the N-type wells 16 to be formed on the N-type impurity layer 14 are laid out (Step S2).

Next, as illustrated in FIG. 35C, patterns of the P-type wells 32a, 32b to be formed on the N-type impurity layer 14 are laid out (Step S3).

After the patterns of the N-type wells 16 have been laid out, the patterns of the P-type wells 32a, 32b are laid out here. The patterns of the N-type wells 16 may be laid out after the patterns of the P-type wells 32a, 32b have been laid out.

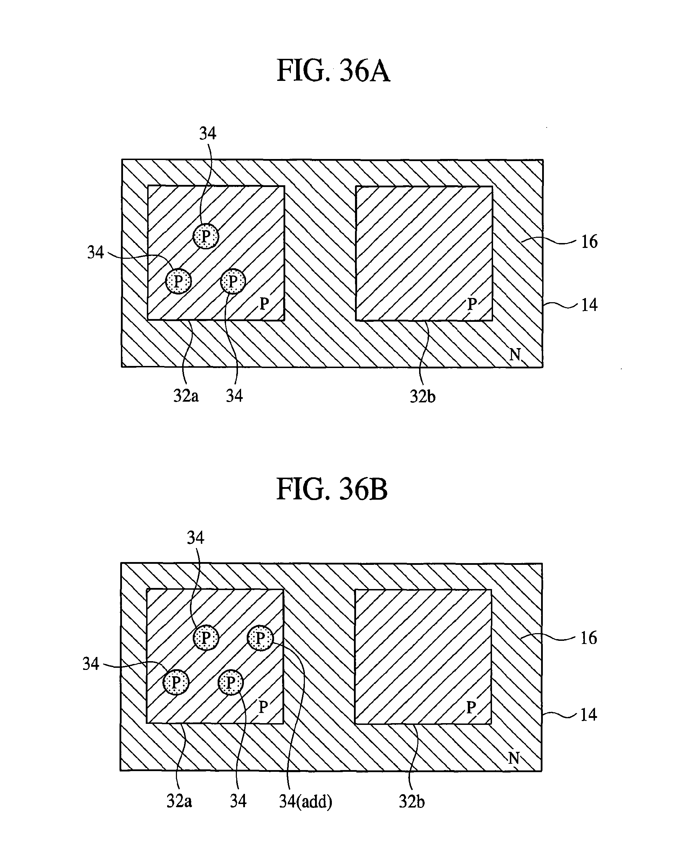

Next, as illustrated in FIG. 36A, patterns of P-type contact regions 34 are laid out (Step S4). At this time, the patterns of the P-type contact regions 34 are laid out so that the P-type contact regions 34 are formed selectively in the N-type impurity layer 14 immediately below the P-type well 32a. The P-type contact regions 34 are not formed in the N-type impurity layer 14 immediately below the P-type well 32b. The P-type well 32b must be electrically isolated from the P-type semiconductor substrate 10.

Next, a total sum A of the areas of the P-type contact regions 34 in the region where the P-type well 32a are to be formed is computed. Then, a ratio (A/B) (a prescribed parameter) of the total sum A of the areas of the P-type contact regions 34 to an area B of the P-type well 32a is computed (Step S5). Thus, the computation for the prescribed parameter is made.

Next, it is judged whether the ratio (A/B) of the total sum A of the areas of the P-type contact regions 34 to the area B of the P-type well 32a is within a prescribed range, i.e., whether or not the ratio (A/B) satisfies a prescribed design basis (Step S6).

When the ratio (A/B) of the total sum A of the areas of the P-type contact regions 34 to the area B of the P-type well 32a is too small, i.e., the ratio (A/B) is small than a lower limit of the prescribed design basis, the electric resistance between the P-type well 32a and the P-type semiconductor substrate 10 becomes too higher, and it is difficult to apply a prescribed bias voltage V_{B2} to the P-type well 32a.

On the other hand, when the ratio (A/B) of the total sum of the areas of the P-type contact regions 34 to the area B of the P-type well 32a is too large, i.e., the ratio (A/B) is larger than a upper limit of the prescribed design basis, the intra-plane electric resistance of the N-type impurity layer 14 becomes too high, and it is difficult to apply a prescribed bias voltage V_{B1} to the N-type well 16.

Thus, in forming the P-type contact regions 34, it is necessary that the ratio (A/B) of the total sum A of the areas of the contact regions 34 to the area B of the P-type well 32a satisfies the prescribed design basis.

When the ratio (A/B) of the total sum of the P-type contact regions 34 to the area B of the P-type well 32a satisfies the prescribed design basis, the step laying out the patterns of the P-type contact regions 34 is completed.

On the other hand, when the ratio (A/B) of the total sum of the areas of the P-type contact regions 34 to the area B of the P-type well 32a does not satisfy the prescribed design basis, the addition, decrease, deformation, shift, etc. of the P-type contact regions 34 are made (Step S7).

When the ratio (A/B) of the total sum of the areas of the P-type contact regions 34 to the area B of the P-type well 32a is smaller than the lower limit of the prescribed design basis, the P-type contact regions 34 are increased in the number as illustrated in FIGs. 36A and 36B. FIG. 36A illustrates the P-type contact regions 34 before added, and FIG. 36B illustrates the P-type contact regions 34 after added. The P-type contact region 34_{(add)} of FIG. 36B is an added P-type contact region. The increased number of the P-type contact regions 34 can increase the ratio (A/B) of the total sum A of the areas of the P-type contact regions 34 to the area B of the P-type well 32a.

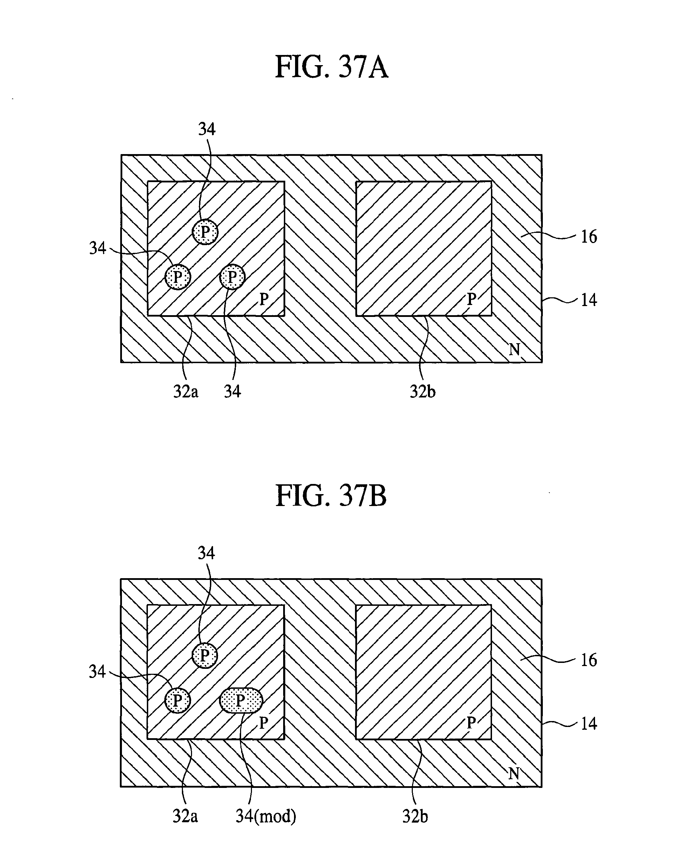

As illustrated in FIGs. 37A and 37B, the P-type contact regions 34 may be deformed. FIG. 37A illustrates the P-type contact regions before deformed, and FIG. 37B illustrates the P-type contact regions after deformed. The P-type contact region 34_{(mod)} illustrated in FIG. 37A indicates the deformed P-type contact region. The P-type contact region 34 is deformed to have the area increased, whereby the ratio (A/B) of the total sum A of the areas of the P-type contact regions 34 to the area B of the P-type well 32a can be increased.

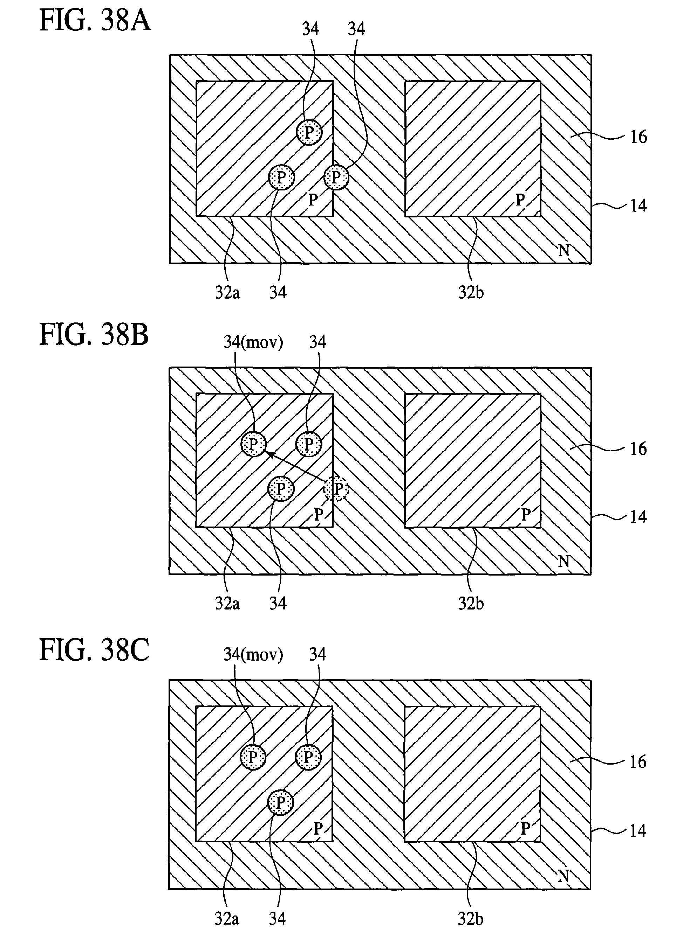

As illustrated in FIGs. 38A to 38B, the P-type contact regions 34 may be shifted. FIG. 38A illustrates the P-type contact regions before shifted, FIG. 38B illustrates the P-type contact regions is shifted, and FIG. 38C illustrates the P-type contact regions after shifted. The P-type contact region 34₍ₘₒᵥ₎ in FIGs. 38B and 38C indicates the shifted P-type contact regions. For example, as illustrated in FIG. 38A, when a part of the P-type contact region 34 is outside of the region where the P-type wells 32a are formed, such P-type contact region 34 is shifted to the inside of the region where the P-type wells 32a are formed (see FIG. 38B). The contact region 34 is shifted, whereby the ratio (A/B) of the total sum A of the areas of the contact regions 34 to the area B of the P-type well 32a can be increased (see FIG. 38C).

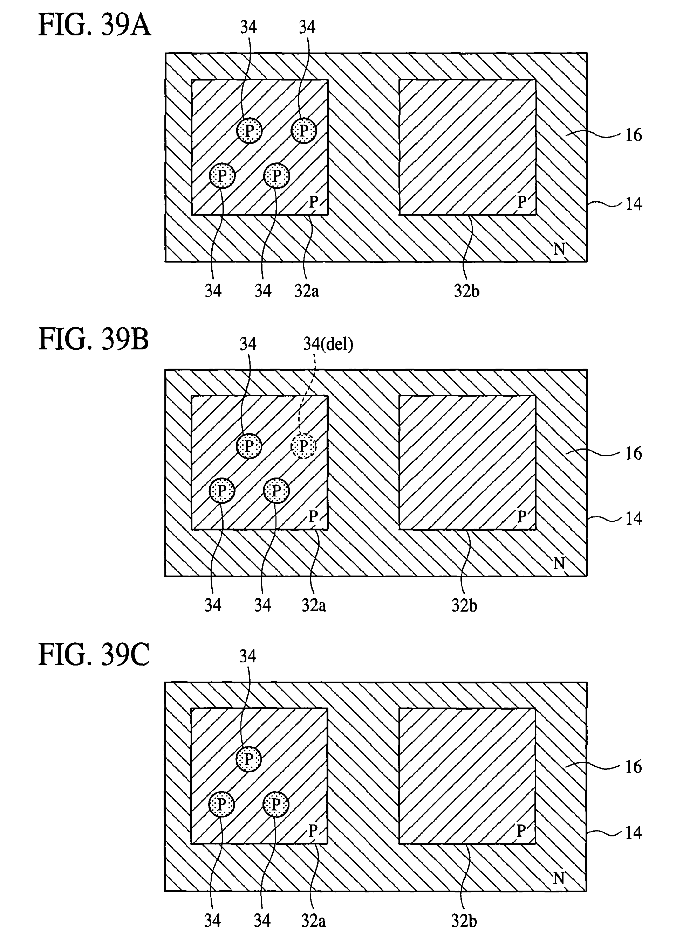

On the other hand, when the ratio (A/B) of the total sum of the areas of the contact regions 34 to the area B of the P-type well 32a is larger than the upper limit of the prescribed design basis, the number of the contact regions to be formed in the region where the P-type well 32a is to be formed is decreased as illustrated in FIGs. 39A to 39C. FIG. 39A illustrates the P-type contact regions before decreased in the number, FIG. 39B illustrates the P-type contact regions when the P-type contact regions are decreased in the number, and FIG. 39C illustrates the P-type contact regions after decreased in the number. The P-type contact region 34_{(del)} in FIG. 39B indicates the P-type contact region to be deleted. Thus, the decreased number of the P-type contact regions 34 can decrease the ratio (A/B) of the total sum A of the areas of the contact regions 34 to the area B of the P-type well 32a.

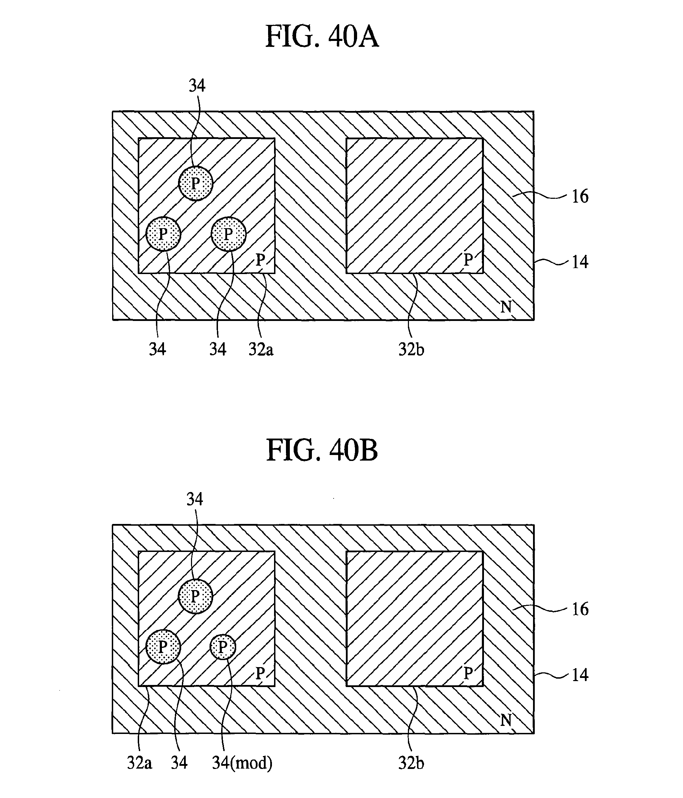

As illustrated in FIGs. 40A and 40B, the P-type contact regions 34 may be deformed. FIG. 40A illustrates the P-type contact regions before deformed, FIG. 40B illustrates the P-type contact regions after deformed. The P-type contact region 34_{(mod)} in FIG. 40B indicates the deformed P-type contact region. Thus, the contact region 34 is deformed to decrease the area thereof, whereby the ratio (A/B) of the total sum A of the areas of the contact regions 34 to the area B of the P-type well 32a can be also decreased.

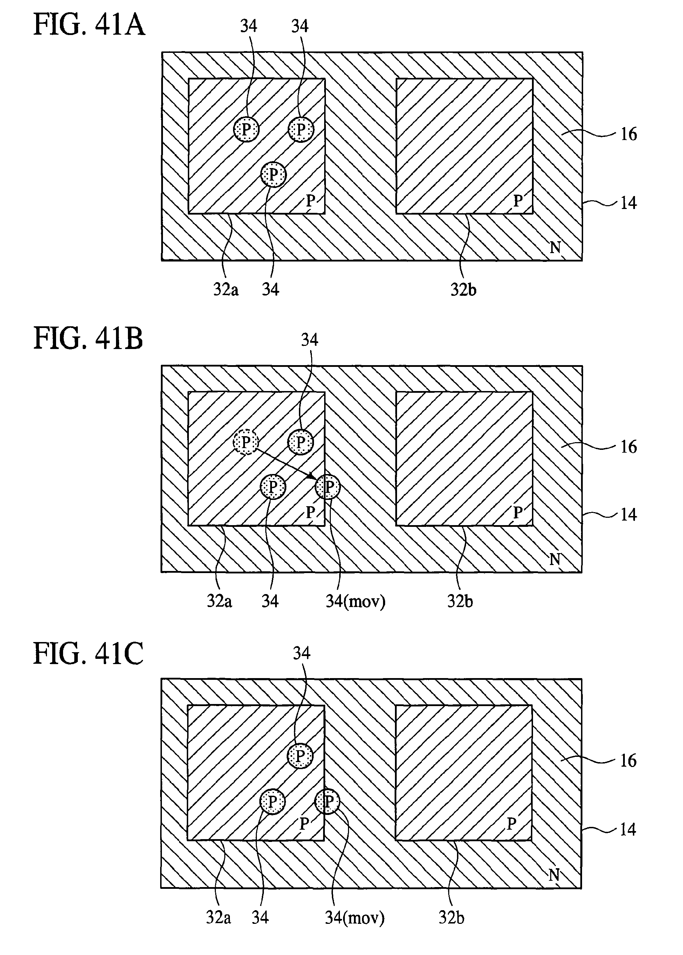

As illustrated in FIGs. 41A to 41C, the contact region 34 may be shifted. FIG. 41A illustrates the P-type contact regions before shifted, FIG. 41B illustrates the P-type contact regions when the P-type contact region is shifted, and FIG. 41C illustrates the P-type contact regions after shifted. The P-type contact regions 34₍ₘₒᵥ₎ in FIG. 41B and 41C indicate the shifted P-type contact region. For example, a part of the P-type contact region 34 to be formed in the region where the P-type contact well 32a may be shifted to be outside the region where the P-type well 32a is to be formed (see FIGs. 41B and 41C). The P-type contact region 34 is shifted to be partially outside the region where the P-type well 32a is to be formed, whereby the ratio (A/B) of the total sum A of the areas of the contact regions 34 to the area B of the P-type well 32a can be decreased.

After the addition, decrease, deformation, shift or others of the P-type contact regions 34 (Step S7) has been made, a total sum A of areas of the contact regions 34 in the region where the P-type well 32a is to be formed is again computed in the same way as described above. Then, in the same way as described above, the ratio (A/B) of the total sum A of the areas of the contact regions 34 to the area B of the P-type well 32a is computed (Step S5).

Next, in the same way as described above, it is judged whether or not the ratio (A/B) of the total sum A of the areas of the P-type contact regions 34 to the area B of the P-type well 32a is the prescribed range, i.e., satisfies the prescribed design basis (Step S6).

Unless the ratio (A/B) of the total sum A of the areas of the P-type contact regions 34 to the area B of the P-type well 32a satisfies the prescribed design basis, the addition, decrease, deformation, shift or others of the P-type contact regions 34 (Step S7) is further made.

On the other hand, when the ratio (A/B) of the total sum A of the areas of the P-type contact regions 34 to the area B of the P-type well 32a has come to satisfy the prescribed design basis, the step of laying out the P-type contact regions 34 is completed.

As described above, according to the present embodiment, a prescribed parameter (A/B) is computed based on a pattern of the P-type well 32a, patterns of the contact regions 34, etc., it is judged whether or not the prescribed parameter satisfies a prescribed design basis, and unless the prescribed parameter satisfies the prescribed design basis, the addition, decrease, deformation, shift or others of the P-type contact regions 34 is made so that the prescribed parameter satisfies the prescribe design basis, which facilitates designing the semiconductor device.

### (Modification)

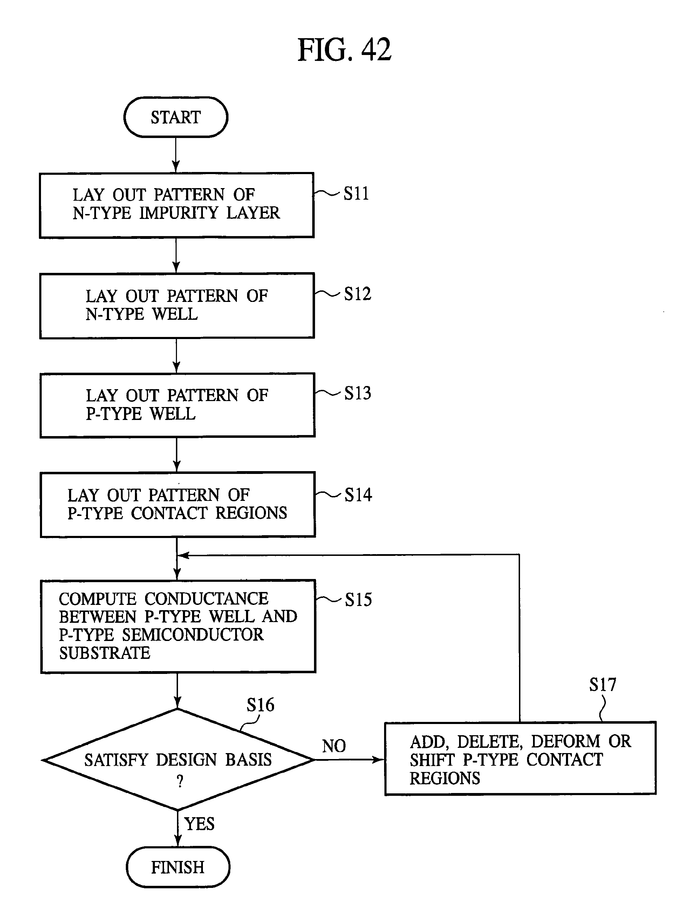

Next, a modification of the semiconductor device design method according to the present embodiment and a modification of the computer program for a computer executing the design method will be explained with reference to FIGs. 35A to 42. FIG. 42 shows the flow chart of the semiconductor device design method according to the present modification. More specifically, FIG. 42 shows the algorithm of the computer program for executing the semiconductor device design method according to the present embodiment.

First, as illustrated in FIGs . 42 and 35A, a pattern of the N-type impurity layer 14 to be buried in the P-type semiconductor substrate 10 is laid out (Step S11). Step S11 is the same as described above with reference to FIG. 34.

Next, as illustrated in FIG. 35B, patterns of the N-type wells 16 to be formed on the N-type impurity layer 14 are laid out (Step S12). Step S12 is the same as Step S2 described above with reference to FIG. 34.

Next, as illustrated in FIG. 35C, the patterns of the P-type wells 32a, 32b to be formed on the N-type impurity layer 14 are laid out (Step S13). Step S13 is the same as Step S3 described above with reference to FIG. 34.

After the pattern of the N-type well 16 has been laid out, the patterns of the P-type wells 32a, 32b are laid out here, but after the patterns of the P-type wells 32a, 32b have been laid out, the pattern of the N-type well 16 may be laid out.

Next, as illustrated in FIG. 36A, the patterns of the P-type contact regions 34 are laid out (Step S14). Step S14 is the same as Step S4 described above with reference to FIG. 34.

Next, the conductance (a prescribed parameter) between the P-type well 32a and the semiconductor substrate 10 is computed (Step S15). Thus, the computation is made for the prescribed parameter.

Next, it is judged whether or not the conductance between the P-type well 32a and the semiconductor substrate 10 is within a prescribed range, i.e., satisfies a prescribed design basis (Step S16).

When the conductance between the P-type well 32a and the semiconductor substrate 10 is too small, i.e., the conductance between the P-type well 32a and the semiconductor substrate 10 is below the lower limit of the prescribed design basis, the electric resistance between the P-type well 32a and the P-type semiconductor substrate 10 becomes too high, as is when the ratio (A/B) of a total sum A of areas of the P-type contact regions 34 to an area B of the P-type well 32a is too small, and it is difficult to apply a required bias voltage V_{B2} to the P-type well 32a.

On the other hand, when the conductance between the P-type well 32a and the semiconductor substrate 10 is too large, i.e., when the conductance between the P-type well 32a and the semiconductor substrate 10 is larger than the upper limit of the prescribed design basis, the inter-plane electric resistance of the N-type impurity layer 14 becomes too high, as is in when the ratio (A/B) of the total sum A of the areas of the P-type contact regions 34 to the area B of the P-type well 32a is too large, and there is a risk that a required bias voltage V_{B1} could not be applied to the N-type well 16.

Thus, in forming the P-type contact regions 34, it is necessary that the conductance between the P-type well 32a and the semiconductor substrate 10 satisfies the prescribed design basis.

When the conductance between the P-type well 32a and the semiconductor substrate 10 satisfies the prescribed design basis, the step of laying out the patterns of the P-type contact regions 34 is completed.

On the other hand, unless the conductance between the P-type well 32a and the semiconductor substrate 10 satisfies the prescribed design basis, the addition, increase, deformation, shift or others of the P-type contact regions 34 is made (Step S17).

When the conductance between the P-type well 32a and the semiconductor substrate 10 is smaller than the lower limit of the prescribed design basis, the P-type contact regions 34 are increased in the number as illustrated in FIGs. 36A and 36B. The increased number of the P-type contact regions 34 can increase the conductance between the P-type well 32a and the semiconductor substrate 10.

As illustrated in FIGs. 37A and 37B, the contact region 34 may be deformed. The P-type contact region 34 is deformed to increase the area, whereby the conductance between the P-type well 32a and the semiconductor substrate 10 can be increased.

As illustrated in FIGs. 38A to 38C, the P-type contact region 34 may be shifted. The contact region 34 is shifted, whereby the conductance between the P-type well 32a and the semiconductor substrate 10 can be also increased.

On the other hand, when the conductance between the P-type well 32a and the semiconductor substrate 10 is larger than the upper limit of the design basis, the number of the contact regions 34 in the region where the P-type well 32a is to be formed is decreased as illustrated in FIGs. 39A to 39C. The decreased number of the P-type contact regions 34 can decrease the conductance between the P-type well 32a and the semiconductor substrate 10.

As illustrated in FIGs. 40A and 40B, the P-type contact region 34 may be deformed. The contact region 34 is deformed so that the area of the contact region 34 is decreased, whereby the conductance between the P-type well 32a and the semiconductor device 10 can be also decreased.

As illustrated in FIGs. 41A to 41C, the contact region 34 may be shifted. The P-type contact region 34 is shifted so that a part thereof is outside the region where the P-type well 32a is to be formed, whereby the conductance between the P-type well 32a and the semiconductor substrate 10 can be decreased.

After the addition, decrease, deformation, shift or others of the P-type contact regions 34 (Step S17) has been made, a conductance between the P-type well 32a and the semiconductor substrate 10 is again computed in the same way as described above (Step S15).

Then, in the same way as described above, it is judged whether or not the conductance between the P-type well 32a and the semiconductor substrate 10 is in the prescribed range, i.e., satisfies the prescribed design basis (Step S16).

Unless the conductance between the P-type well 32a and the semiconductor substrate 10 satisfies the prescribed design basis, the addition, decrease, deformation, shift or others of the P-type contact regions 34 is further made (Step S17).

On the other hand, when the conductance between the P-type well 32a and the semiconductor substrate 10 has come to satisfy the prescribed design basis, the step of laying out the patterns of the P-type contact regions 34 is completed.

As described above, according to the present modification, a prescribed parameter (conductance) is computed based on a pattern of the P-type well 32a, patterns of the contact regions 34, etc., it is judged whether or not the prescribed parameter satisfies a prescribed design basis, and unless the prescribed parameter satisfies the prescribed design basis, the addition, decrease, deformation, shift or others of the P-type contact regions 34 is made so that the prescribed parameter satisfies the prescribe design basis. The present modification can also facilitate designing the semiconductor device.

### [An Eleventh Embodiment]

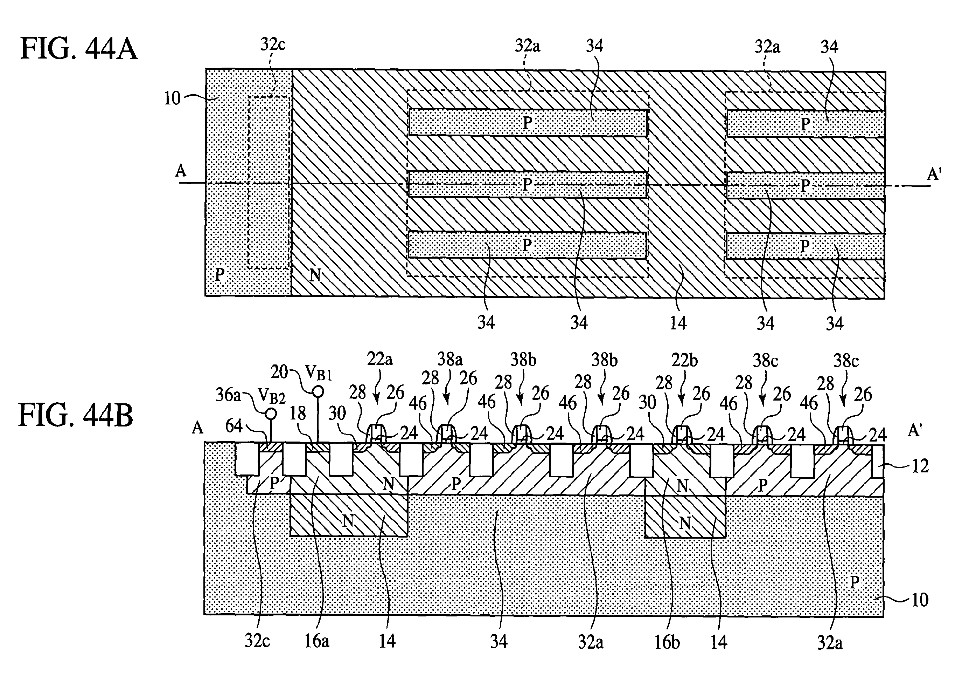

The semiconductor device according to an eleventh embodiment of the present invention will be explained with reference to FIGs. 44A and 44B. FIGs. 44A and 44B are a plan view and a sectional view of the semiconductor device according to the present embodiment. FIG. 44A is the plan view, and FIG. 44B is the sectional view along the line A-A' in FIG 44A. The same members of the present embodiment according to the first to the tenth embodiments and the method for fabricating the semiconductor device illustrated in FIGs. 1A to 43B are represented by the same reference numbers not to repeat or to simplify their explanation.

The semiconductor device according to the present embodiment is characterized mainly in that the total sum of the areas of P-type contact regions 34 immediately below a P-type well 32a is set smaller than the area immediately below the P-type well 32a except the P-type contact regions 34.

As illustrated in FIGs. 44A and 44B, the P-type contact regions 34 are formed selectively in an N-type impurity layer 14 immediately below the P-type well 32a. The plane shape of the P-type contact regions 34 is rectangular.

The N-type impurity layer 14 is formed not only immediately below the P-type well 32a but also immediately below an N-type well 16b. The N-type impurity layer 14 immediately below the P-type well 32a and the N-type impurity layer 14 immediately below the N-type well 16b are formed integral with each other.

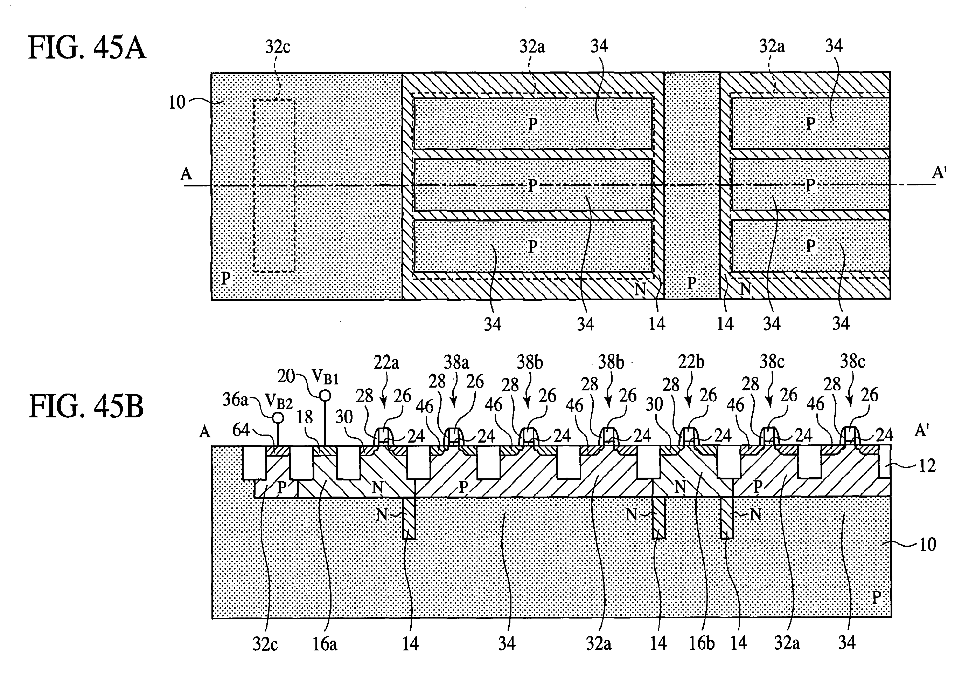

FIGs. 45A and 45B are a plan view and a sectional view of the semiconductor device according to Control 1. FIG. 45A is a plan view, and FIG. 45B is the sectional view along the line A-A' in FIG. 45A. In the semiconductor device according to Control 1 illustrated in FIGs. 45A and 45B, the total sum of the areas of the P-type contact regions 34 immediately below the P-type well 32a is much larger than the area immediately below the P-type well 32a except the P-type contact regions 34, whereby the intra-plane electric resistance of the N-type impurity layer 14 immediately below the P-type well 32a is very high. The N-type well 16b and the N-type impurity layer 14 are connected to each other only at the edge of the N-type well 16b, which makes the electric resistance of the N-type impurity layer 14, etc. in the region near the N-type well 16b very high. Accordingly, in the semiconductor device according to Control 1 illustrated in FIGs. 45A and 45B, a large difference is caused between the bias voltage to be applied to the N-type well 16a directly connected to the bias input terminal 20 and the bias voltage to be applied to the N-type well 16b positioned relatively remote from the bias input terminal 20.

In contrast to this, in the present embodiment, the total sum of the areas of the P-type contact regions 34 immediately below the P-type well 32a is set smaller than the area immediately below the P-type well 32a except the P-type contact regions 34, which permits the intra-plane electric resistance of the N-type impurity layer 14 immediately below the P-type well 32a to be set low. Besides, the N-type impurity layer 14 is formed not only immediately below the P-type well 32a but also immediately below the N-type well 16b, and the N-type impurity layer 14 immediately below the P-type well 32a and the N-type impurity layer 14 immediately below the N-type well 16b are formed integral with each other. Thus, according to the present embodiment, the intra-plane electric resistance of the N-type impurity layer 14 can be depressed relatively low. Thus, according to the present embodiment, a required bias voltage can be applied to the N-type well 16a and the P-type well 32a, and a required voltage can be surely applied also to the N-type well 16b.

### (Modification 1)

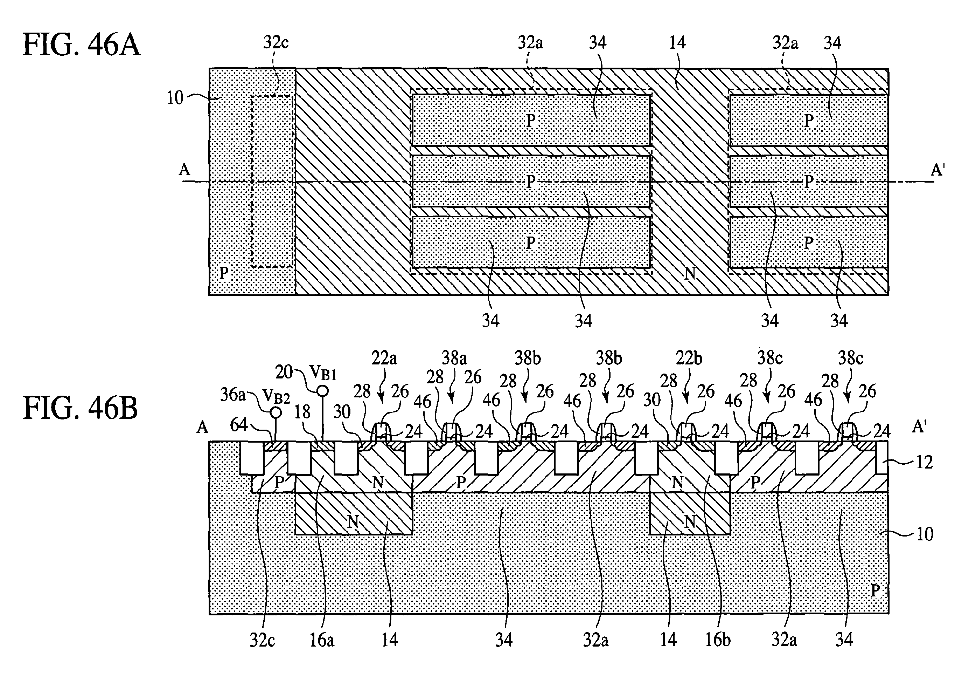

Next, a modification of the semiconductor device according to the present embodiment will be explained with reference to FIGs. 46A and 46B. FIGs. 46A and 46B are a plan view and a sectional view of the semiconductor device according to the present modification. FIG. 46A is the plan view, and FIG. 46B is the sectional view along the line A-A' in FIG. 46A.

The semiconductor device according to the present modification is characterized mainly in that the total sum of the areas of the P-type contact regions 34 immediately below the P-type well 32a is set larger than the area of the region immediately below the P-type well 32a except the P-type contact region 34, and the N-type impurity layer 14 is formed not only immediately below the P-type well 32a but also immediately below the N-type well 16b.

In the present modification, the intra-plane electric resistance of the N-type impurity layer 14 immediately below the P-type well 32a is relatively high, but the intra-plane electric resistance of the N-type impurity layer 14 immediately below the N-type well 16b is relatively low.

Thus, according to the present modification, in comparison with the control illustrated in FIGs. 45A and 45B, the intra-plane electric resistance of the N-type impurity layer 14 can be suppressed low.

As described above, it is possible that the total sum of the areas of the P-type contact regions 34 immediately below the P-type well 32a is set larger than the area immediately below the P-type well 32a except the P-type contact regions 34, and the N-type impurity layer 14 immediately below the P-type well 32a and the N-type impurity layer 14 immediately below the N-type well 16b are formed integral with each other.

### (Modification 2)

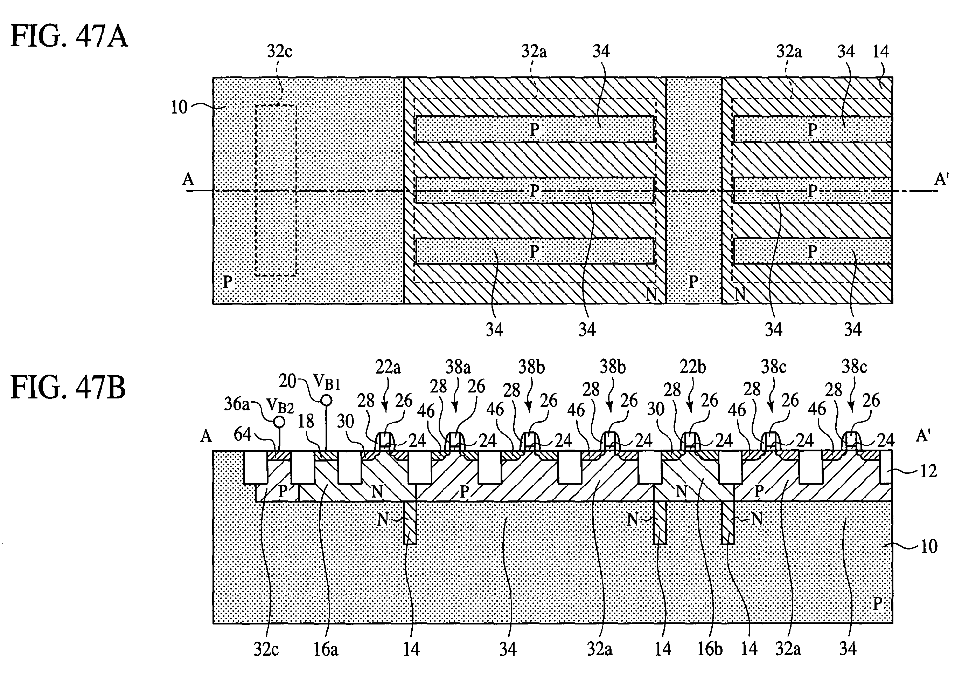

Next, Modification 2 of the semiconductor device according to the present embodiment will be explained with reference to FIGs. 47A and 47B. FIGs. 47A and 47B are a plan view and a sectional view of the semiconductor device according to the present embodiment. FIG. 47A is the plan view, and FIG. 47B is the sectional view along the line A-A' in FIG. 47A.

The semiconductor device according to the present modification is characterized mainly in that the total sum of the areas of the P-type contact regions 34 immediately below the P-type well 32a is set smaller than the area immediately below the P-type well 32a except the P-type contact regions 34, and the N-type well 16b and the N-type impurity layer 14 are connected to each other only at the edge of the N-type well 16b.

In the present modification, the electric resistance of the N-type impurity layer 14, etc. in the region near the N-type well 16b is relatively high, but the intra-plane electric resistance of the N-type impurity layer 14 relatively low immediately below the P-type well 32a.

Thus, according to the present modification, in comparison with the semiconductor device according to the control illustrated in FIGs. 45A and 45B, the intra-plane electric resistance of the N-type impurity layer 14 can be depressed low.

Thus, it is possible that the total sum of the areas of the P-type contact regions 34 immediately below the P-type well 32a is set smaller than the area immediately below the P-type well 32a except the P-type contact regions 34, and the N-type well 16b and the N-type impurity layer 14 are connected to each other only at the edge of the N-type well 16b.

### (Modification 3)

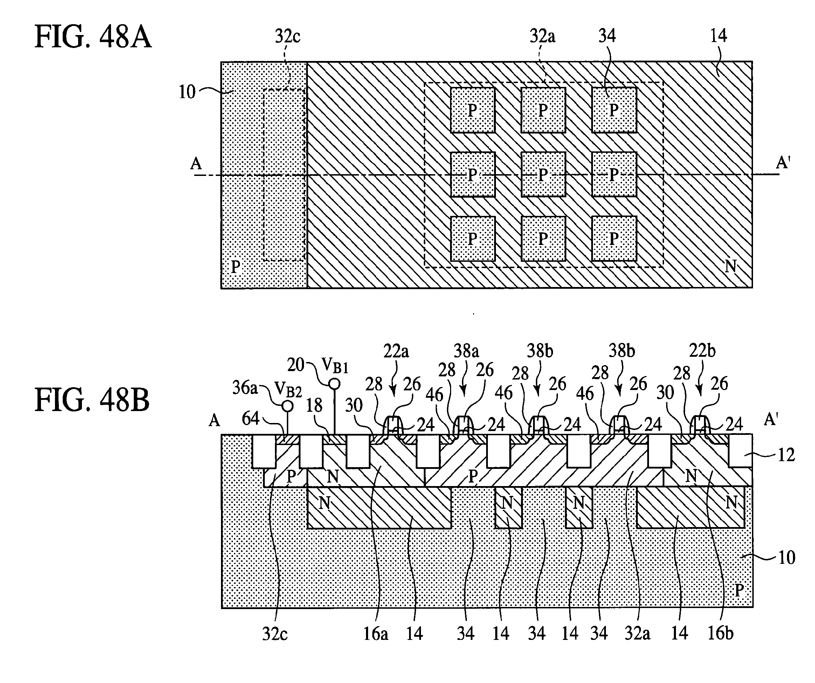

Next, Modification 3 of the semiconductor device according to the present embodiment will be explained with reference to FIGs. 48A and 48B. FIGs. 48A and 48B are a plan view and a sectional view of the semiconductor device according to the present modification. FIG. 48A is the plan view, and FIG. 48B is the sectional view along the line A-A' in FIG. 48A.

The semiconductor device according to the present modification is characterized mainly in that the plane shape of the P-type contact regions 34 is square, and the P-type contact regions 34 are arranged in a matrix.

As illustrated in FIG. 48A and 48B, in the present modification, the plane shape of the P-type contact regions 34 is rectangular. The P-type contact regions 34 are formed in the N-type impurity layer 14 selectively immediately below the P-type well. The P-type contact regions 34 are arranged in a matrix.

As described above, it is possible to arrange the P-type contact regions 34 of a square plane shape in a matrix.

### (Modification 4)

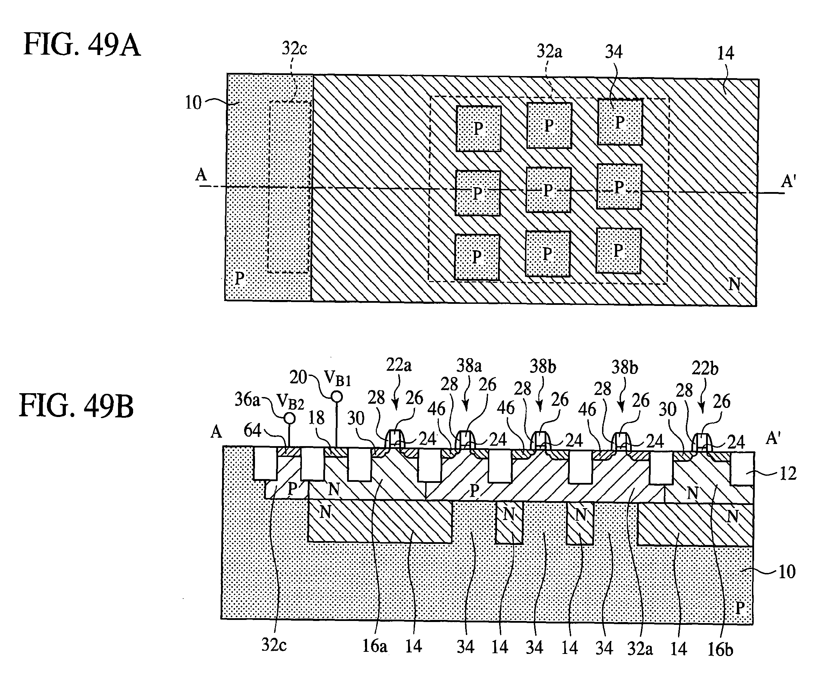

Next, Modification 4 of the semiconductor device according to the present embodiment will be explained with reference to FIGs. 49A and 49B. FIGs. 49A and 49B are a plan view and a sectional view of the semiconductor device according to the present modification. FIG. 49A is the plan view, and FIG. 49B is the sectional view along the line A-A' in FIG. 49A.

The semiconductor device according to the present modification is characterized mainly in that a number of square P-type contact regions 34 are formed, and the positions of the P-type contact regions 34 are gradually offset in a prescribed direction.

As illustrated in FIGs. 49A and 49B, in the present modification, the plane shape of the P-type contact regions 34 is square. The P-type contact regions 34 are formed in the N-type impurity layer 14 selectively immediately below the P-type well. The P-type contact regions 34 are offset gradually in a prescribed direction.

As described above, the P-type contact regions 34 of a square plane shape may be offset gradually in a prescribed direction.

### (Modification 5)

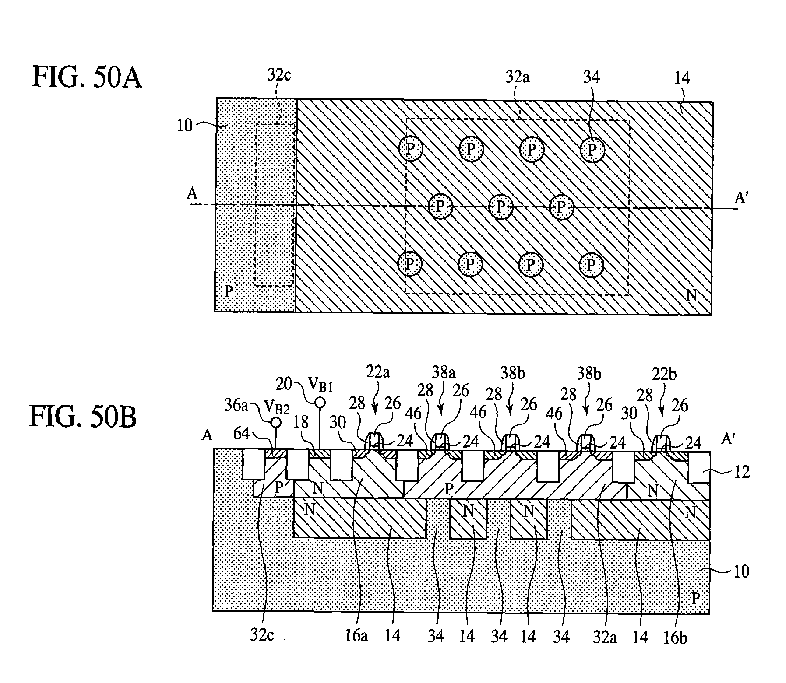

Next, Modification 5 of the semiconductor device according to the present embodiment will be explained with reference to FIGs. 50A and 50B. FIGs. 50A and 50B are a plan view and a sectional view of the semiconductor device according to the present modification. FIG. 50A is the plan view, and FIG. 50B is the sectional view along the line A-A' in FIG. 50A.

The semiconductor device according to the present modification is characterized mainly in that the plane shape of the P-type contact regions 32 is circular.

As illustrated in FIGs. 50A and 50B, in the present modification, the P-type contact regions 34 are formed in a circular plane shape. The P-type contact regions 34 are formed in the N-type impurity layer 14 selectively immediately below the P-type well.

The N-type impurity layer 14 is formed immediately below the N-type well 16a, immediately below the P-type well 32a and immediately below the N-type well 16b integral with each other.

Thus, the P-type contact regions 34 may be set in a circular plane shape.

### (Modification 6)

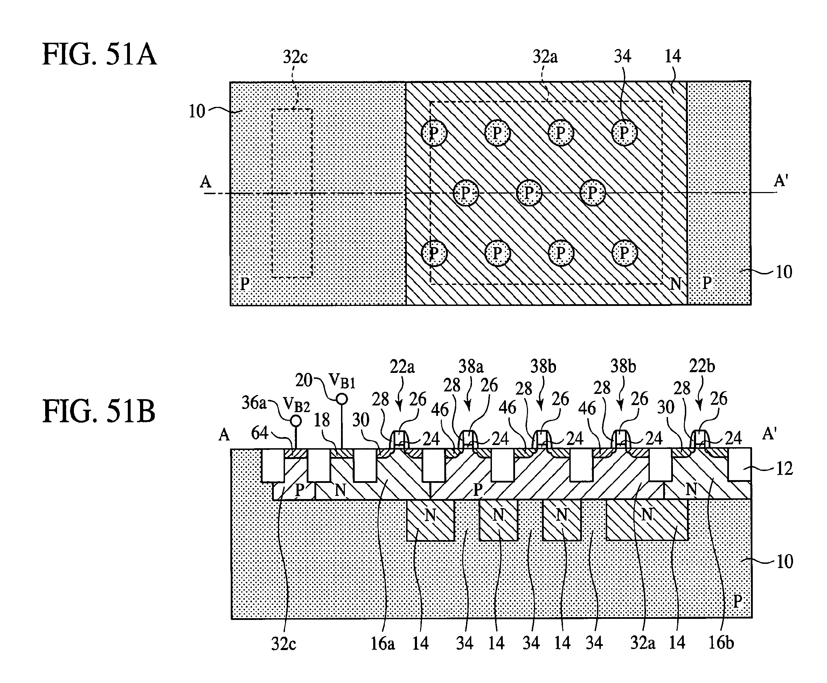

Next, Modification 6 of the semiconductor device according to the present embodiment will be explained with reference to FIGs. 51A and 51B. FIGs. 51A and 51B are a plan view and a sectional view of the semiconductor device according to the present modification. FIG. 51A is the plan view, and the FIG. 51B is the sectional view along the line A-A' in FIG. 51A.

The semiconductor device according to the present modification is characterized mainly in that the N-type well 16a and the N-type impurity layer 14 are connected to each other only at the edge of the N-type impurity layer 14, and the N-type well 16b and the N-type impurity layer 14 are connected to each other at the edge of the N-type impurity layer 14.

As illustrated in FIGs. 50A and 50B, in the present modification, the plane shape of the P-type contact regions 34 is set circular. The P-type contact regions 34 are formed in the N-type impurity layer 14 selectively immediately below the P-type well.

The N-type well 16a and the N-type impurity layer 14 are connected to each other only at the edge of the N-type impurity layer 14. The N-type well 16b and the N-type impurity layer 14 are connected to each other at the edge of the N-type impurity layer 14.

In the present modification, the N-type impurity layer 14 is formed locally only immediately below the N-type well 16a, and the N-type impurity layer 14 is formed locally only immediately below the N-type well 16n, which tends to make the intra-plane electric resistance of the N-type impurity layer 14, etc. a little high.

Even in the present modification of such constitution, a required bias voltage can be applied to the N-type well 16a, 16b and the P-type well 32a.

### (Modification 7)

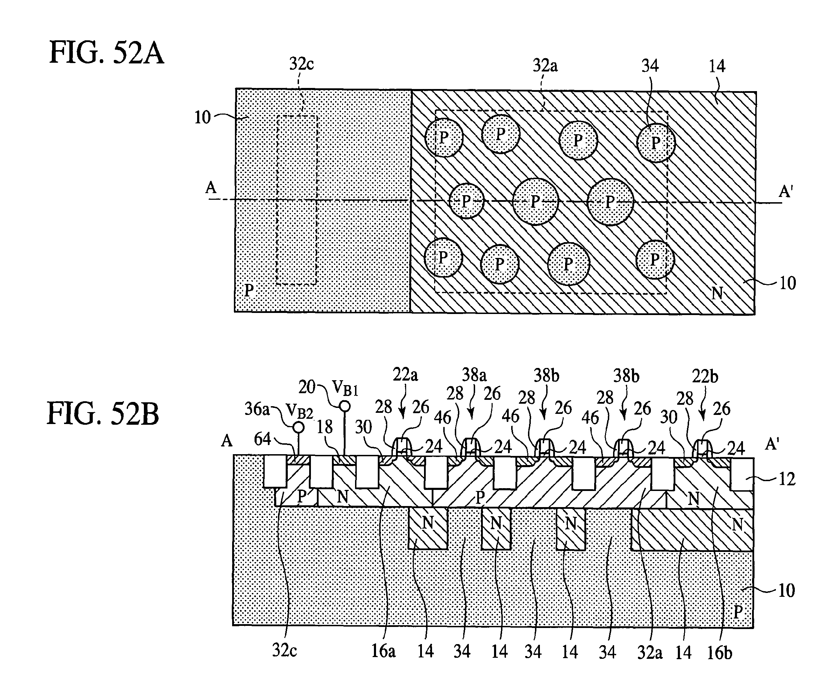

Next, Modification 7 of the semiconductor device according to the present embodiment will be explained with reference to FIGs. 52A and 52B. FIGs. 52A and 52B are a plan view and a sectional view of the semiconductor device according to the present modification. FIG. 52A is the plan view, and FIG. 52B is the sectional view along the line A-A' in FIG. 52A.

The semiconductor device according to the present modification is characterized mainly in that the plane shape of the P-type contact regions 34 are set circular, and the P-type contact regions 34 have random sizes.

As illustrated in FIGs. 52A and 52B, in the present modification, the plane shape of the P-type contact regions 34 is set circular. The P-type contact regions 34 have random sizes. The P-type contact regions 34 are formed in the N-type impurity layer 14 selectively immediately below the P-type well 32a.

As described above, the P-type contact regions 34 may have random sizes.

### (Modification 8)

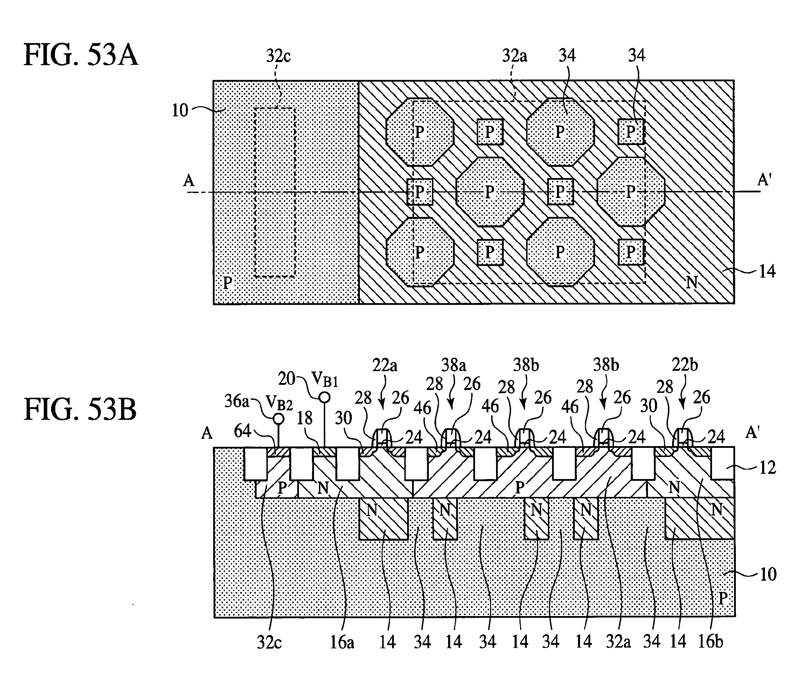

Next, Modification 8 of the semiconductor device according to the present embodiment will be explained with reference to FIG. 53A and 53B. FIGs. 53A and 53B are a plane view and a sectional view of the semiconductor device according to the present modification. FIG. 53A is the plan view, and the FIG. 53B is the sectional view along the line A-A' in FIG. 53A.

In the semiconductor device according to the present modification, P-type contact regions 34 having a square plane shape and P-type contact regions 34 having an octagonal plane shape are suitably formed.

As illustrated in FIGs. 53A and 53B, in the present modification, P-type contact regions 34 of a square plane shape and P-type contact regions 34 of an octagonal plane shape are suitably formed. The P-type contact regions 34 are formed in the N-type impurity layer 14 selectively below the P-type well 32a.

As described above, P-type contact regions 34 of a square plane shape and P-type contact regions 34 of an octagonal plane shape may be suitably formed.

### (Modification 9)

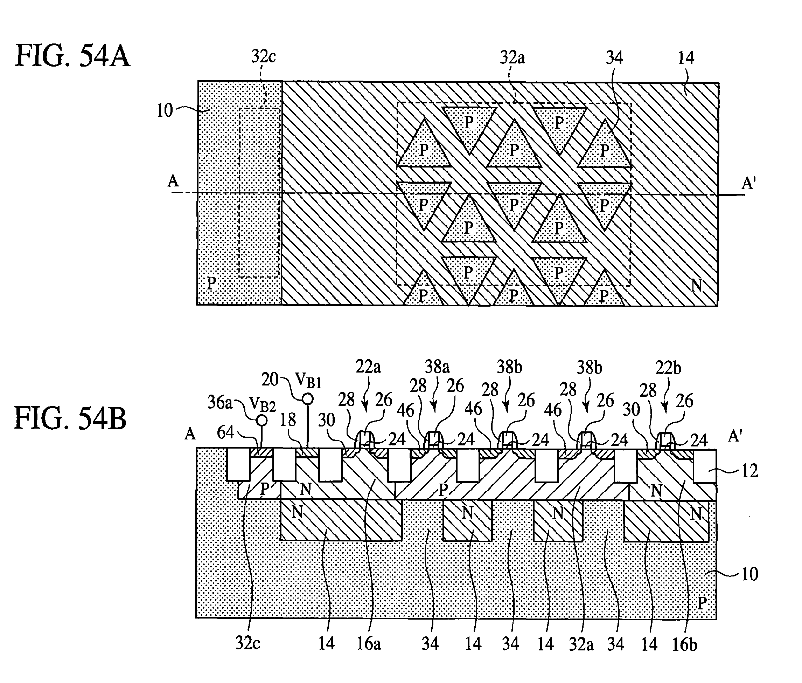

Next, the Modification 9 of the semiconductor device according to the present embodiment will be explained with reference to FIGs. 54A and 54B. FIGs. 54A and 54B are a plan view and a sectional view of the semiconductor device according to the present modification. FIG. 54A is the plan view, and FIG. 54B is the sectional view along the line A-A' in FIG. 54A.

The semiconductor device according to the present modification is characterized mainly in that P-type contact regions 34 of a triangular plane shape are formed.

As illustrated in FIGs. 54A and 54B, in the present modification, P-type contact regions 34 of a triangular plane shape are formed. The P-type contact regions 34 are formed in the N-type impurity layer 14 selectively immediately below the P-type well 32a.

As described above, P-type contact regions 34 of a triangular plane shape may be formed.

### (Modification 10)

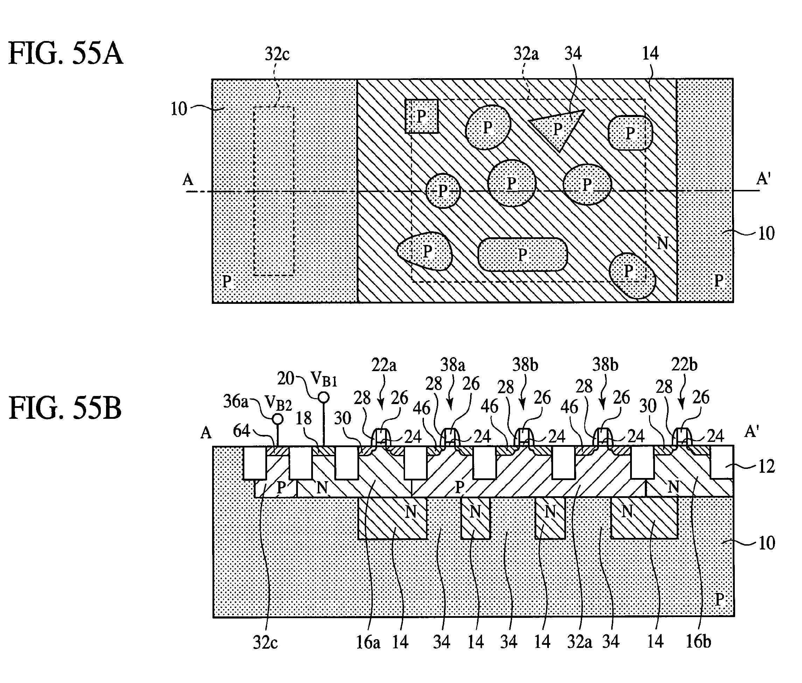

Next, Modification 10 of the semiconductor device according to the present embodiment will be explained with reference to FIGs. 55A and 55B. FIGs. 55A and 55B are a plan view and a sectional view of the semiconductor device according to the present modification. FIG. 55A is the plan view, and FIG. 55B is the sectional view along the line A-A' in FIG. 55A.

The semiconductor device according to the present modification is characterized mainly in that P-type contact regions 34 of various plane shapes, a circular plane shape, a square plane shape, a triangular plane shape, etc., are formed.

As illustrated in FIGs. 55A and 55B, in the present modification, P-type contact regions 34 of various plane shapes as of a circular plane shape, a square plane shape, a triangular plane shape and other plane shapes, are formed. The P-type contact regions 34 are formed in the N-type impurity layer 14 selectively immediately below the P-type well 32a.

As described above, P-type contact regions 34 of various plane shapes may be formed.

### [A Twelfth Embodiment]

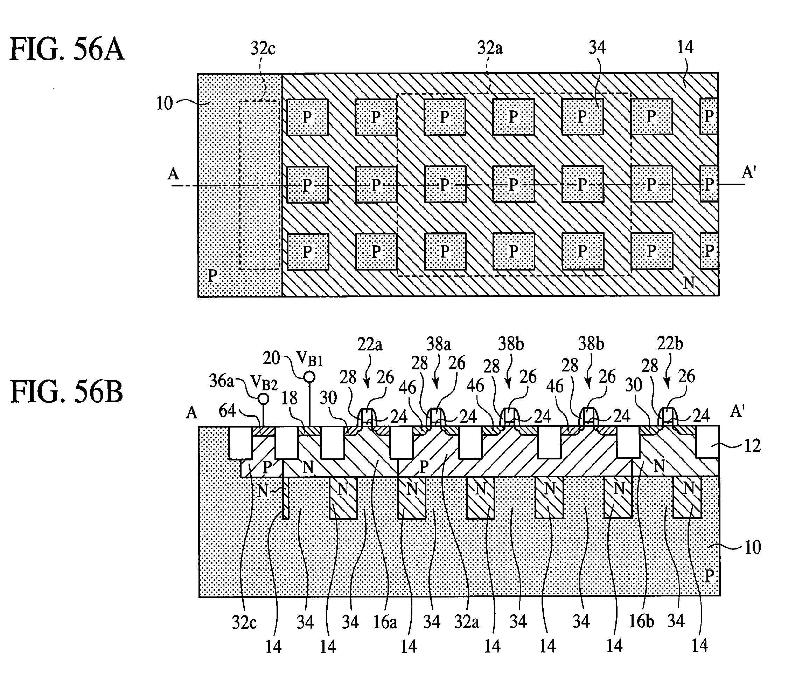

The semiconductor device according to a twelfth embodiment of the present invention will be explained with reference to FIGs. 56A and 56B. FIGs. 56A and 56B are a plan view and a sectional view of the semiconductor device according to the present embodiment. FIG. 56A is the plan view, and FIG. 56B is the sectional view along the line A-A'. The same member of the present embodiment as those of the semiconductor device according to the first to the eleventh embodiments, the method for fabricating the semiconductor device, and others illustrated in FIGs. 1A to 55B are represented by the same reference numbers not to repeat or to simplify their explanation.

The semiconductor device according to the present embodiment is characterized mainly in that contact regions 34 are formed generally in the region where the N-type impurity layer 14 is formed in, and the total sum of the areas of the contact regions 34 in the region where the N-type impurity layer 14 is formed is set smaller than the area of the region of the N-type impurity region 14 except the contact regions 34.

As illustrated in FIGs. 56A and 56B, in the present embodiment, the contact regions 34 are formed generally in the region where the N-type impurity layer 14 is formed. The plane shape of the P-type contact regions 34 is set, e.g., rectangular.

The N-type impurity layer 14 is formed not only immediately below the P-type well 32a but also immediately below N-type wells 16a, 16b. The N-type impurity layer 14 immediately below the P-type well 32a, the N-type impurity layer 14 immediately below the N-type well 16a and the N-type impurity layer 14 immediately below the N-type well 16b are formed integral with each other.

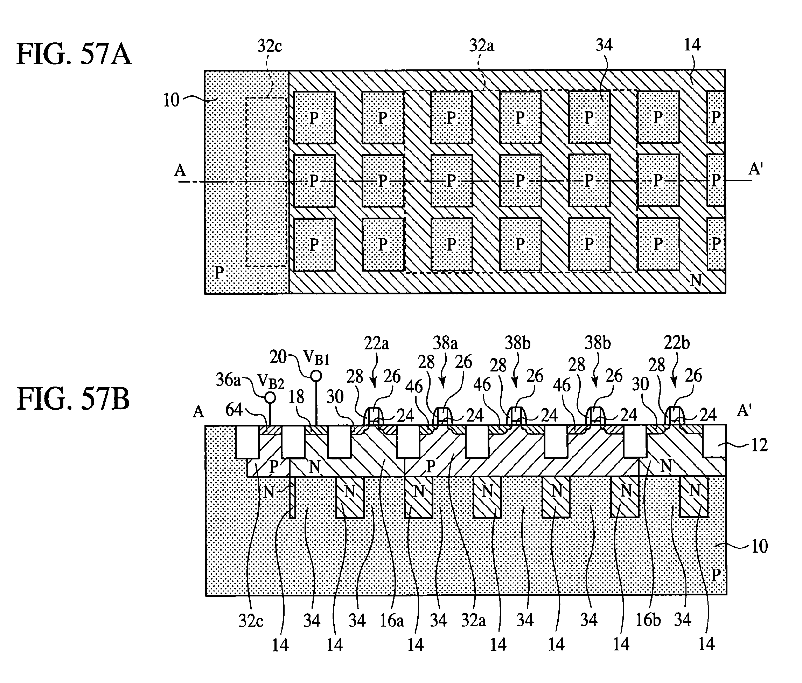

FIGs. 57A and 57B are a plan view and a sectional view of a semiconductor device according to Control 2. FIG. 57A is the plan view, and FIG. 57B is the sectional view along the line A-A' in FIG. 57A. In the semiconductor device according to Control 2 illustrated in FIG. 57A and 57B, the total sum of the areas of the contact regions 34 in the region where the N-type impurity layer 14 is formed is set larger than the area of region of the N-type impurity layer 14 except the contact regions 34, which makes the intra-plane electric resistance of the N-type impurity layer 14 very high. Specifically, in FIGs. 57A and 57B, the ratio of the total sum of the areas of the contact regions 34 to the area of the region of the N-type impurity layer 14 is set to be 53.3%. Accordingly, in the semiconductor device according to Control 2 illustrated in FIGs. 57A and 57B, a large difference is generated between a bias voltage to be applied to the N-type well 16a directly connected to the bias input terminal 20 and a bias voltage to be applied to the N-type well 16b positioned relatively remote from the bias input terminal 20.

In contrast to this, in the present embodiment, the total sum of the areas of the contact regions 34 in the region where the N-type impurity layer 14 is formed is set smaller than the area of the region of the N-type impurity layer 14 except the contact regions 34. Specifically, in the semiconductor device according to the present embodiment illustrated in FIG. 56, the total sum of the areas of the contact regions 34 to the area of the region of the N-type impurity layer 14 is set to be 35.6%. Thus, according to the present embodiment, the intra-plane electric resistance of the N-type impurity layer 14 can be depressed relatively low, and a bias voltage to be applied to the N-type well 16a connected directly to the bias input terminal 20 and a bias voltage to be applied to the N-type well 16b relatively remote from the bias input terminal 20 can be set substantially equal to each other. Thus, according to the present embodiment, even when the contact regions 34 are formed generally in the region where the N-type impurity layer 14 is formed, a required bias voltage can be applied to the N-type wells 16a, 16b and the P-type well 32a.

### (Modification)

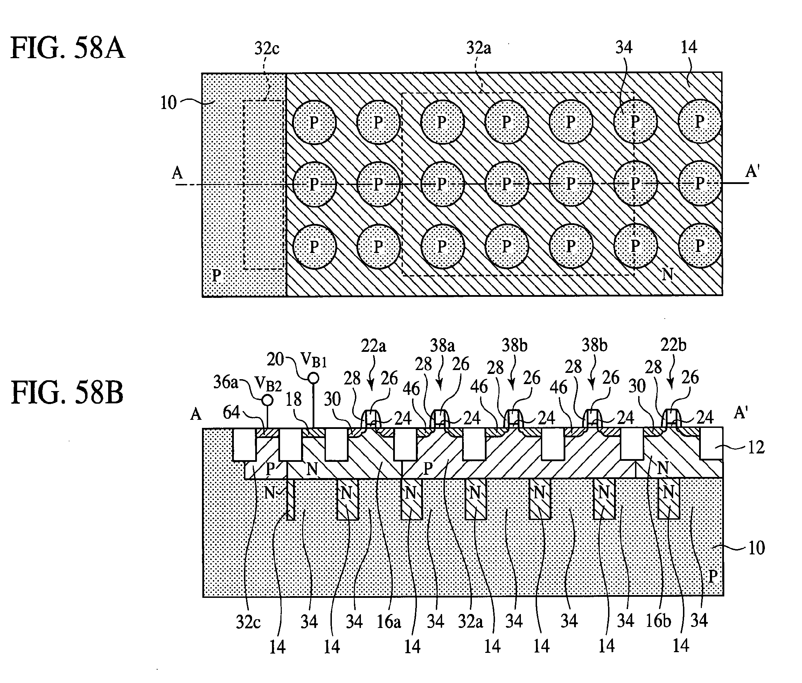

Then, a modification of the semiconductor device according to the present embodiment will be explained with reference to FIGs. 58A and 58B. FIGs. 58A and 58B are a plan view and a sectional view of the semiconductor device according to the modification. FIG. 58A is the plan view, and FIG. 58B is the sectional view along the line A-A' in FIG. 58A.

The semiconductor device according to the present modification is characterized mainly in that the P-type contact regions 34 have a circular plane shape.

As illustrated in FIGa. 58A and 58B, the contact regions 34 are generally formed in the region where the N-type impurity layer 14 is formed, and the total sum of the areas of the contact regions 34 in the region where the N-type impurity layer 14 is formed is set smaller than the area of the region of N-type impurity layer 14 except the contact regions 34. The contact regions 34 have a circular plane shape.

The N-type impurity layer 14 is formed not only immediately below the P-type well 32a but also immediately below the N-type wells 16a, 16b. The N-type impurity layer 14 immediately below the P-type well 32a and the N-type impurity layer 14 immediately below the N-type well 16a and the N-type impurity layer 14 immediately below the N-type well 16b are formed integral with each other.

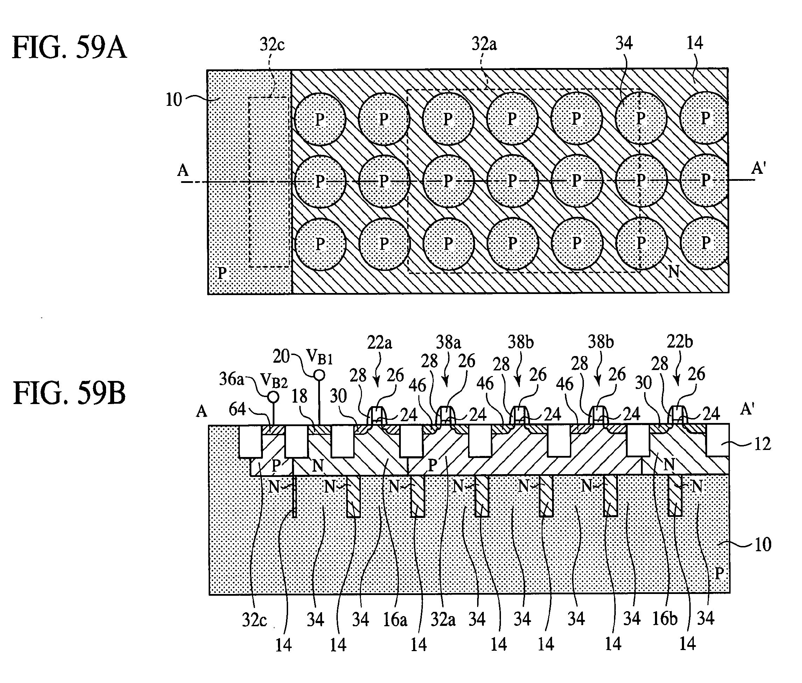

FIGs. 59A and 59B are a plan view and a sectional view of the semiconductor device according to Control 1. FIG. 59A is the plan view, and FIG. 59B is the sectional view along the line A-A' in FIG. 59B. In the semiconductor device according to Control 3 illustrated in FIGs. 59A and 59B, the total sum of the areas of the contact regions 34 in the region where the N-type impurity layer 14 is formed in is set larger than the area of the region of the N-type impurity layer 14 except the contact regions 34, which makes the intra-plane electric resistance of the N-type impurity layer 14 very high. Specifically, in FIGs. 59A and 59B, the ratio of the total sum of the areas of the contact regions 34 to the area of the region of the N-type impurity layer 14 is set to be 57.7%. Accordingly, in the semiconductor device according to Control 3 illustrated in FIGs. 59A and 59B, a large difference is generated between a bias voltage to be applied to the N-type well 16a directly connected to the bias input terminal 20 and a bias voltage to be applied to the N-type well 16b positioned relatively remote from the bias input terminal 20.

In contrast to this, in the present embodiment, the total sum of the areas of the contact regions 34 in the region where the N-type impurity layer 14 is formed is set smaller than the area of the region of the N-type impurity layer 14 except the contact regions 34. Specifically, in the semiconductor device according to the present embodiment illustrated in FIGs. 58A and 58B, the ratio of the total sum of the areas of the contact regions 34 to the area of the region where the N-type impurity layer 14 is formed is set to be 40.0%. Thus, according to the present embodiment, the intra-plane electric resistance of the N-type impurity layer 14 can be depressed relatively low, and a bias voltage to be applied to the N-type well 16a directly connected to the bias input terminal 20 and a bias voltage to be applied to the N-type well 16b positioned relatively remote from the bias input terminal 20 can be set substantially equal to each other. Thus, according to the present embodiment, even when the contact regions are generally formed in the region where the N-type impurity layer 14 is formed, a required bias voltage can be applied to the N-type wells 16a, 16b and the P-type well 32a.

As described above, the P-type contact regions 34 may have a circular plane shape.

### [Modified Embodiments]

The present invention is not limited to the above-described embodiments and can over other various modifications.

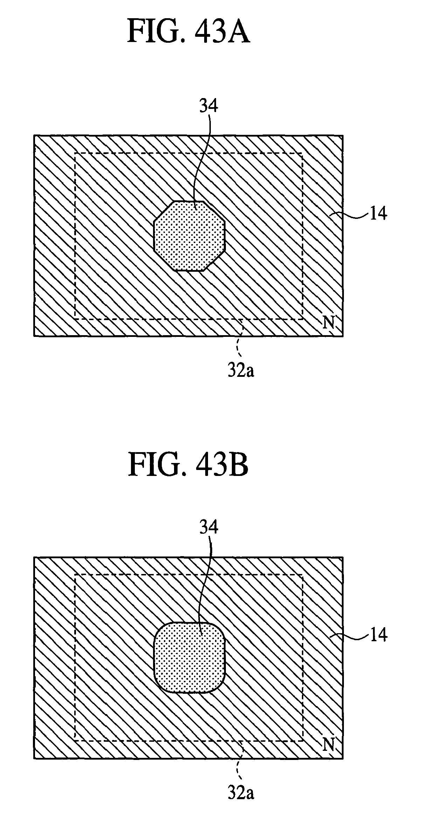

For example, in the above-described embodiments, the P-type contact regions 34 are cylindrical shape but are not essentially cylindrical shape. For example, the P-type contact regions may be formed in a polygonal column shape of section having an obtuse interior angle. FIGs. 43A and 43B are plan views of modifications of the shape of the contact region. FIG. 43A illustrates the contact region formed in an octagonal column shape. Also when the contact region 34 is formed in a polygonal column shape of section having an obtuse interior angle, the distance between the opposed parts of the N-type impurity layer 14 in the contact region 34 can be surely made relatively large. Accordingly, even when the contact region 34 is formed in a polygonal pole of section having an obtuse interior angle, the depletion of the contact region 34 can be suppressed. The contact region 34 may be formed in a pole of substantially circular section. As illustrated in FIG. 43B, the contact region 34 may be formed in a substantially polygonal column shape of section having the respective angles rounded in an arc.

In the above-described embodiments, the P-type wells 32 are formed after the N-type wells 16 have been formed, but the N-type wells 16 may be formed after the P-type wells 32 have been formed.

In the above-described embodiments, a single N-type impurity layer 14 is present in the semiconductor substrate 10. However, a number of the N-type impurity layers 14 are formed separate from each other in the semiconductor substrate 10, and different potentials may be applied to the respective bias input terminals 20.

In the above-described embodiments, the P-type contact regions 34 are formed equidistantly from each other. However, the P-type contact regions 34 may be formed at different pitches in the respective regions in plane, depending on lay-out of the N-type wells 16 or the P-type wells 32. Otherwise, the pitch of the P-type contact regions 34 may be set random.

In the above-described embodiment, the P-type contact regions 34 have substantially the same size. However, the P-type contact regions 34 may have different sizes in the respective regions in plane, depending on design values of the voltage to be applied. Otherwise, the P-type contact regions 34 may have random sizes.

In the above-described embodiment, the P-type contact regions 34 have substantially the same shape. However, the P-type contact regions 34 may have different shape in the respective regions in plane, depending on lay-out of the N-type wells 16 or the P-type wells 32. Otherwise, the P-type contact regions 34 may have random shapes.

In the tenth embodiment, the ratio (A/B) of the total sum A of the areas of the P-type contact regions 34 to the area B of the P-type well 32a is used as a prescribed parameter, and it is judged whether or not the parameter satisfies a prescribed design basis. However, the prescribed parameter is not limited to this. For example, it is possible that the ratio (A'/B) of the area A' of the N-type impurity layer 14 immediately below the P-type well 32a to the area B of the P-type well 32a is used as a prescribed parameter, and it is judged whether or not the parameter satisfies a prescribed design basis. It is also possible that the length-wise conductance of the N-type impurity layer 14 is used as a prescribed parameter, and it is judged whether or not the parameter satisfies a prescribed design basis.

In the above-described embodiments, the area B of the P-type well 32 and the total sum A of the areas of the P-type contact regions 34 are used. However, it is possible that a rectangular region of a prescribed size which is a part in plane is assumed to be a region to be noted, an area of the P-type well 32 contained in the noted region is B", a total sum of the areas of the P-type contact regions 34 is A", and (A''/B'') is used as a prescribed parameter.

In the above-described embodiments, the P-type semiconductor substrate 10 and the P-type well 32a are connected to each other via the P-type contact region 34, and a plurality of the N-type wells 16 are connected to each other by the N-type impurity layer 14 buried deep in the P-type semiconductor substrate 10. However, the conduction types of the semiconductor substrate, the wells, the impurity layer, etc. are not essentially those described above. It is possible that an N-type semiconductor substrate and N-type wells are connected to each other by N-type contact regions, and a plurality of P-type wells are connected to each other by a P-type impurity layer buried deep in the N-type semiconductor substrate.

## Claims

1. A semiconductor device comprising:
a semiconductor substrate of a first conduction type;
a first well of the first conduction type formed in the semiconductor substrate;
a first transistor of the second conduction type formed over the first well;
a second well of the second conduction type formed in the semiconductor substrate;
a second transistor of the first conduction type formed over the second well; and
an impurity layer of the second conduction type buried in the semiconductor substrate below the first well and below the second well, connected to the second well, for applying a bias voltage to the second well,
a contact region of the first conduction type being formed selectively in the impurity layer immediately below the first well,
the first well being connected to the semiconductor substrate via the contact region.

2. A semiconductor device according to claim 1,
wherein
the second well is connected to a first potential via the impurity layer, and
the first well is connected to a second potential different from the first potential via the contact region and the semiconductor substrate.

3. A semiconductor device according to claim 1, further comprising:
a third well of the first conduction type formed in the semiconductor substrate; and
a third transistor of the second conduction type formed on the third well,
the impurity layer is formed further in the semiconductor substrate below the third well, and
the third well is electrically isolated from the semiconductor substrate by the impurity layer.

4. A semiconductor device according to claim 3,
wherein
the third well is connected to a third potential different from the first potential and the second potential.

5. A semiconductor device according to claim 1,
wherein
a total sum of areas of the contact regions immediately below the first well is smaller than an area of the region immediately below the first well except the contact regions.

6. A semiconductor device according to claim 1,
wherein
the contact region is formed in a cylindrical shape, a column shape of substantially circular section, a polygonal column shape of section having obtuse interior angles or in a substantially polygonal column shape of section having the respective angles rounded in an arc.

7. A semiconductor device according to claim 1,
wherein
the bias voltage is variable.

8. A semiconductor device comprising:
a semiconductor substrate of a first conduction type;
a first well of the first conduction type formed in the semiconductor substrate;
a first transistor of the second conduction type formed over the first well;
a second well of the second conduction type formed in the semiconductor substrate;
a second transistor of the first conduction type formed on the second well; and
an impurity layer of the second conduction type buried in the semiconductor substrate below the first well and below the second well, connected to the second well, for applying a bias voltage to the second well,
contact regions of the first conduction type being formed in the impurity layer,
the first well being connected to the semiconductor substrate via the contact regions, and
a total sum of areas of the contact regions in the region of the impurity layer being smaller than an area of the region of the impurity layer except the contact regions.

9. A method for fabricating a semiconductor device comprising the steps of:
forming an impurity layer of a second conduction type, buried in a semiconductor substrate of a first conduction type so that a contact region of the first conduction type are formed selectively in a first region of the region of the impurity layer;
a first well of the first conduction type over the first region of the region of the impurity layer, connected to the semiconductor substrate via the contact region;
a second well of the second conduction type on a second region of the region of the impurity layer, connected to the impurity layer;
a first transistor of the second conduction type over the first well; and
forming a second transistor of the first conduction type over the second well.

10. A method for fabricating a semiconductor device according to claim 9, wherein
in the step of forming a first well, a third well of the first conduction type is further formed over a third region of the region of the impurity layer, and
in the step of forming a first transistor, a third transistor of the second conduction type is further formed on the third well.

11. A method for fabricating a semiconductor device according to claim 9, wherein
in the step of forming an impurity layer, an impurity of the second conduction type is implanted into the region except the region to be the contact region to thereby form said impurity layer of the second conduction type.

12. A method for fabricating a semiconductor device according to claim 9, wherein
the step of forming an impurity layer includes the step of implanting an impurity of the second conduction type into the region except the region to be the contact region to thereby form the impurity layer of the second conduction type; and the step of implanting an impurity of the first conduction type into the regions to be the contact region to thereby form the contact region of the first conduction type whose impurity concentration is higher than an impurity concentration of the semiconductor substrate.

13. A method for fabricating a semiconductor device according to claim 9, wherein
the step of forming an impurity layer includes the step of implanting the impurity of the first conduction type in a first concentration into the region containing the regions to be the contact region; and the step of implanting the impurity of the second conduction type in a second concentration higher than the first concentration into the region except the region to be the contact region to thereby form the impurity layer of the second conduction type.

14. A method for fabricating a semiconductor device according to claim 9, wherein
the step of forming an impurity layer includes the step of implanting an impurity of the second conduction type in a first concentration into the region containing the region to be the contact region; and the step of implanting an impurity of the first conduction type in a second concentration higher than the first concentration to thereby form the contact region of the first conduction type.

15. A method for designing a semiconductor device comprising a semiconductor substrate of a first conduction type; a first well of the first conduction type formed in the semiconductor substrate; a first transistor of a second conduction type formed over the first well; a second well of a second conduction type formed in the semiconductor substrate; a second transistor of the first conduction type formed over the second well; an impurity layer of the second conduction type buried in the semiconductor substrate below the first well and below the second well and connected to the second well, for applying a bias voltage to the second well, a contact region of the first conduction type being formed selectively in the impurity layer immediately below the first well, the first well being connected to the semiconductor substrate via the contact region, the method comprising the steps of:
computing a prescribed parameter, based on a pattern of the first well, a pattern of the impurity layer or patterns of the contact region;
judging whether or not a result of computing the prescribed parameter satisfies a prescribed design basis; and
adding, deleting, deforming or shifting the contact region so as to satisfy the prescribed design basis unless the prescribed parameter satisfies the prescribed design basis.

16. A method for designing a semiconductor device according to claim 15, wherein
the prescribed parameter is a ratio of A/B of a total sum A of areas of the contact regions to be formed immediately below the first well to an area B of the first well.

17. A method for designing a semiconductor device according to claim 15, wherein
the prescribed parameter is a conductance between the first well and the semiconductor substrate.

18. A computer program for designing a semiconductor device comprising a semiconductor substrate of a first conduction type; a first well of the first conduction type formed in the semiconductor substrate; a first transistor of the second conduction type formed over the first well; a second well of the second conduction type formed in the semiconductor substrate; and a second transistor of the first conduction type formed over the second well; an impurity layer of the second conduction type buried in the semiconductor substrate below the first well and below the second well and connected to the second well, for applying a bias voltage to the second well, contact region of the first conduction type being formed selectively in the impurity layer immediately below the first well, the first well being connected to the semiconductor substrate via the contact region, the computer program executing the steps of:
computing a prescribed parameter, based on a pattern of the first well, a pattern of the impurity layer or patterns of the contact region;
judging whether or not a result of computing the prescribed parameter satisfies a prescribed design basis;
adding, deleting, deforming or shifting the contact region so that the prescribed parameter satisfies the prescribed design basis, unless the prescribed parameter satisfies the prescribed design basis.

19. A computer program according to claim 18,
wherein
the prescribed parameter is a ratio A/B of a total sum A of areas of the contact regions to be formed immediately below the first well to an area B of the first well.

20. A computer program according to claim 18,
the prescribed parameter is a conductance between the first well and the semiconductor substrate.

21. A computer-readable recording medium storing a computer program according to claims 18.
